(19)

Europäisches
Patentamt
European
Patent Office
Office européen
des brevets

(11) **EP 2 530 131 A1**

(12) **EUROPEAN PATENT APPLICATION**
published in accordance with Art. 153(4) EPC

(43) Date of publication:
**05.12.2012 Bulletin 2012/49**

(21) Application number: **11736967.8**

(22) Date of filing: **25.01.2011**

(51) Int Cl.:
**C09K 5/08** *(2006.01)*     **B01J 20/20** *(2006.01)*
**B01J 20/28** *(2006.01)*     **C01B 31/02** *(2006.01)*
**H05K 9/00** *(2006.01)*

(86) International application number:
**PCT/JP2011/051268**

(87) International publication number:
**WO 2011/093254 (04.08.2011 Gazette 2011/31)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.03.2010   JP 2010075350
10.03.2010   JP 2010053268
26.01.2010   JP 2010014167**

(71) Applicant: **The Nisshin Oillio Group, Ltd.
Chuo-ku
Tokyo 104-8285 (JP)**

(72) Inventors:
• **GOTOU, Hiroyuki**
**Tokyo 104-8285 (JP)**
• **SHINOHARA, Go**
**Tokyo 104-8285 (JP)**
• **KUNO, Noriyasu**
**Tokyo 104-8285 (JP)**

(74) Representative: **Hodsdon, Stephen James et al
Mewburn Ellis LLP
33 Gutter Lane
London
EC2V 8AS (GB)**

(54) **HEAT CONDUCTING MEMBER AND ADSORBENT USING BURNED PLANT MATERIAL**

(57)     Provided is a heat conducting member using a heat conducting material that has been developed so as to retain the same heat conductivity as that of a conventional product without using silicone rubber. The heat conducting member comprises a base material formed from any of rubber, resin, paint or cement and, contained in the base material, a burned plant material selected from any of soybean hulls, rapeseed meal, sesame meal, cotton seed meal, cotton hulls, soybean chaffs, and cacao husk, and is produced by controlling at least one of the content ratio of burned plant material against the base material or the temperature at which the plant material is burned.

FIG. 1

**Description**

FIELD OF THE INVENTION

The present invention is related to a heat conducting member and an adsorbent using burned plant materials; and more particularly, it is related to a heat conducting member such as plate type and paste type, and an adsorbent for toxic gas and toxic substance removal.

BACKGROUND OF THE INVENTION

Patent Document 1 discloses the silicone rubber composition including silicone rubber, having thermally conductive and electrical insulation whose thermal conductivity of the forming body after vulcanization is 0.4 W/(m·K) or more and specific volume resistance value is $10^9$ Ω·cm or more.

In addition, as disclosed by Non-Patent Document 1, the raw materials for activated carbon contained in gas adsorbent are divided roughly into carboniferous base (peat, lignite, brown coal, bituminous coal, etc.), woody base (coconut shell, wood, sawdust), and others (petroleum pitch, synthetic resin (polymer), various organic ashes, etc.). In the relation between the raw materials of activated carbon and the pore size distribution, the pore size distribution of coconut shell activated carbon is concentrated at a small pore size compared to carboniferous based activated carbon, and, it is a characteristic that there are few large pores concerning pore diameter. Therefore, coconut shell activated carbon is often used in gas phase adsorption for the molecules that size is small.

Even if it is same carboniferous base, when lignite and peat which are less-advanced coalification are used as raw materials, many mesoporous tend to be generated. Therefore, such activated carbon is used for adsorption in the liquid phase of the substance (coloration material and humic acid) of high molecular weight of large molecular size. The average pore size has been described as 3.54 nm with sawdust, 2.15 nm with coal, 1.97 nm with coal, 1.77 nm with coconut shell and 1.60 nm with synthetic polymer.

Patent Document 1: JPA2000-053864
Non-Patent Document 1:

http://www.jpo.go.jp/shiryou/s_sonota/hyoujun_gijutsu/mizushori/1-9-1.pdf

DISCLOSURE OF THE INVENTION

PROBLEM TO BE SOLVED BY THE INVENTION

However, the heat conductive member containing silicone rubber as shown in Patent Document 1 has a problem about a generating of siloxane gas causing the contact failure for switch and relay. Therefore, without using silicone rubber, the substitute which the thermal conductivity is equal to or better than conventional products has been requested.

In addition, the activated carbon as shown in Non-Patent Document 1 has 1.60 nm pore size on average, corresponding to a synthetic polymer even if the average pore size is small. Therefore, It is a difficulty in absorbing efficiently the substance which is several 10 % smaller than the activated carbon. More specifically, for example, the molecular sizes of nitrogen, oxygen, and carbon dioxide are about 0.36 nm, about 0.34 nm, and about 0.33 nm respectively. So, the adsorption of these gases using the activated carbon which consists of existing raw materials is marginal.

On the other hand, in general, because most of things called activated carbon have a wide pore radius range of about 0.1 nm to about several 100 nm, it is unsuitable for adsorbing the substance of specific size efficiently. Therefore, the selection of raw materials and manufacturing conditions of activated carbon becomes a very important factor in the production of adsorbent.

The present invention is to provide the heat conducting material which does not need to use silicone rubber, and a heat conducting member using it, maintaining thermal conductivity equivalent to thermal conductivity of conventional products.

In addition, the present invention is to provide an adsorbent capable of adsorbing the substance of specific molecular size effectively by selecting the raw materials and manufacturing conditions of activated carbon suitably.

MEANS OF SOLVING THE PROBLEMS

In order to solve the above problems, the heat conducting member of the present invention comprises a base material and a burned plant material containing in the base material, and is manufactured by controlling at least one the content ratio of the burned plant material to the base material, and the burning temperature of the burned plant material.

In addition, a heat conducting material of the present invention includes the above burned plant material.

As the burned plant material, a burned material such as soybean hulls, rapeseed meal, sesame meal, cotton seed meal, cotton hulls, soybean chaffs, or cacao husk can be used. As the base material, ethylene propylene diene monomer rubber, paint, or cement can be used.

According to the present invention, for example, in the case of each above plant, 0.4 [W/(m·K)] or more as the thermal conductivity can be obtained when the content ratio of each burned plant material to the base material is 200 phr, and the burning temperature is 900 °C or higher (phr: per hundred resin (rubber), by weight).

The adsorbent of the present invention comprises a burned plant material having a peak of the differential volume in specific pore radius value. The burned plant material is adjusted a burning temperature and a median diameter. The burned plant material is one of the burned materials of soybean hulls, rapeseed meal, sesame meal, cotton seed meal, cotton hulls, soybean chaffs, and cacao husk.

The adsorbent of the present invention can adsorb under controlling the pore radius value of the burned plant material by determining the burned temperature, etc. of the burned plant material in response to the substances to be adsorbed.

EMBODYMENT OF THE INVENTION

Referring to drawings, embodiments according to the present invention are described hereinafter.

(EMBODIMENT 1)

This embodiment first produces a burned plant material by burning and carbonizing any of soybean hulls, rapeseed meal, cotton hulls, sesame meal, cotton seed meal, and cacao husk. Today, the production of food oil etc. from soybeans as a raw material results in causing a large amount of soybean hulls etc. Although most of those are reused as fodder for live stock or agricultural fertilizer, further usages have been sought. As a result of dedicated study from the aspect of ecology, as a way of further reusing soybean hulls etc., it was found that the burned material of soybean hulls etc. can be beneficially used as a heat conducting material and a heat conducting member.

In addition, as described later in EMBODIMENT 2, it was found that the burned material of soybean hulls etc. can be beneficially used not only as a heat conducting material and a heat conducting member but also as various adsorption material such as gas adsorption material.

The burned plant material is obtained by burning soybean hulls etc. in an inert gas atmosphere with nitrogen gas etc. or in a vacuum condition by using a carbonization apparatus such as holding furnace or rotary kiln, for example, at a temperature of approx. 900 [°C]. Then, the burned material of soybean hulls etc. is ground and then sieved with, for example, a 106 $\mu$m by 106 $\mu$m mesh. As a result, about 80% of the entire burned material of soybean hulls becomes 85 $\mu$m or below. In this case, the median diameter becomes, for example, approx. 30 $\mu$m to approx. 60 $\mu$m.

The median diameter was measured by a laser diffraction particle size analyzer, SALD-7000 etc. made by SHIMADZU Corporation. The heat conducting member of this embodiment use, for example, approx. 30 $\mu$m to approx. 60 $\mu$m as the median diameter for a burned material of soybean hulls etc., and approx. 1 $\mu$m as the minimum median diameter by those further selective pulverizing.

Pulverizing herein refers to a pulverization of a pre-pulverizing material to reduce its median diameter by about one decimal order. Therefore, it refers that a median diameter of 30 $\mu$m before pulverization is pulverized to 3 $\mu$m. However, pulverizing does not refer to exactly reducing the median diameter before pulverization by approx. one decimal order, and it also includes pulverizing to reduce the median diameter before pulverization to 1/5 - 1/20. In this embodiment, the pulverization was carried out so that the median diameter after pulverization becomes 1 $\mu$m at the smallest.

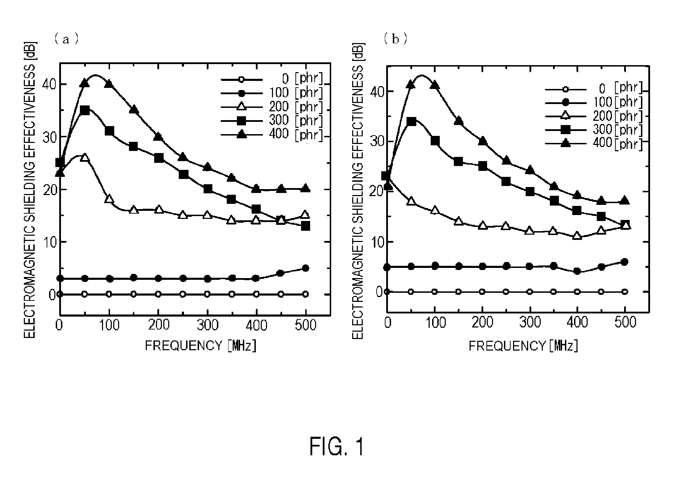

Fig. 1 shows charts indicating the measurement results of the electromagnetic shielding characteristics of the heat conducting member of this embodiment. In the following description, the heat conducting member is defined as the burned plant material such as soybean hulls, etc. is blended with ethylene propylene diene monomer rubber, etc. that is the base material. Fig. 1(a) shows a measurement result of the burned material of soybean hulls. Fig. 1(b) shows a measurement result of the burned material of a mixture of raw soybean hulls (=soybean hulls before burned) and a liquid resol-type phenolic resin at the ratio of 75 [wt.%] to 25 [wt.%].

Mixing a resol-type phenolic resin with raw soybean hulls allows improving the strength and carbon content of the burned material of soybean hulls. However, please note that said mixing itself is not essential for producing the heat conducting material and heat conducting member of this embodiment.

In Fig. 1(a) and Fig. 1(b), the lateral axis and vertical axis indicate frequency [MHz] and electromagnetic shielding effectiveness [dB] respectively. In addition, for both of the measuring objects of the measurement results shown in Fig. 1(a) and Fig. 1(b), the median diameter of the burned material of soybean hulls was set to approx. 60 $\mu$m, and the burning temperature for soybean hulls was set to approx. 900 [°C], and the thickness of the platy heat conducting member was set to approx. 2.5 [mm].

These electromagnetic shielding characteristics were obtained by using Shield Material Evaluator (TR17301A manufactured by Advantest Corporation) and Spectrum Analyzer (TR4172 manufactured by Advantest Corporation) at Yamagata Research Institute of Technology, Okitama Branch on 5 July 2007.

As seen in Fig. 1, it is found that the electromagnetic shielding effectiveness has been improved as the content ratio of the heat conducting material against the base material increases. There are some points that are worth noting, and the first point is that, according to this embodiment, the content ratio of the burned material of soybean hulls against the base material can be adjusted freely. Furthermore, it is particularly worth noting that the content ratio against the base material can be increased generally for the burned plant material including soybean hulls. As shown in Fig. 1, the heat conducting member of this embodiment has a characteristic of improving the electromagnetic shielding effectiveness as increasing the content ratio of the burned material of soybean hulls.

Here, instead of the burned material of soybean hulls, when carbon black was used as the containing object to ethylene propylene diene monomer rubber, it was found that the flexibility of the heat conducting member is reduced by containing as much as 100 [phr] of carbon black against ethylene propylene diene monomer rubber.

And, I would not say that it is impossible to contain as much as 400 [phr] of carbon black against the rubber, but it will essentially be very difficult to achieve that. In contrast to this, in the case of the heat conducting member of this embodiment, as much as approx. 400 [phr] of the burned material of soybean hulls can be contained against the rubber.

The second point is that the heat conducting member of this embodiment can advantageously improve the electromagnetic shielding effectiveness significantly as a result of the increased content ratio of the burned material of soybean hulls against the base material. From a different view point, the heat conducting member of this embodiment is advantageously easy to control its electromagnetic shielding effectiveness by adjusting the content ratio of the burned material of soybean hulls against the base material.

As shown in Fig. 1, an excellent electromagnetic shielding effectiveness is particularly observed in the frequency band of around 50 [MHz]. Specifically, when the content ratio of the burned material of soybean hulls is approx. 400 [phr] against rubber, the electromagnetic shielding member maintains 20 [dB] or above up to the frequency band of 500 [MHz] with a maximum value of over 40 [dB].

This value is a tremendous value considering that most of the generally commercially available electromagnetic shielding materials in the market have an electromagnetic shielding effectiveness within the range of 5 [dB] to 25 [dB]. Similarly, even if the content ratio of the burned material of soybean hulls is approx. 300 [phr], an electromagnetic shielding effectiveness of 20 [dB] or above has been maintained in the frequency band of 300 [MHz] and below.

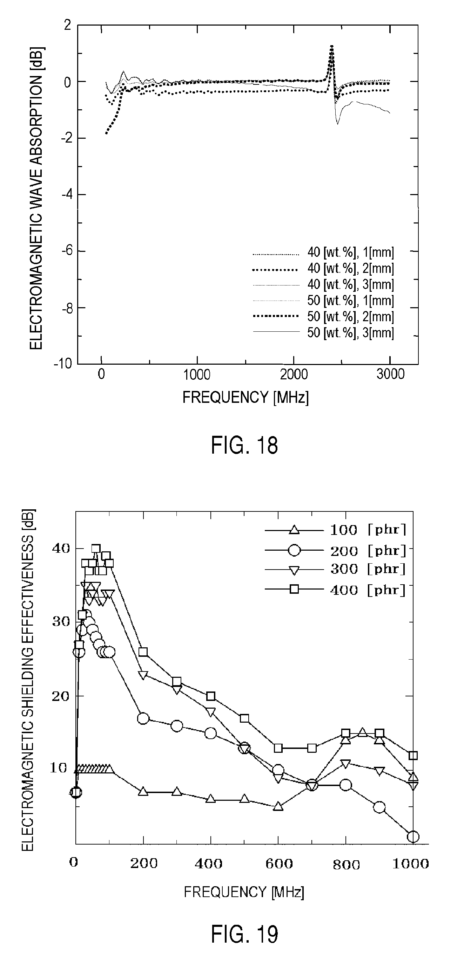

Fig. 19 shows a chart indicating the measurement results of the electromagnetic shielding characteristics shown in Fig. 1 with an expanded measurement range. In Fig. 19, the lateral axis and vertical axis indicate frequency [MHz] and electromagnetic shielding effectiveness [dB] respectively. The measurement range of Fig. 1 is a frequency band of up to 500 [MHz], while the measurement range of Fig. 19 is a frequency band of up to 1000 [MHz]. As the measuring object, raw soybeans were burned without containing a resol-type phenolic resin.

First, paying attention to the frequency band of up to 500 [MHz], it is found that a measurement result with an electromagnetic shielding effectiveness similar to the chart in Fig. 1 has been obtained. In contrast, paying attention to the frequency band from 500 [MHz] to 1000 [MHz], the electromagnetic shielding effectiveness decreases for all measuring objects up to 600 [MHz].

However, the electromagnetic shielding effectiveness increases for most of the measuring objects up to the frequency band of around 800 [MHz]. Then the electromagnetic shielding effectiveness decreases again from approx. 900 [MHz] to approx. 1000 [MHz].

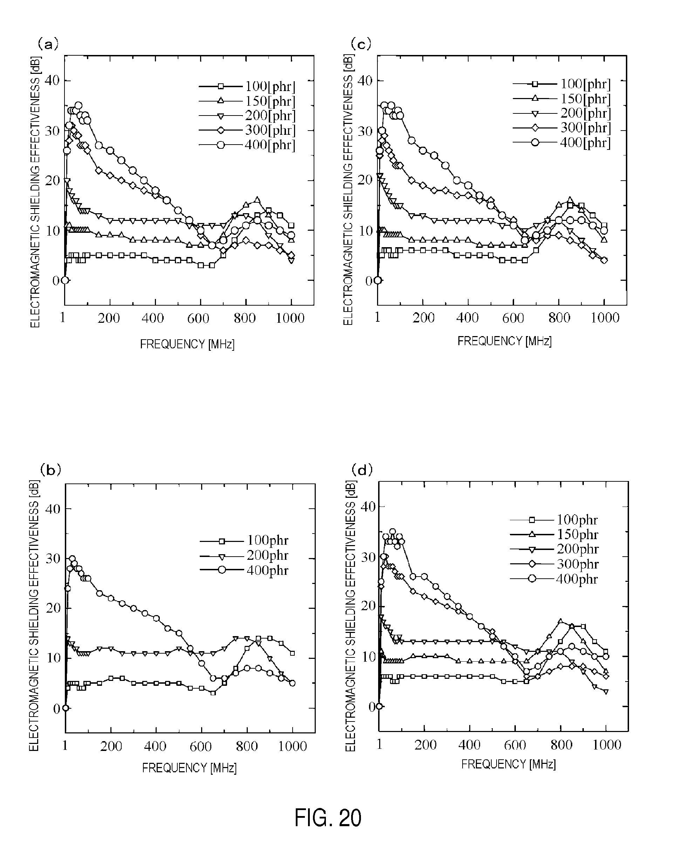

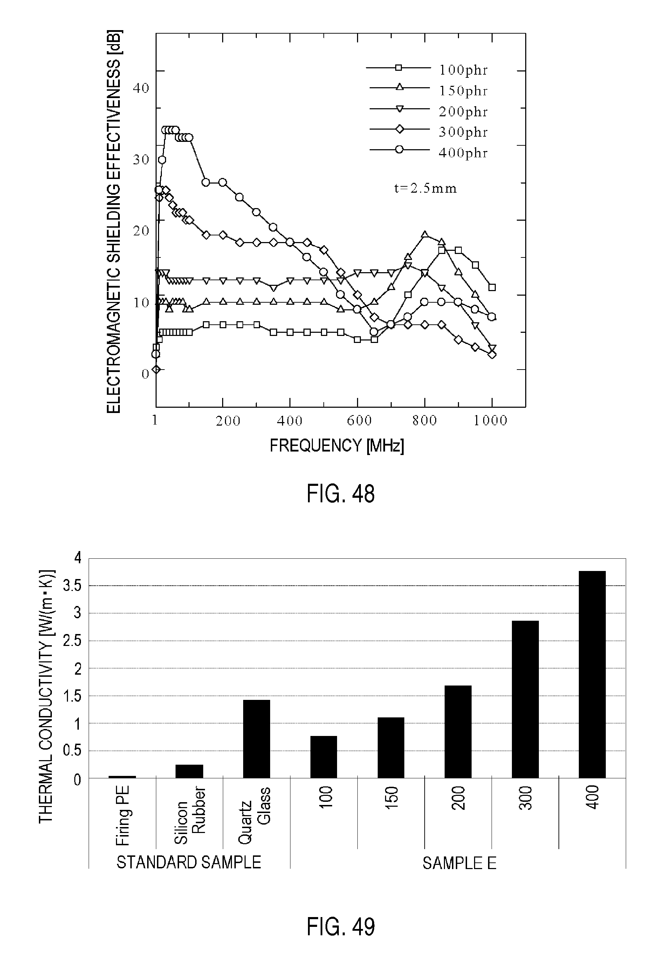

Fig. 20(a) - Fig. 20(d) show a chart indicating the measurement results of the electromagnetic shielding characteristics of the burned materials of rapeseed meal, sesame meal, cotton seed meal and cotton hulls. Fig. 48 shows a chart indicating the measurement results of the electromagnetic shielding characteristics of the burned materials of cacao husk. In Fig. 20(a) - Fig. 20(d) and Fig. 48, the lateral axis and vertical axis indicate frequency [MHz] and electromagnetic shielding effectiveness [dB] respectively. Fig. 20(a), Fig. 20(b), Fig. 20(c) and Fig. 20(d) indicate the measurement result of the electromagnetic shielding characteristics of rapeseed meal, sesame meal, cotton seed meal and cotton hulls respectively.

Rapeseed meal, sesame meal, cotton seed meal, cotton hulls and cacao husk were burned at a burning temperature of 900 [°C] and the obtained burned materials were ground and sieved with a 106 μm by 106 μm mesh, and thus the median diameters were respectively approx. 48 μm, approx. 61 μm, approx. 36 μm, approx. 34 μm and approx. 39 μm. Therefore, hereinafter, when the burning temperature of rapeseed meal etc. is clearly specified as 900 [°C], it means that the burned material of rapeseeds etc. has a median diameter of approx. 48 μm, etc.

First, as comparing Fig. 20(a) - Fig. 20(d), Fig. 48 and Fig. 19 with each other, a similar tendency is found between the electromagnetic shielding characteristics of those. Specifically, all charts show a tendency of improving its electromagnetic shielding effectiveness up to approx. 500 [MHz] as the content ratio of burned material against rubber increases.

In addition, when the content ratio of burned plant material is 400 [phr], it is found that the electromagnetic shielding effectiveness exceeds 30 [dB] as the maximum value in all charts. Furthermore, it is also found that the electromagnetic shielding effectiveness shows a small peak in the frequency band of 700 [MHz] - 1000 [MHz].

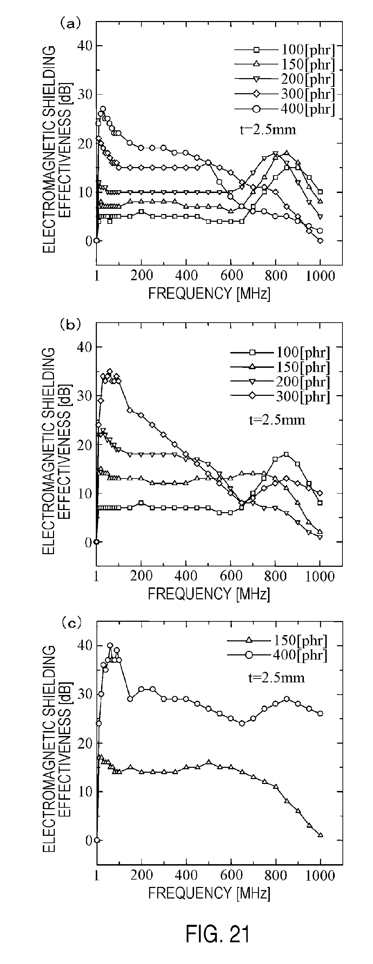

Fig. 21(a) - Fig. 21(c) show a chart indicating the measurement results of the electromagnetic shielding characteristics when the production conditions etc. for the burned material of soybean hulls have been changed. In Fig. 21 (a) - Fig. 21(c), the lateral axis and vertical axis indicate frequency [MHz] and electromagnetic shielding effectiveness [dB] respectively.

Fig. 21(a) shows a chart in which the burning temperature stayed at 900 [°C] and then the burned material of soybean hulls was pulverized, while Fig. 21(b) shows a chart in which the burning temperature for soybean hulls was set to 1500 [°C] (to be exact, the material was once burned at 900 [°C], and then burned again at 1500 [°C]. Otherwise the same) and was not pulverized, and while Fig. 21(c) shows a chart in which the burning temperature for soybean hulls was set to 3000 [°C] (to be exact, the material was once burned at 900 [°C], and then burned again at 3000 [°C]. Otherwise the same) and was not pulverized.

As shown in Fig. 21(a), when the burned material of soybean hulls was pulverized, the electromagnetic shielding effectiveness generally tends to be reduced in comparison with those not pulverized regardless of the content ratio of burned material against rubber. As seen in detail, when the content ratio of burned plant material against rubber was 400 [phr], it was found that the electromagnetic shielding effectiveness only reaches about 25 [dB] as the maximum value. In contrast, those burned at 900 °C and not pulverized as shown in Fig. 1 exceeds 40 [dB]. Therefore, you could say that the electromagnetic shielding effectiveness improves as the grain size of burned material increases.

As shown in Fig. 21(b), when the burning temperature for soybean hulls was set to 1500 [°C], it was confirmed that the electromagnetic shielding effectiveness is similar to the case of setting the burning temperature for soybean hulls shown in Fig. 19 to 900 [°C]. In other words, even if the burning temperature for soybean hulls was set to 1500 [°C], no significant improvement was observed in the electromagnetic shielding effectiveness.

As shown in Fig. 21(c), when the burning temperature for soybean hulls was set to 3000 [°C], it was confirmed that setting the content ratio of the burned material of soybean hulls against rubber to 400 [phr] allows to obtain a stable electromagnetic shielding effectiveness. That means, the electromagnetic shielding effectiveness was significantly reduced from approx. 150 [MHz] towards approx. 600 [MHz] in the chart of Fig. 19, while only a gentle reduction (may be seen as almost level) was confirmed in the chart of Fig. 21. As more easily seen in comparison with the chart in Fig. 21 (b), it was confirmed that the electromagnetic shielding effectiveness improves when the content ratio of the burned material is set to 150 [phr] against rubber.

Furthermore, according to Fig. 21(c), it is worth noting that an electromagnetic shielding effectiveness of over approx. 25 [dB] is obtained in a wide frequency band up to 1000 [MHz]. As described above, the electromagnetic shielding effectiveness of existing general products mostly falls in the range of 5 [dB] - 25 [dB]. However, existing products can achieve the electromagnetic shielding effectiveness of 25 [dB] only in a limited frequency band, and none of those can achieve it in a wide frequency band up to 1000 [MHz]. Thus, the heat conducting member of this embodiment performs a significant effect in terms of the electromagnetic shielding effectiveness.

Hereinafter, the heat conducting material and the heat conducting member of this embodiment are described in further detail.

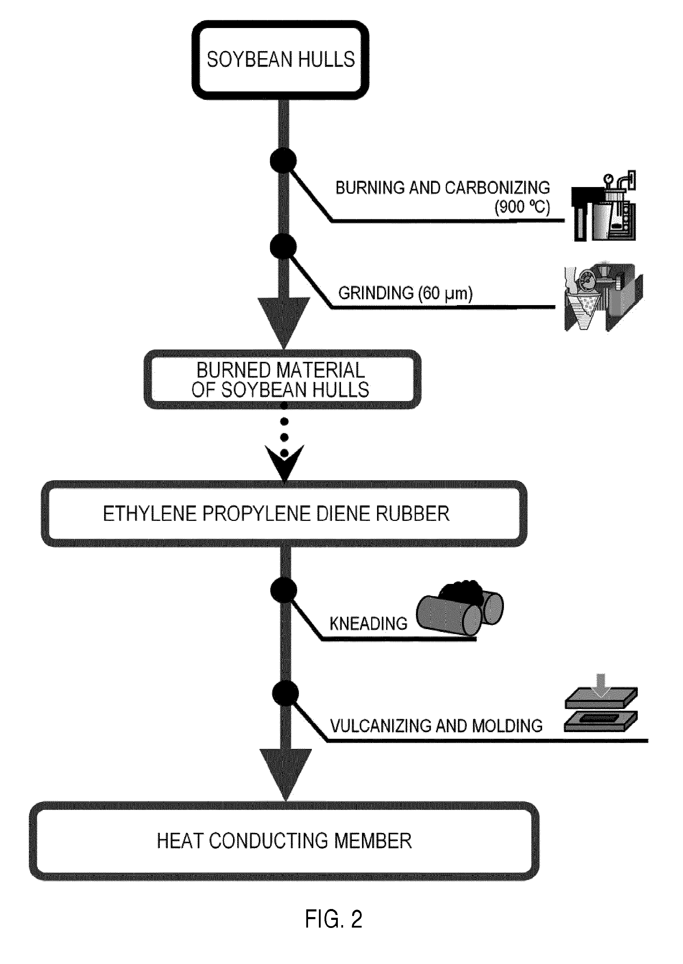

Fig. 2 shows a schematic production process diagram of the heat conducting material and the heat conducting member of this embodiment. First, raw soybean hulls caused by producing a food oil etc. are set in a carbonization apparatus, and are then heated at the rate of approx. 2 [°C] per minute in a nitrogen gas atmosphere to reach a prescribed temperature such as 700 [°C] - 1500 [°C] (for example, 900 [°C]). Then the carbonization process is provided for about 3 hours at the attained temperature.

Next, the burned soybean hulls are ground and sieved to obtain a burned material of soybean hulls with a median diameter of, for example, approx. 4 $\mu$m to approx. 80 $\mu$m (for example, 60 $\mu$m). In this way, first of all, a heat conduction material is produced. Subsequently, the heat conducting material and ethylene propylene diene monomer rubber are set in a kneading machine together with various additives and are then given a kneading process. Then, the kneaded material is given a molding process, and is then given a vulcanization process. In this way, the production of heat conducting member completes.

Here, the heat conducting member of this embodiment can be formed by using a metal mold with a required shaped etc. Therefore, even if an electronic substrate requiring heat conducting member mounted on an electronic appliance does not have a planer shape, a heat conducting member corresponding to the shape of the electronic substrate can be produced.

However, the heat conducting member of this embodiment also has a degree of freedom to process cutting and vending, etc. This point is also advantageous in the production of heat conducting member.

Today, due to space-saving inside the case of electronic appliance accompanied by the downsizing of electronic appliances in late years, there are problems such as a difficulty in using a heat conducting member, or necessity for a layout of electronic appliance considering the space allocation for a heat conducting member. Since the heat conducting member of this embodiment can be formed into a shape corresponding to the shape of the space inside electronic appliance, it also causes a secondary effect of not requiring a product layout etc. considering the space allocation for a heat conducting member.

The heat conducting member of this embodiment can be preferably used for electronic appliance, inspection apparatus for electronic appliance and building material, etc. That means, the heat conducting member of this embodiment can be provided for a communication terminal body such as a mobile phone and PDA (Personal Digital Assistant), etc., or can be mounted on an electronic substrate built in a communication terminal body, or can be provided for a so-called shield box, or can be provided for roof material, floor material or wall material, etc., or can be used for a part of work shoes and work clothes as an anti-static material due to its conductivity.

As a result of this, there are advantageous effects of making it possible to eliminate a cause for concern about adverse impact on human body from the electromagnetic waves generated from mobile phones etc. or power cables etc. around houses, to provide a light-weight shield box, and to provide work shoes etc. having anti-static capability.

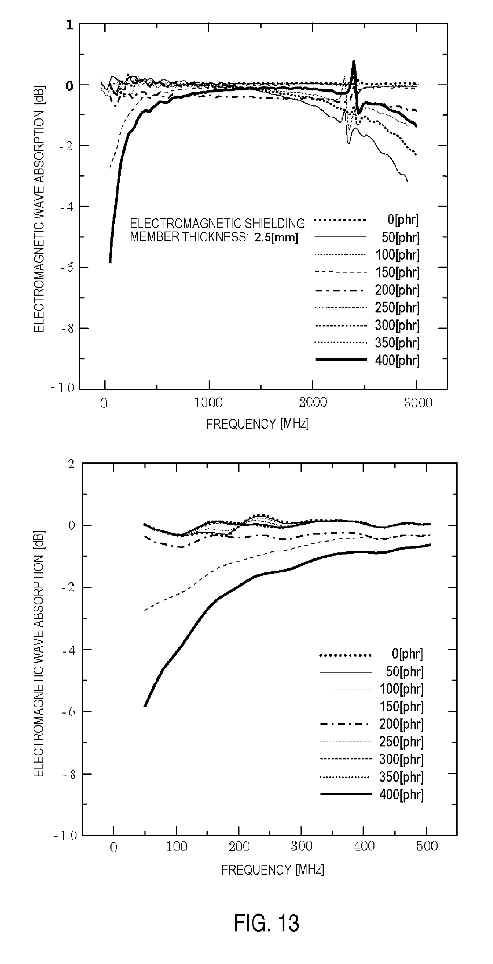

More specifically, as shown in Fig. 13, the heat conducting member of this embodiment can obtain excellent electromagnetic wave absorption characteristics, for example, in a frequency band of around 50 [MHz] - 300 [MHz] by accordingly adjusting the production conditions.

In addition, as shown in Fig. 1, the heat conducting member of this embodiment can achieve an electromagnetic shielding effectiveness of over 20 [dB] in a frequency band of 500 [MHz] and below by accordingly adjusting the production conditions. Thus, there is an advantageous effect of making it possible to provide a shield box useful in the frequency band of 500 [MHz] and below.

Next, the following measurements etc. have been carried out for "raw soybean hulls", "burned material of soybean hulls (heat conducting material)", and "heat conducting member".

(1) Component analysis of the "raw soybean hulls" and "burned material of soybean hulls", etc.
(2) Tissue observation of the "raw soybean hulls" and "burned material of soybean hulls",
(3) Conductivity test for the "burned material of soybean hulls",
(4) Regarding the "heat conducting member", measurement of the surface resistivity by different burning temperatures or median diameters for the heat conducting member of the test object.

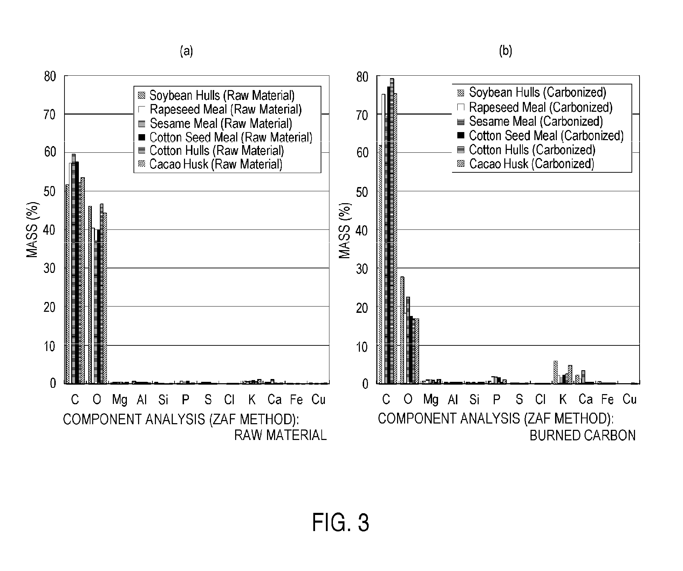

Fig. 3(a) shows a chart indicating the result of the component analysis based on the ZAF quantitative analysis method for soybean hulls, rapeseed meal, sesame meal, cotton seed meal, cotton hulls, and cacao husk before burning. Fig. 3(b) shows a chart indicating the result of the component analysis based on the ZAF quantitative analysis method for soybean hulls etc. shown in Fig. 3(a) after burning. Although the production conditions for the burned material of soybean hulls etc. are as shown in Fig. 2, the "prescribed temperature" and "median diameter" were respectively set to 900 [°C] and approx. 30 $\mu$m - approx. 60 $\mu$m. Since it has been said that the ZAF quantitative analysis method is quantitatively less reliable regarding C, H and N elements in comparison with the organic micro-elemental analysis method, an analysis based on the organic micro-elemental analysis method was also performed separately in order to perform a highly reliable analysis regarding C, H and N elements. The details of this point are described later.

The soybean hulls before burning shown in Fig. 3(a) are composed of the carbon (C) component and oxygen (O) component roughly half-and-half, respectively at 51.68% and 45.98%. Inorganic components etc. account for the rest of 2.35%.

Similar to the soybean hulls before burning, the rapeseed meal etc. before burning are composed of the carbon (C) component and oxygen (O) component roughly half-and-half. As seen in detail, it has been found that "C" shown in Fig. 3(a) accounts for 50% - 60% for all plants. It has also been found that these five kinds of plants are rich in "O" second only to "C".

In addition, as shown in Fig. 3(b), the soybean hulls after burning had its carbon (C) component increased by a factor of nearly 1.2 from those before burning. Specifically, it became 61.73% in the soybean hulls after burning.

In addition, the oxygen (O) component in the soybean hulls after burning was decreased to nearly half by burning. Although others have been variously changed (ranging from that reduced to half to that increased by a factor of 5), any of the changes were within several % of the total. It has also been read that the rapeseed meal etc. after burning somewhat tends to increase the carbon (C) component and to reduce the oxygen (O) component just like the soybean hulls after burning. Regarding the measurement target elements, none of them showed a distinctive change in quantity except for "C" and "O" for all plants, just like the case of soybean hulls.

Regarding soybean hulls, when the burning temperature was set to 1500 [°C], "C" was increased to 75.25%, "H" was decreased to 0.51%, and "N" was decreased to 0.96%. Furthermore, regarding soybean hulls, when the burning temperature was set to 3000 [°C], "C" was increased to 99.92%, "H" was decreased to 0.00%, and "N" was decreased to 0.03%.

However, the results of the component analysis shown in Fig. 3 are from those produced in the procedure and conditions shown in Fig. 2, and thus it should be noted that the carbon content etc. also varies depending on the burning temperature for soybean hulls etc. as shown in the above example. The details of this point are described later.

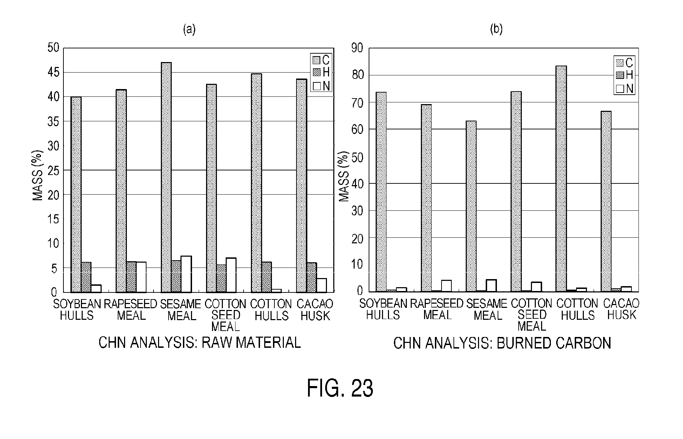

Fig. 23(a) shows a chart indicating the result of the component analysis based on the organic micro-elemental analysis method corresponding to Fig. 3(a). Fig. 23(b) shows a chart indicating the result of the component analysis based on the organic micro-elemental analysis method corresponding to Fig. 3(b).

As seen in Fig. 23(a) and Fig. 23(b), the ratios of organic elements included in the burned materials of six kinds of plants can generally be evaluated as similar to each other. This is considered to be attributable to the fact that soybean hulls and rapeseed meal etc. are no more than plants. However, since rapeseed meal, sesame meal and cotton seed meal have the common feature of being oil meal, it is perceived that those charts are similar to each other. Specifically, it is perceived that "N" is relatively high while the increase rate in "C" before and after burning is relatively low.

In contrast, since soybean hulls and cotton hulls have the common feature of being hulls, it is perceived that those charts are similar to each other. Specifically, it is perceived that "N" is relatively low while the increase rate in "C" before and after burning is relatively high. On the other hand, although a cacao husk has the common feature that "N" is relatively low, the increase rate in "C" before and after burning is relatively low. In addition, in terms of "C", cotton hulls are the highest (approx. 83%), while sesame meal is the lowest (approx. 63%).

As individually seen, according to the component analysis based on the organic micro-elemental analysis method, the soybean hulls before burning had the carbon (C) component, hydrogen (H) component and nitrogen (N) component of respectively 39.98%, 6.11% and 1.50%. Thus, it has been found that the soybean hulls before burning are essentially rich in the carbon component. In addition, it is seen in Fig. 23(a) that other plants such as rapeseed meal etc. are also essentially rich in the carbon component before burning.

In contrast, according to the component analysis based on the organic micro-elemental analysis method, the soybean hulls after burning had the carbon (C) component, hydrogen (H) component and nitrogen (N) component of respectively 73.57%, 0.70% and 1.55%. Thus, it has been found that the carbon component has been increased by burning. In addition, it is seen in Fig. 23(b) that other plants such as rapeseed meal etc. also have increased the carbon component by burning.

In addition, according to the component analysis for the cacao husk, the results of the component analysis of cacao husk before burning had the carbon component, hydrogen component and nitrogen component of respectively approx. 43.60%, approx. 6.02% and approx. 2.78%. In contrast, the results of the component analysis of cacao husk after burning had the carbon component, hydrogen component and nitrogen component of respectively approx. 65.57%, approx. 1.12% and approx. 1.93%. Furthermore, the specific volume resistivity of the burned material of cacao husk was $4.06 \times 10^{-2}$ Ω·cm.

As a summary of the above, according to the component analysis based on the organic micro-elemental analysis method, it is perceived that the plant material before burning, in general, is essentially rich in the carbon component and the carbon component after burning is increased by burning.

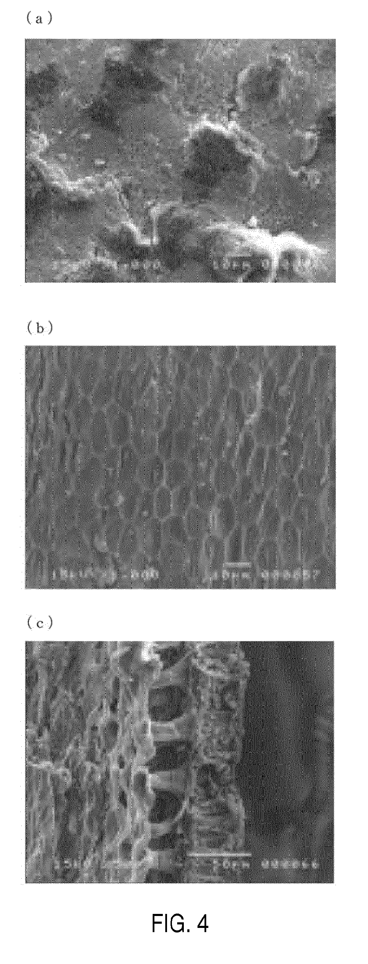

Fig. 4 shows Scanning Electron Microscope (SEM) pictures indicating the result of the tissue observation of "raw soybean hull". Fig. 4(a) - Fig. 4(c) respectively show a picture of the outer skin of a "raw soybean hull" taken at a magnification of 1000, a picture of the inner skin taken at a magnification of 1000, and a picture of the cross-section taken at a magnification of 500. The cross-section refers to an approximately orthogonal cross-section near the boundary face between the outer skin and the inner skin.

The outer skin of the raw soybean hull shown in Fig. 4(a) functions to somehow block the moisture between the outside and the inner skin. As far as this picture of the outer skin is seen, depressions and projections seem to be scattered around the surface in the overall shape.

The inner skin of the raw soybean hull shown in Fig. 4(b) has a net-like structure. As long as this picture of the inner skin is seen, a gentle undulation with less elevation differences is seen around the surface in the overall shape.

As far as this picture of the cross-section is seen, the cross-section of the raw soybean hull shown in Fig. 4(c) seems to have a plurality of columnar structures wherein one end is attached to the outer skin and the other end is attached to the inner skin.

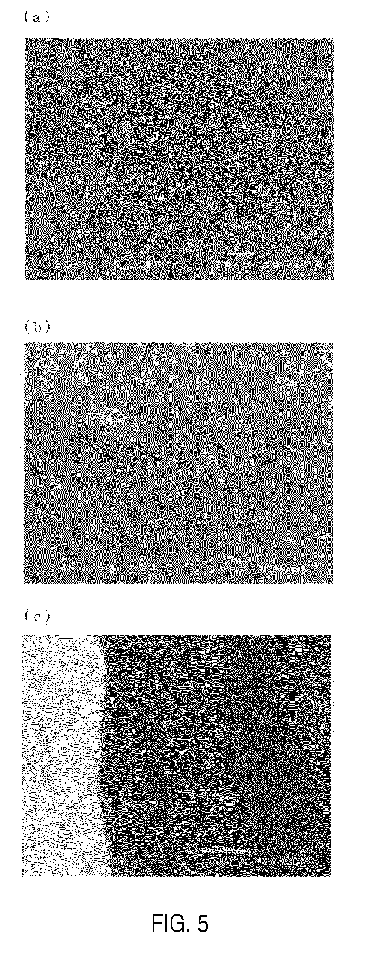

Fig. 5 shows SEM pictures indicating the result of the tissue observation of the "burned material of soybean hull". Fig. 5(a) - Fig. 5(c) respectively show a picture of the outer skin of the "burned material of soybean hull" taken at a magnification of 1000, a picture of the inner skin taken at a magnification of 1000, and a picture of the cross-section taken at a magnification of 500. Here, this soybean hull was burned at a burning temperature of 900 [°C].

As in the overall shape, the outer skin of the burned material of soybean hull shown in Fig. 5(a) seems to have no depressions and projections, which have been seen in the "raw soybean hull". However, the outer skin of the "burned material of soybean hull" was rough.

Although the inner skin of the burned material of soybean hull shown in Fig. 5(b) still shows a net-like structure, the net became finer due to the moisture loss. The inner skin of the "burned material of soybean hull" can also be evaluated as having a squashed net-like structure.

Although the cross-section of the burned material of soybean hull shown in Fig. 5(c) still shows columnar structures, each columnar part has been narrowed with a reduced height, and the gaps have been significantly decreased. The columnar parts also seem to be squashed and changed into a fiber-like form.

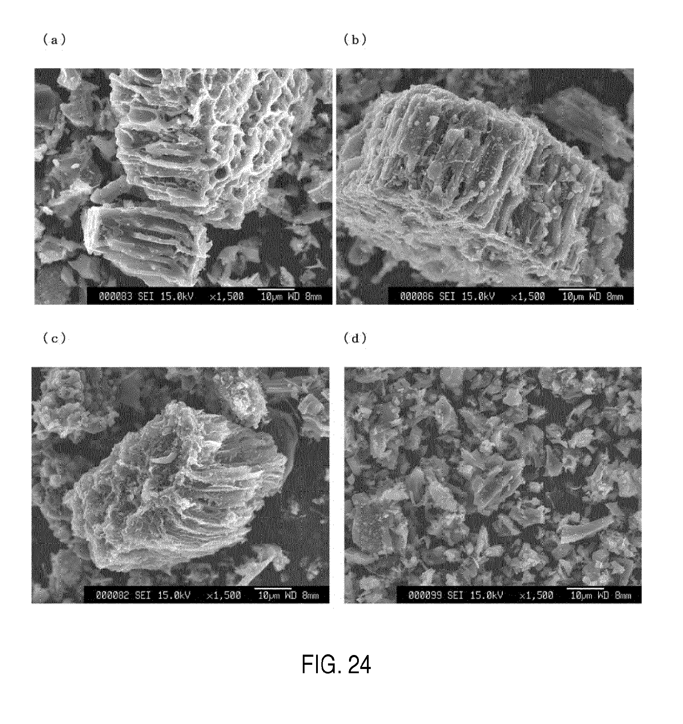

Fig. 24 shows SEM pictures of the "burned material of soybean hull". Fig. 24(a) - Fig. 24(c) show an SEM picture of the "burned material of soybean hulls" that was burned at a burning temperature of 900 [°C], 1500 [°C] and 3000 [°C] respectively, while Fig. 24(d) shows a SEM picture of the "burned material of soybean hulls" that was burned at a burning temperature of 900 [°C] and was then pulverized. All of SEM pictures were taken at a magnification of 1500.

As shown in Fig. 24(a) - Fig. 24(c), all of these pictures indicate a columnar structure, that is, porous structure, in the "burned material of soybean hull". However, as an impression, each columnar part seems to be thinner and shrunk as the burning temperature increases. This is considered to be attributable to the fact that the carbonization progresses as the burning temperature increases.

As shown in Fig. 24(d), the pulverized burned material of soybean hulls mostly has a particle size of approx. 10 $\mu$m or below. This corresponds to the condition that the median diameter of the pulverized burned material of soybean hulls becomes approx. 1/10 of the median diameter before pulverization. Specifically, the burned material shown in Fig. 24(d) had a median diameter of approx. 6.9 $\mu$m.

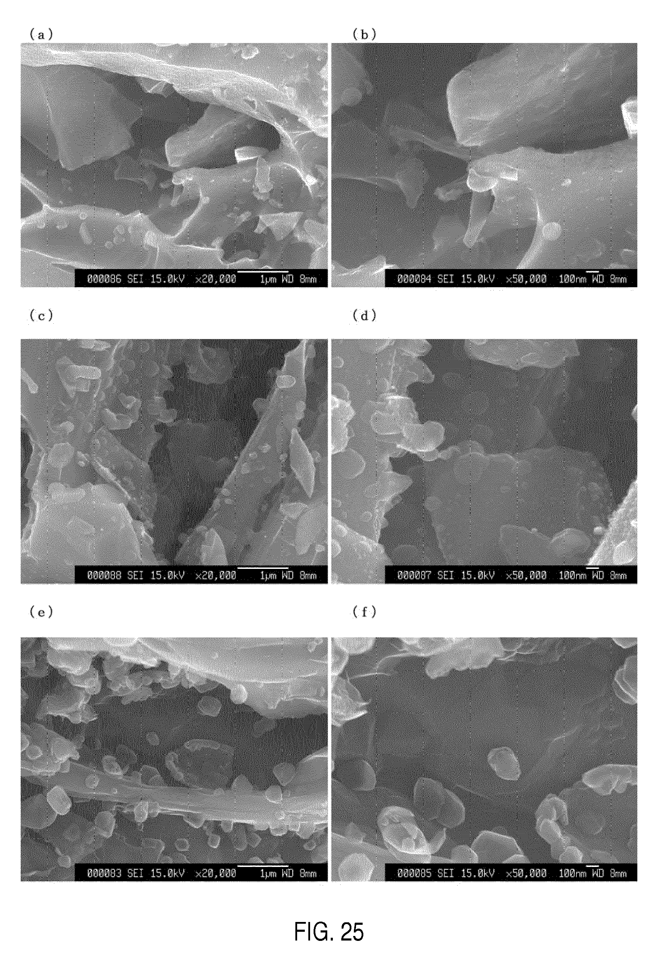

Fig. 25(a) and Fig. 25(b) show a SEM picture of the "burned material of soybean hulls" according to Fig 24(a) taken at a magnification of 20,000 and 50,000 respectively. Fig. 25(c) and Fig. 25(d) show a SEM picture of the "burned material of soybean hulls" according to Fig 24(b) taken at a magnification of 20,000 and 50,000 respectively. Fig. 25(e) and Fig. 25(f) show a SEM picture of the "burned material of soybean hulls" according to Fig 24(c) taken at a magnification of 20,000 and 50,000 respectively.

Interestingly, the burned material of soybean hulls has granular substances attached to the surface. Furthermore, these substances increase the number and the size as the burning temperature for the burned material of soybean hulls increases. It could not be specified that whether these substances were something like crystal growth, or something like carbon nanotubes, or otherwise neither of these, and this kind of phenomenon has not been confirmed in any other plants.

In addition, as seen in Fig. 25(a) - Fig. 25(f), the burned material of soybean hulls clearly shows a porous structure. When the crystallite size of the burned material of soybean hulls was measured by X-ray diffraction, it was found that the one in Fig. 24(a) had approx. 1 nm - approx. 3 nm, and the one in Fig. 24(b) and Fig. 24(c) had approx. 20 nm.

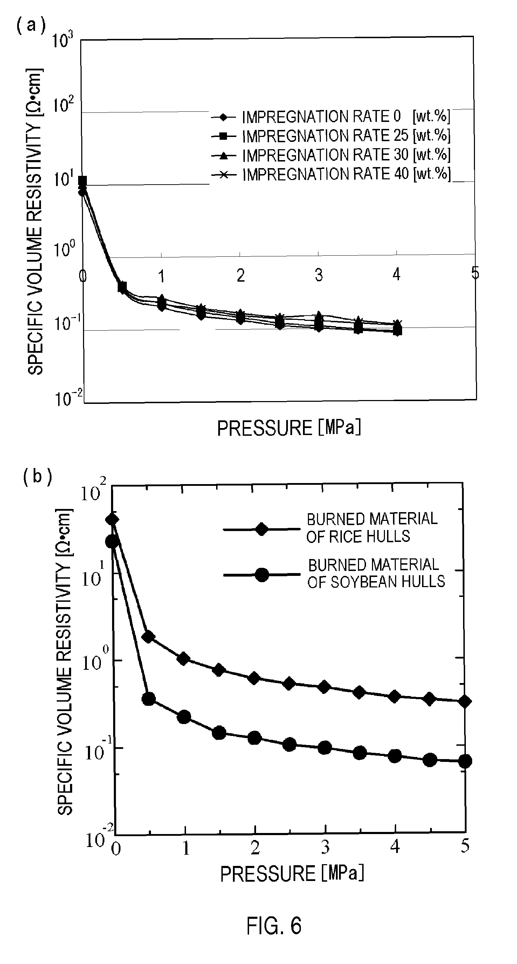

Fig. 6 shows charts indicating the test results of the conductivity test regarding the "burned material of soybean hulls". The lateral axis and vertical axis of Fig. 6 respectively represent the pressure [MPa] applied to the burned material of soybean hulls and the specific volume resistivity [$\Omega\cdot$cm]. As comparative examples, the impregnation rate of phenol resin to raw soybean hulls was set to 0 [wt.%], 25 [wt.%], 30[wt.%] and 40[wt.%], and the burned materials of respective soybean hulls were used as test objects. Fig. 6(b) shows a test result of rice hulls burned material as comparative examples, along with the conductivity test for the burned material of soybean hulls. The conductivity test was carried out in compliance with JIS (Japanese Industrial Standards)-K7194. The production conditions for both "burned material of soybean hulls" and burned material of rice hulls in Fig. 6(a) and Fig. 6(b) were set as a burning temperature of 900 [°C] and a median diameter of 60 $\mu$m.

The method employed was that, 1 g of the powdered "burned material of soybean hulls" as a measuring object was put in a cylindrical container with an inner diameter of approx. 25$\Phi$, and a cylindrical brass with a diameter of approx 25$\Phi$ was aligned to the opening part of the above container, and then a press machine (MP-SC manufactured by Toyo Seiki Seisaku-Sho, Ltd.) was used to apply pressure to the burned material of soybean hulls by pressing via the brass from 0 [MPa] to 4 [MPa] or 5 [MPa] with an increment of 0.5 [MPa] so that the specific volume resistivity was measured by bringing the side part and bottom part of the brass into contact with a probe of a low resistivity meter (Loresta-GP MCP-T600 manufactured by DIA Instruments Co. Ltd.) while the burned material of soybean hulls was pressured.

When a cylindrical container with approx. 10$\Phi$ was used instead of the cylindrical container with approx. 25$\Phi$, and a cylindrical brass with a diameter of approx. 10$\Phi$ was used instead of the cylindrical brass with a diameter of approx. 25$\Phi$, and when the rest of the conditions were the same as above, an equivalent test result was obtained by the conductivity test.

According to the test result shown in Fig. 6(a), it is found that the burned material of soybean hulls reduces its specific volume resistivity (that is, increasing the conductivity) as the pressure increases, regardless of high or low of the impregnation rate of phenol resin to raw soybean hulls.

Furthermore, according to the test result of Fig. 6(a), the conductivity of the burned material of soybean hulls is not much affected by the impregnation rate of phenol resin. Furthermore, when the burned material of soybean hulls is under no pressure (0 [MPa]), its specific volume resistivity is approx. $10^{1.0}$ [$\Omega\cdot$cm], while it is under a pressure of 0.5 [MPa], its specific volume resistivity is approx. $10^{-0.4}$ [$\Omega\cdot$cm], and subsequently even if it is under a pressure of up to 4.0 [MPa], its specific volume resistivity stays at approx. $10^{-1.0}$ [$\Omega\cdot$cm]. Therefore, the burned material of soybean hulls can be evaluated as reducing the specific volume resistivity provided that a certain pressure is applied, however it is not showing enough reduction to say significant in the specific volume resistivity by the further pressure increase.

According to Fig. 6(b), it is found that the specific volume resistivity of the burned material of soybean hulls is lower than that of the burned material of rice hulls both under no pressure and under pressure, while the burned material of soybean hulls is higher in conductivity. The conductivity of the burned material of soybean hulls shown in Fig. 6(b) is about the same as that of carbon black.

In fact, although there is exactly three times difference, for example, between the specific volume resistivity of $1.0\times10^{-1}$ $[\Omega\cdot cm]$ and the specific volume resistivity of $3.0\times10^{-1}$ $[\Omega\cdot cm]$, such a degree of exactness is not required in the measurement results of the specific volume resistivity as it is clearly known by those skilled in the art. Thus, since the specific volume resistivity of $1.0\times10^{-1}$ $[\Omega\cdot cm]$ and the specific volume resistivity $3.0\times10^{-1}$ $[\Omega\cdot cm]$ both are on the same order of "$10^{-1}$", those can be evaluated as equivalent to each other.

In addition, in view of the evaluation of Fig. 6, since there is a possibility that phenol resin does not effectively impregnate into soybean hulls, there is room to improve the conductivity of the burned material of soybean hulls by applying a pre-processing such as provisional burning for soybean hulls or pulverizing prior to phenol resin impregnation for raw soybean hulls etc. so as to facilitate the permeation of phenol resin into soybean hulls.

As a summary of the above, it is found that the burned plant material of this embodiment has a characteristic of increasing its conductivity by applying a pressure of, for example, 0.5 [MPa] or above.

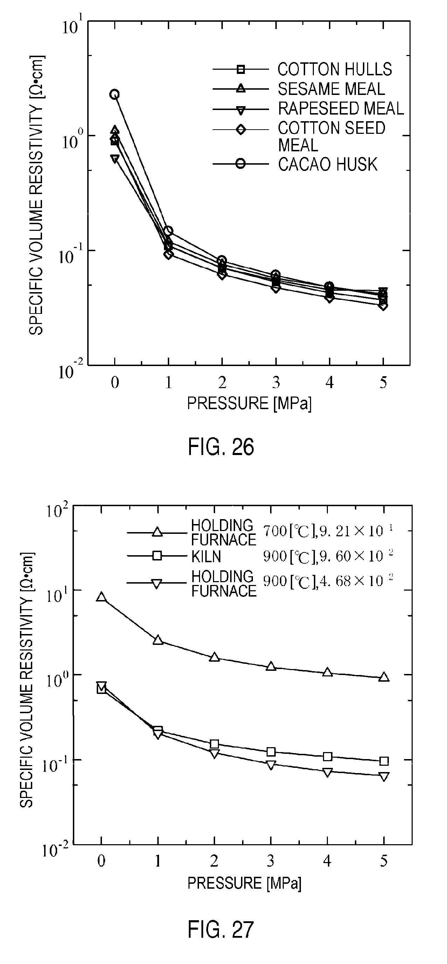

Fig. 26 shows a chart indicating the test results of the conductivity test regarding the burned materials of cotton hulls, sesame meal, rapeseed meal, cotton seed meal and cacao husk. The lateral axis of Fig. 26 represents the pressure [MPa] applied to the burned materials of cotton hulls etc. burned at a burning temperature of 900 [°C], and the vertical axis represents the specific volume resistivity $[\Omega\cdot cm]$. Here, this conductivity test was performed by the same method as the case explained for Fig. 6.

As clearly seen in comparison with Fig. 6(b), it is found that the conductivity regarding cotton hulls, sesame meal, rapeseed meal, cotton seed meal and cacao husk has a specific volume resistivity approximately equivalent to that of the burned material of soybean hulls.

Specifically, the specific volume resistivity of cotton hulls was $3.74\times10^{-2}$ $[\Omega\cdot cm]$, and the specific volume resistivity of sesame meal was $4.17\times10^{-2}$ $[\Omega\cdot cm]$, and the specific volume resistivity of rapeseed meal was $4.49\times10^{-2}$ $[\Omega\cdot cm]$, and the specific volume resistivity of cotton seed meal was $3.35\times10^{-2}$ $[\Omega\cdot cm]$, and the specific volume resistivity of cacao husk was $4.06\times10^{-2}$ $[\Omega\cdot cm]$.

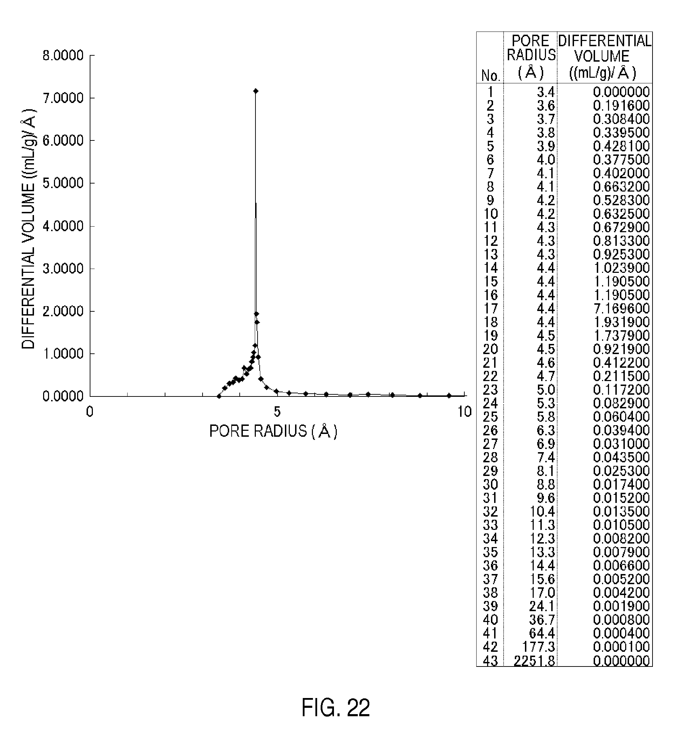

Fig. 22 shows a chart indicating the test results of the conductivity test regarding the burned material of soybean hulls, wherein the burning furnace and burning temperature were changed. The lateral axis and vertical axis of Fig. 27 respectively represent the pressure [MPa] applied to the burned material of soybean hulls and the specific volume resistivity $[\Omega\cdot cm]$. The one under the conditions corresponding to those shown in Fig. 6 is indicated by a chart plotted with □.

First, as comparing the case that a holding furnace was chosen as the burning furnace and the burning temperature stayed at 900 [°C] (plotted with V) with the case that a rotary kiln was chosen as the burning furnace and the burning temperature stayed at 900 [°C] (plotted with D), there is not much difference in specific volume resistivity between those. Specifically, the specific volume resistivity of the chart plotted with V is $4.68\times10^{-2}$ $[\Omega\cdot cm]$, while the specific volume resistivity of the chart plotted with □ is $9.60\times10^{-2}$ $[\Omega\cdot cm]$, and therefore, both are in common with being on the order of "$10^{-2}$". Thus, it can be said that the selection of the burning furnace for soybean hulls is most unlikely to affect the specific volume resistivity.

In contrast, when a rotary kiln was chosen as the burning furnace and the burning temperature was lowered to 700 [°C] (plotted with $\Delta$), the specific volume resistivity was increased in comparison with the case of setting the burning temperature to 900 [°C] in a holding furnace (plotted with V). Thus, it can be said that the burning temperature for soybean hulls affects the specific volume resistivity.

Hence, the specific volume resistivity was measured further at different burning temperatures for soybean hulls. In addition, the specific volume resistivity was also measured for a pulverized burned material of soybean hulls.

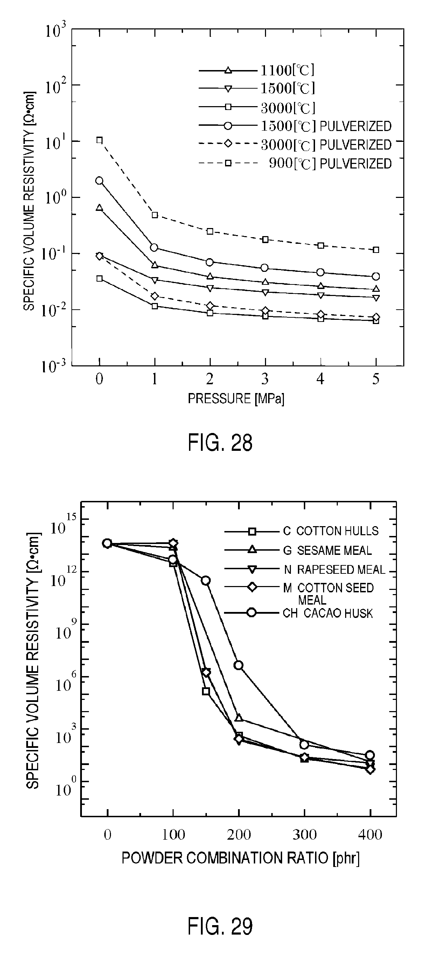

Fig. 28 shows a chart indicating the test results of the conductivity test regarding, wherein the burning temperature etc. were changed. The lateral axis and vertical axis of Fig. 28 respectively represent the pressure [MPa] applied to the burned material of soybean hulls and the specific volume resistivity $[\Omega\cdot cm]$.

Fig. 28 shows charts respectively in the case that the burning temperature was set to 1100 [°C] (plotted with $\Delta$), in the case that the burning temperature was set to 1500 [°C] (plotted with V), in the case that the burning temperature was set to 3000 [°C] (solid line, plotted with D), in the case that the burning temperature was set to 1500 [°C] and the burned material was pulverized (plotted with O), in the case that the burning temperature was set to 3000 [°C] and the burned material was pulverized (plotted with $\diamond$), and in the case that the burning temperature stayed at 900 [°C] and the burned material was pulverized (dotted line, plotted with □).

As clearly seen in Fig. 28, the one in the case that the burning temperature stayed at 900 [°C] and the burned material was pulverized (dotted line, plotted with D) shows the highest specific volume resistivity among these. As comparing this specific volume resistivity with the chart in Fig. 6, it is found that the pulverized burned material has a slightly higher specific volume resistivity.

The chart with the second highest specific volume resistivity is from the case that the burning temperature was set to 1500 [°C] and the burned material was pulverized (plotted with O). The reason for the high specific volume resistivity can be evaluated to be attributable to the relatively lower burning temperature. In addition, as comparing the case that the burning temperature was set to 1500 [°C] and the burned material was pulverized (plotted with O) with the case that the burning temperature was set to 1500 [°C] and the burned material was not pulverized (plotted with V), the pulverized burned material has a higher specific volume resistivity.

As described above, the same tendency is observed in the burned material at a burning temperature of 900 [°C], and is also observed in the burned material at a burning temperature of 3000 [°C] as explained below. Therefore, it can be said that the burned material of soybean hulls increases its specific volume resistivity when pulverized.

In addition, paying attention to the burning temperature, the burned material of soybean hulls by a burning temperature of 1500 [°C] (plotted with V) has a specific volume resistivity lower than that of the one by a burning temperature of 1100 [°C] (plotted with $\Delta$), and further the one by a burning temperature of 3000 [°C] (dotted line, plotted with D) has an even lower specific volume resistivity, and thus it can be said that the specific volume resistivity decreases as the burning temperature increases. This relationship between burning temperature and specific volume resistivity also fits to the case of pulverizing the burned materials.

Next, when measuring the specific volume resistivity of the burned material of soybean hulls, some parameters were changed. The pressure condition was the same at 0.5 [MPa].

(2) Change in the median diameter of the burned material of soybean hulls

The median diameter of the burned material of soybean hulls was changed to approx. 15 $\mu$m and to approx. 30 $\mu$m by the previously-mentioned sieving followed by grinding etc. However, those values of the specific volume resistivity are both around approx. $10^{-1.0}$ [$\Omega \cdot$cm] showing no significant difference.

In contrast, when the median diameter of the burned material of soybean hulls was changed to approx. 4 $\mu$m and to approx. 8 $\mu$m by the previously-mentioned sieving followed by grinding etc., the specific volume resistivity slightly increased to around approx. $10^{-0.7-0.8}$ [$\Omega \cdot$cm]. In the case of these values, it is speculated that it is due to almost no columnar or net-like structure in the cell layer that is unique to soybean hulls in spite of the change in the median diameter of the burned material of soybean hulls.

(3) Change in the burning temperature for soybean hulls

When the burning temperature for soybean hulls was changed, an interesting measurement result was obtained. More specifically, the burning temperature for soybean hulls was changed to approx. 500 [°C], approx. 700 [°C], approx. 1100 [°C] and approx. 1500 [°C]. The measuring object was prepared at a phenol resin impregnation rate of 25 [wt. %] for raw soybean hulls and under the pressure condition of 5 [MPa] for the burned material of soybean hulls.

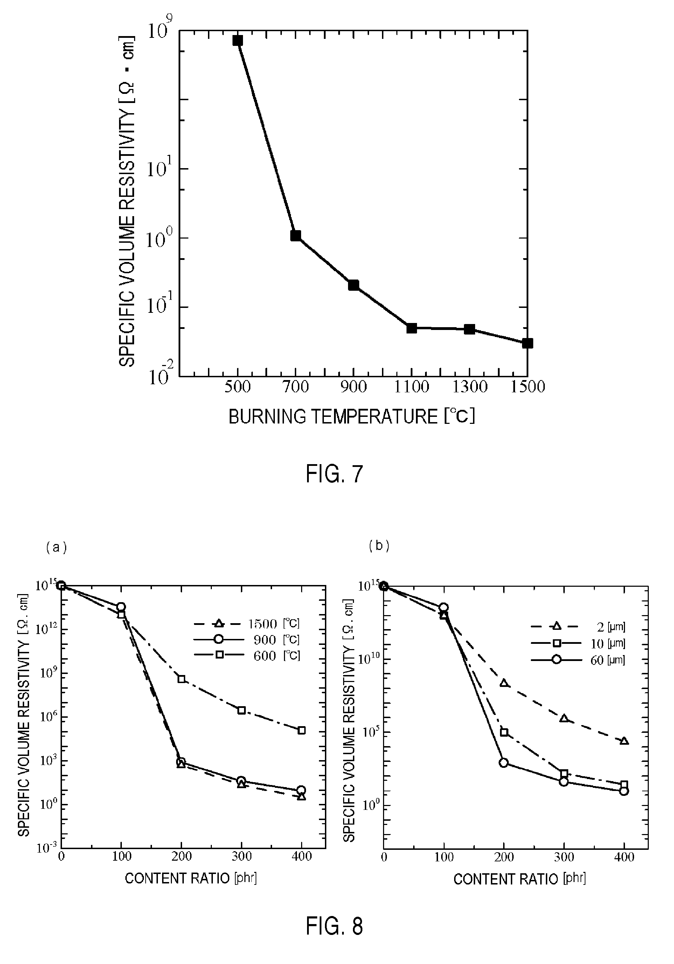

Fig. 7 shows a chart indicating the relationship between the burning temperature for soybean hulls and the specific volume resistivity. The lateral axis and vertical axis of Fig. 7 respectively represent the burning temperature [°C] for soybean hulls and the specific volume resistivity [$\Omega \cdot$cm]. According to Fig. 7, as the burning temperature for soybean hulls increases, the specific volume resistivity drastically decreases. It is highly likely that this is attributable to the improved carbon content in the burned material of soybean hulls.

In contrast, when the burning temperature for soybean hulls becomes approx. 1100 [°C] or above, it is found that there is not much change in the specific volume resistivity. It can be considered that this is due to almost no change in the carbon content and other component contents in the burned material of soybean hulls.

In particular, a larger change is seen where the burning temperature for soybean hulls is between approx. 500 [°C] and approx. 700 [°C]. It can be considered that this is due to a large change in the carbon content in the burned material of soybean hulls. When the burning temperature for soybean hulls was approx. 1500 [°C], the specific volume resistivity was as very small as approx. $10^{-1.5}$ [$\Omega \cdot$cm].

As a summary of the above, it is found that the heat conducting member of this embodiment has a characteristic of increasing its conductivity when the burning temperature for soybean hulls is, for example, 700 [°C] or above.

(4) Other changes

In addition to changing either the median diameter of the burned material of soybean hulls or the burning temperature for soybean hulls, the content ratio of the burned material of soybean hulls against ethylene propylene diene monomer rubber was changed.

Fig. 8 shows a chart indicating the relationship between the content ratio of the burned material of soybean hulls and the specific volume resistivity. Fig. 8(a) shows measurements at a burning temperature for soybean hulls of 600 [°C], 900 [°C] and 1500 [°C] respectively. The lateral axis and vertical axis of Fig. 8(a) respectively represent the content ratio [phr] of the burned material of soybean hulls and the specific volume resistivity [$\Omega \cdot$cm]. In both cases, the median diameter of the burned material of soybean hulls was set to 60 $\mu$m, and the thickness of the mixture of the burned material of soybean hulls and the base material was set to 2.5 [mm]. The plotted numeric in Fig 8 is an average of measurements at 9 arbitrarily chosen points in the mixture of the burned material of soybean hulls and the base material.

As shown in Fig. 8(a), regardless of the burning temperature for soybean hulls, the specific volume resistivity decreases as the content ratio of the burned material of soybean hulls increases. When the burning temperature was relatively high such as the burning temperature for soybean hulls of 900 [°C] and 1500 [°C], no significant difference was observed regardless of the content ratio of the burned material of soybean hulls. Said specific volume resistivity is reduced as the content ratio of the burned material of soybean hulls increases, and in particular, an abrupt fall is seen in the content ratio of the burned material of soybean hulls around approx. 100 [phr] - approx. 200 [phr].

In contrast, when the burning temperature was relatively low such as the burning temperature for soybean hulls of 600 [°C], the specific volume resistivity still decreased as the content ratio of the burned material of soybean hulls increased, however said fall in the specific volume resistivity was more linear in comparison with the case of the relatively higher burning temperature for soybean hulls. Thus, no abrupt fall was observed unlike in the case of the burning temperature for soybean hulls of 900 [°C] etc.

Therefore, the reason for different measurement results depending on a relatively high or low burning temperature for soybean hulls is considered as follows: That is, organic components with insulation properties essentially exist inside soybean hulls, and when the burning temperature for soybean hulls is relatively low, it is considered that those largely remain without carbonization or pyrolysis in comparison with the case of the relatively high burning temperature for soybean hulls.

It is considered that the reason why the case of the burning temperatures of soybean hulls of 900 [°C] and the case of 1500 [°C] show almost the same measurement result is that there is no significant change in the component constitution of soybean hulls, that is, the carbon content when the burning temperature is 900 [°C] or above.

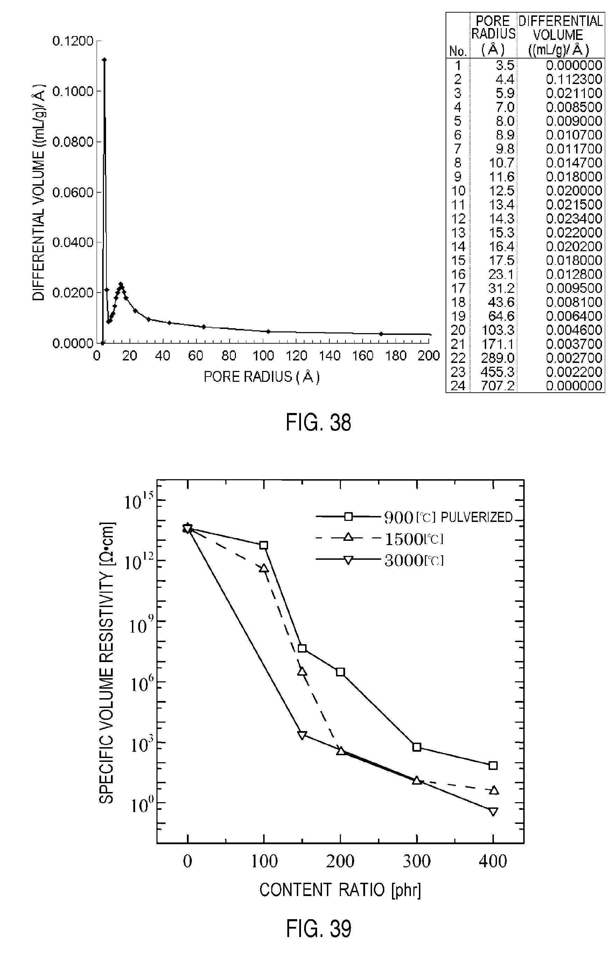

Fig.39 shows a chart indicating the specific volume resistivity regarding the burned material of soybean hulls, wherein the burning temperature etc. was changed. Fig.39 shows respective measurement results for the burned material of soybean hulls that was burned at 900 [°C] and was then pulverized, and the burned material of soybean hulls that was burned at 3000 [°C] and was not pulverized. For reference, it also includes the measurement result for the burned material of soybean hulls that was burned at 1500 [°C] and was not pulverized shown in Fig. 8(a).

First, in the case of the burned material of soybean hulls that was burned at 3000 [°C], when the content ratio of the burned material of soybean hulls is 0 [phr], the measurement result is almost the same as the case of the burned material of soybean hulls that was burned at 900 [°C].

However, in the case of the burned material of soybean hulls that was burned at 3000 [°C], when the content ratio of the burned material of soybean hulls is 150 [phr] and 400 [phr], it is confirmed that the specific volume resistivity is about $3.0 \times 10^3$ [$\Omega \cdot$cm] and $80 \times 10^{-1}$ [$\Omega \cdot$cm] respectively.

According to the measurement result shown in Fig. 39 regarding the burned material of soybean hulls that was burned at 3000 [°C] and the measurement result shown in Fig. 8(a), when the burning temperature exceeds a certain temperature of 1500 [°C] or above, it is found that a significant change is caused in the carbon content of the burned material of soybean hulls, showing a change in the specific volume resistivity.

In addition, according the measurement result shown in Fig. 39, it can be generally said that the higher the burning temperature becomes, the higher the conductivity becomes, and also the higher the content ratio of the burned material of soybean hulls against rubber becomes, the more the conductivity improves.

Furthermore, according to the measurement result shown in Fig. 39, when the burned material of soybean hulls is pulverized, the conductivity somewhat decreases. Thus, it is found that the grain size of the burned material of soybean hulls affects the high or low of the conductivity. However, when the burned material of soybean hulls is pulverized, it is found that the specific volume resistivity changes more gently as the content ratio of the burned material of soybean hulls against rubber changes. This is prominently seen when the content rate of the burned material of soybean hulls is changed from 150 [phr] to 300 [phr]. Thus, it can be said that pulverizing the burned material of soybean hulls has an advantageous effect of making it easy to control its specific volume resistivity.

Fig. 8(b) shows measurement results of the specific volume resistivity at the median diameter of the burned material of soybean hulls of 2$\mu$m, 10 $\mu$m and 60 $\mu$m respectively. The lateral axis and vertical axis of Fig. 8(b) respectively represent the content ratio [phr] of the burned material of soybean hulls and the specific volume resistivity [$\Omega \cdot$cm]. In all cases, the burning temperature for soybean hulls was set to 900 [°C], and the thickness of the mixture of the burned material of soybean hulls and the base material was set to 2.5 [mm].

As shown in Fig. 8(b), it is found that the specific volume resistivity decreases as the content ratio of the burned material of soybean hulls increases regardless of the median diameter of the burned material of soybean hulls. In addition, it is found that the specific volume resistivity decreases as the median diameter of the burned material of soybean hulls increases. It is considered that this is because the burned material of soybean hulls is getting harder to form clusters inside rubber as the median diameter of the burned material decreases.

Here, the cluster is formed by the burned materials of soybean hulls linking with each other and forming a current pathway. Therefore, when it is hard for clusters to be formed, it is hard for electrical current to flow. Corresponding to the increased content ratio of the burned material of soybean hulls, the specific volume resistivity gently decreases, making it easy for electrical current to flow. In contrast, when an excess amount of clusters have been formed, the specific volume resistivity abruptly falls even if the content ratio of the burned material of soybean hulls is low.

As a summary of the above, it is found that the heat conducting material of this embodiment has a characteristic of increasing its conductivity when the median diameter of the burned material of soybean hulls is, for example, 10 $\mu$m or above.

Fig. 29 shows a chart indicating the relationship between the content ratio of the burned material of cotton hulls, sesame meal, rapeseed meal, cotton seed meal and cacao husk, and the specific volume resistivity. The lateral axis and vertical axis of Fig. 29 respectively represent the content ratio [phr] of the burned material of cotton hulls etc. and the specific volume resistivity [$\Omega\cdot$cm]. In the burned material of any plants, the burning temperature was set to 900 [°C], and the thickness of the heat conducting member was set to 2.5 [mm]. The plotted numeric in Fig 29 is an average of measurements at 9 arbitrarily chosen points in the heat conducting member.

As shown in Fig. 29, each specific volume resistivity of cotton hulls, sesame meal, rapeseed meal and cotton seed meal had a measurement result similar to each other. It can be said that these specific volume resistivities are also similar to the specific volume resistivity of soybean hulls shown in Fig. 8(b).

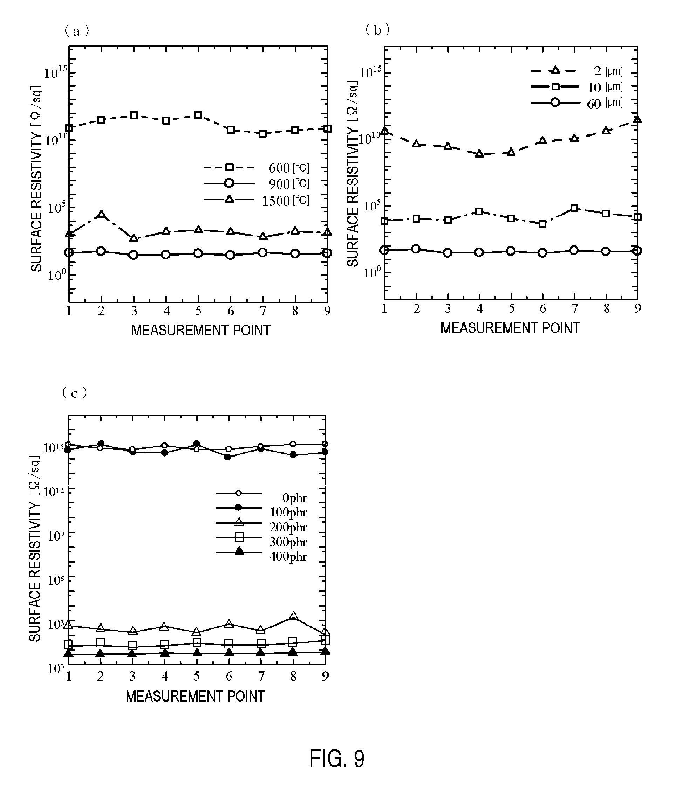

Fig. 9 shows charts indicating the measurement results of the "surface resistivity" of the heat conducting member of the test object. When measuring the surface resistivity, the burning temperature for soybean hulls, the median diameter of soybean hulls, and the content ratio of the burned material of soybean hulls against rubber were changed.

Fig. 9(a) shows a chart indicating the measurement results of the "surface resistivity" by different burning temperatures for obtaining the heat conducting member of the test object. The lateral axis and vertical axis of Fig. 9(a) respectively represent the measurement point in the heat conducting member and the surface resistivity [$\Omega$/sq]. Here, the heat conducting member was measured at 9 arbitrarily chosen points in each case of the burning temperature for soybean hulls of 600 [°C], 900 [°C] and 1500 [°C]. In all cases, the median diameter of the burned material of soybean hulls was set to 60 $\mu$m, the content ratio of the burned material of soybean hulls against the base material was set to 200 [phr], and the thickness of the heat conducting member was set to 2.5 [mm].

According to the measurement results shown in Fig. 9(a), the surface resistivity did not show a significant difference depending on the position in the heat conducting member regardless of high or low of the burning temperature. However, when the burning temperature is higher, the fluctuations in the surface resistivity seem to be slightly reduced. It is considered that this is due to correction of nonuniformity in the component constitution of soybean hulls since the carbonization of soybean hulls progresses as the burning temperature increases.

Fig. 9(b) shows a chart indicating the measurement results of the "surface resistivity" by different median diameters of the burned material of soybean hulls regarding the heat conducting material of the test object. The lateral axis and vertical axis of Fig. 9(b) respectively represent the measurement point in the heat conducting member and the surface resistivity [$\Omega$/sq]. Here, the heat conducting member was measured at 9 arbitrarily chosen points in each case of the median diameter of the burned material of soybean hulls of 2 $\mu$m, 10 $\mu$m and 60 $\mu$m. In all cases, the burning temperature for soybean hulls was set to 900 [°C], the content ratio of the burned material of soybean hulls against the base material was set to 200 [phr], and the thickness of the heat conducting member was set to 2.5 [mm].

According to the measurement results shown in Fig. 9(b), the surface resistivity did not show a significant difference depending on the position in the heat conducting member regardless of large or small of the median diameter of the burned material of soybean hulls. However, when the median diameter of the burned material of soybean hulls is larger, the fluctuations in the surface resistivity seem to be slightly reduced, and also the surface resistivity seems to be reduced.

Fig. 9(c) shows a chart indicating the measurement results of the "surface resistivity" by different content ratio of the burned material of soybean hulls against rubber. The lateral axis and vertical axis of Fig. 9(c) respectively represent the measurement point in the heat conducting member and the surface resistivity [$\Omega$/sq]. Here, the heat conducting member was measured at 9 arbitrarily chosen points in each case that the content ratio of the burned material of soybean hulls against rubber was 0 [phr], 100 [phr], 200 [phr], 300 [phr] and 400 [phr]. In all cases, the median diameter of the burned material of soybean hulls was set to 60 $\mu$m, the burning temperature for soybean hulls was set to 900 [°C], and the thickness of the heat conducting member was set to 2.5 [mm].

According to the measurement results shown in Fig. 9(c), the surface resistivity did not show a significant difference depending on the position in the heat conducting member regardless of high or low of the content ratio of the burned material of soybean hulls against rubber. However, when the content ratio of the burned material of soybean hulls against rubber is higher, the fluctuations in the surface resistivity seem to be slightly reduced, and also the surface resistivity seems to be reduced.

As a summary of the above, it is found that the heat conducting material of this embodiment has a characteristic of increasing its conductivity by setting the content ratio of the burned material of soybean hulls against rubber to 200 [phr] or above, and increasing the burning temperature, and increasing the grain size.

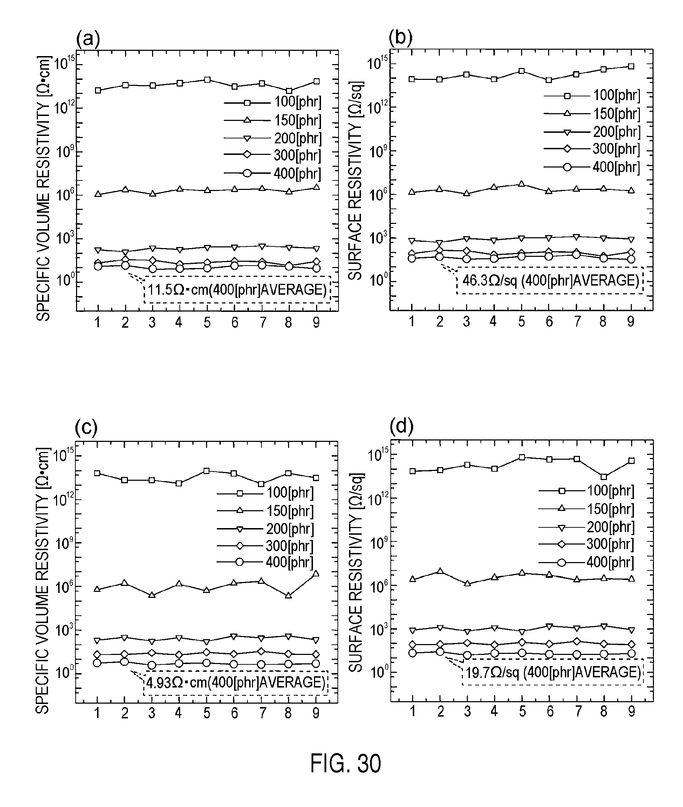

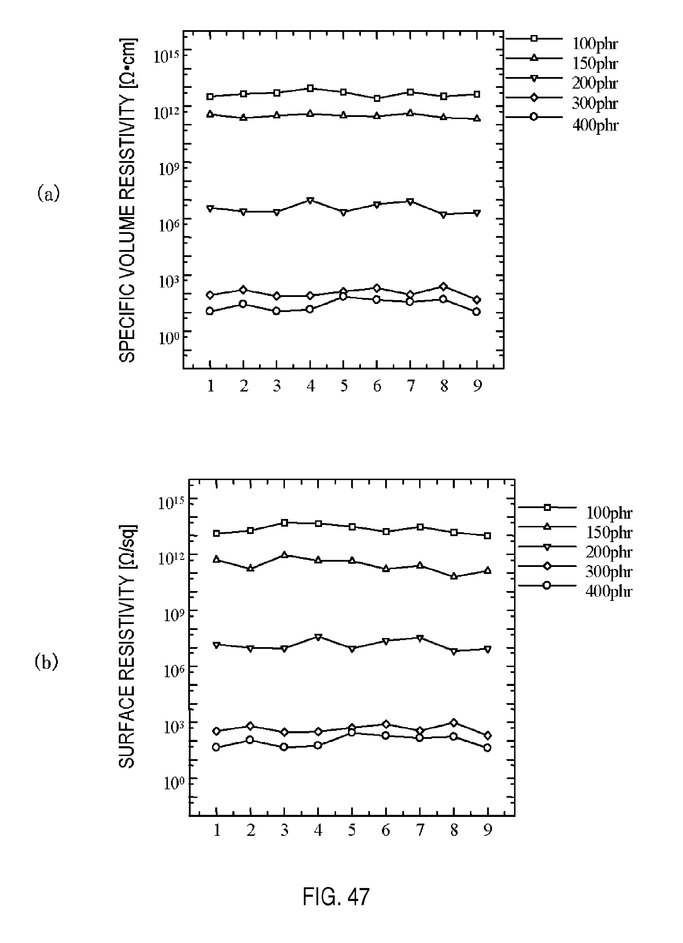

Fig. 30(a) - Fig. 30(h) show a chart indicating the measurement results of the specific volume resistivity and surface resistivity of the heat conducting member of the burned materials of rapeseed meal, sesame meal, cotton seed meal and cotton hulls, Fig. 47(a) and Fig. 47(b) show a chart indicating the measurement results of the specific volume resistivity and surface resistivity of the heat conducting member of the burned materials of cacao husk, and each of these corresponds to Fig. 9(c). The burning temperature for rapeseed meal etc. was set to 900 [°C].

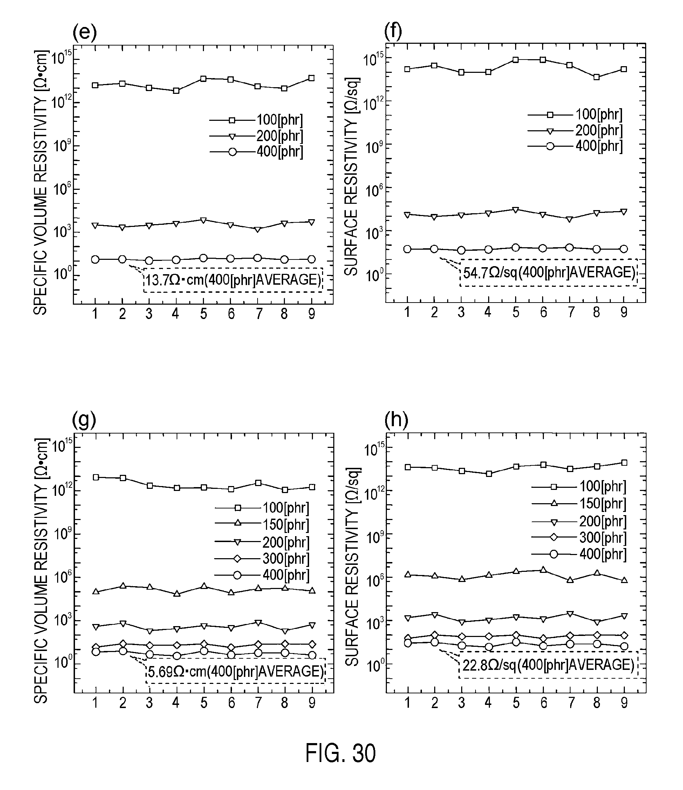

In Fig. 30(a), Fig. 30(c), Fig. 30(e), Fig. 30(g) and Fig. 47(a), the lateral axis and vertical axis respectively represent the measurement point in the heat conducting member and the specific volume resistivity [$\Omega\cdot$cm]. In Fig. 30(b), Fig. 30(d), Fig. 30(f), Fig. 30(h) and Fig. 47(b), the lateral axis and vertical axis respectively represent the measurement point in the heat conducting member and the surface resistivity [$\Omega$/sq].

Fig. 30(a) and Fig. 30(b) show a chart of the specific volume resistivity and surface resistivity respectively, regarding the heat conducting member of the burned material of rapeseed meal. According to Fig. 30(a) and Fig. 30(b), it is found to have a characteristic of increasing the conductivity when the content ratio of the burned material of rapeseed meal against rubber is set to 200 [phr] or above. When the content ratio of the burned material of rapeseed meal against rubber was set to 400 [phr], the specific volume resistivity was 11.5 [$\Omega\cdot$cm] and the surface resistivity was 46.3 [$\Omega$/sq].

Fig. 30(c) and Fig. 30(d) show a chart of the specific volume resistivity and surface resistivity respectively, regarding the heat conducting member of the burned material of cotton seed meal. According to Fig. 30(c) and Fig. 30(d), it is found to have a characteristic of increasing the conductivity also when the content ratio of the burned material of cotton seed meal against rubber is set to 200 [phr] or above. When the content ratio of the burned material of cotton seed meal against rubber was set to 400 [phr], the specific volume resistivity was 4.93 [$\Omega\cdot$cm] and the surface resistivity was 19.7 [$\Omega$/sq], both indicating the best result among those shown in Fig. 30.

Fig. 30(e) and Fig. 30(f) show a chart of the specific volume resistivity and surface resistivity respectively, regarding the heat conducting member of the burned material of sesame meal. According to Fig. 30(e) and Fig. 30(f), it is found to have a characteristic of increasing the conductivity also when the content ratio of the burned material of sesame meal against rubber is set to 200 [phr] or above. When the content ratio of the burned material of cotton seed meal against rubber was set to 400 [phr], the specific volume resistivity was 13.7 [$\Omega\cdot$cm] and the surface resistivity was 54.7 [$\Omega$/sq].

Fig. 30(g) and Fig. 30(h) show a chart of the specific volume resistivity and surface resistivity respectively, regarding the heat conducting member of the burned material of cotton hulls. According to Fig. 30(e) and Fig. 30(f), it is found to have a characteristic of increasing the conductivity also when the content ratio of the burned material of cotton hulls against rubber is set to 200 [phr] or above. When the content ratio of the burned material of cotton hulls against rubber was set to 400 [phr], the specific volume resistivity was 5.69 [$\Omega\cdot$cm] and the surface resistivity was 22.8 [$\Omega$/sq].

Fig. 47(a) and Fig. 47(b) show a chart of the specific volume resistivity and surface resistivity respectively regarding the heat conducting member of the burned material of cacao husk. According to Fig. 47(a) and Fig. 47(b), it is found to have a characteristic of increasing the conductivity when the content ratio of the burned material of cacao husk against rubber is set to 200 [phr] or above. When the content ratio of the burned material of rapeseed meal against rubber was set to 400 [phr], the specific volume resistivity was 30.6 [$\Omega\cdot$cm] and the surface resistivity was 119.2 [$\Omega$/sq].

From the above consideration, it can be said that it has a characteristic of increasing the conductivity when the content ratio of the burned material of the plant against rubber is set to 200 [phr] or above, which is just like the case of the burned material of soybean hulls.

Regarding only to the respective burned materials of soybean hulls, rapeseed meal, sesame meal and cotton seed meal and cotton hulls, when the content ratio of the burned plant material against rubber is set to 200 [phr] or above, it is found that the surface resistivity significantly decreases in all cases in contrast to the case that said content ratio is set to 150 [phr] or below. In addition, when said content ratio is 200 [phr] or above, each specific volume resistivity significantly decreases in contrast to the case that said content ratio is set to 150 [phr] or below.

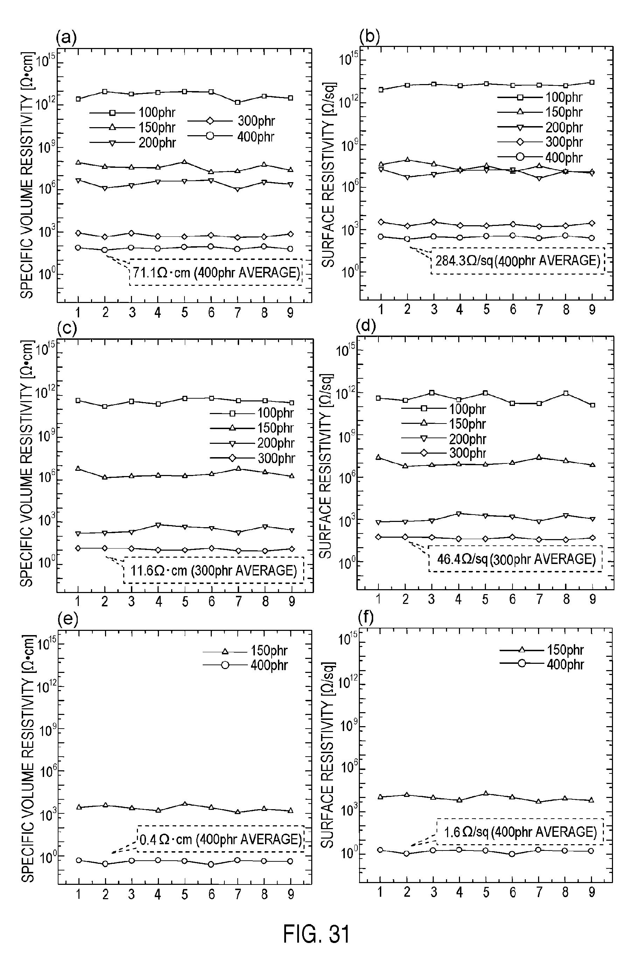

Fig. 31(a) - Fig. 31(f) show a chart indicating the measurement results of the specific volume resistivity and surface resistivity of the heat conducting member of this embodiment, and each of these corresponds to Fig. 9(c). The median diameter of the burned material of soybean hulls was set to 60 $\mu$m.

In Fig. 31(a), Fig. 31(c) and Fig. 31(e), the lateral axis and vertical axis respectively represent the measurement point in the heat conducting member and the specific volume resistivity [$\Omega\cdot$cm]. In Fig. 31(b), Fig. 31(d) and Fig. 31(f), the lateral axis and vertical axis respectively represent the measurement point in the heat conducting member and the surface resistivity [$\Omega$/sq].

Fig. 31(a) and Fig. 31(b) respectively show a chart of the specific volume resistivity and surface resistivity of the heat conducting member according to soybean hulls of the pulverized burned material at the burning temperature of 900 [°C], and Fig. 31(c) and Fig. 31(d) respectively show a chart of the specific volume resistivity and surface resistivity of the heat conducting member according to soybean hulls at the burning temperature for soybean hulls of 1500 [°C], and Fig. 31(e) and Fig. 31(f) respectively show a chart of the specific volume resistivity and surface resistivity of the heat conducting member according to soybean hulls at the burning temperature for soybean hulls of 3000 [°C].

First, as the charts are compared with each other, it is found that both specific volume resistivity and surface resistivity decrease as the burning temperature increases as described above. In addition, as the measurement results are compared with each other, it is also found that both specific volume resistivity and surface resistivity decrease not only as the burning temperature increases but also as the content ratio of the burned material of soybean hulls against rubber increases.

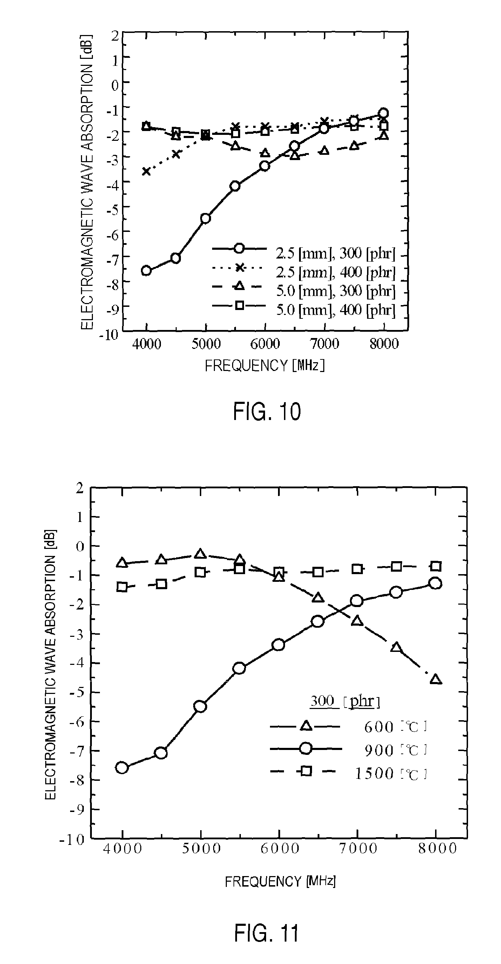

Fig. 10 - Fig. 12 show a chart indicting the electromagnetic wave absorption characteristics of the "heat conducting member". The lateral axis and vertical axis of Fig 10 etc. respectively represent frequency [MHz] and electromagnetic wave absorption [dB]. For calculating the electromagnetic wave absorption characteristics shown in Fig. 10 etc., the heat conducting member with a size of 300 [mm] x 300 [mm] was mounted on a metallic plate with the same size, and said mixture was irradiated with incident waves at frequencies plotted in Fig. 10 etc. so as to measure the energy of the reflected waves from the heat conducting member, thus the energy difference between the incident wave and the reflected wave, that is, the electromagnetic wave absorption (energy loss) was calculated. Said measurement was carried out based on the arch test method by using an arch type electromagnetic wave absorption measuring apparatus.

Here, Samples 1 - 4 with the following conditions were prepared. The prepared samples were as follows:

Sample 1: Thickness of the heat conducting member of 2.5 [mm], Content ratio of the burned material of soybean hulls against rubber of 300 [phr]
Sample 2: Thickness of the heat conducting member of 2.5 [mm], Content ratio of the burned material of soybean hulls against rubber of 400 [phr]
Sample 3: Thickness of the heat conducting member of 5.0 [mm], Content ratio of the burned material of soybean hulls against rubber of 300 [phr]
Sample 4: Thickness of the heat conducting member of 5.0 [mm], Content ratio of the burned material of soybean hulls against rubber of 400 [phr]

All of Samples 1 - 4 were prepared under the following conditions:

Burning temperature for soybean hulls to obtain heat conducting material: 900 [°C]
Median diameter of the burned material of soybean hulls: 60 $\mu$m

According to Fig. 10, it is found that Samples 1, 2 having a less thick heat conducting member (plotted with O, (in the figure) show a relatively higher electromagnetic wave absorption around the frequency band of 4000 [MHz] to 6000 [MHz], and show a relatively lower electromagnetic wave absorption around the frequency band of 6000 [MHz] to 8000 [MHz]. In contrast, it is found that Samples 3, 4 having a thick heat conducting member (plotted with (, ( in the figure) show less fluctuations in the electromagnetic wave absorption and also show a relatively lower electromagnetic wave absorption in the frequency band of 4000 [MHz] to 8000 [MHz].

In addition, it is found that Samples 2, 4 having a higher content ratio of the burned material of soybean hulls against rubber (plotted with (, (in the figure) shows a less electromagnetic wave absorption than Samples 1, 3 having a lower content ratio of the burned material of soybean hulls against rubber (plotted with (, (in the figure) do.

Regarding Fig. 11, the following Samples 5 - 7 were prepared. The prepared samples were as follows:

Sample 5: Burning temperature for soybean hulls to obtain heat conducting material: 600 [°C]
Sample 6: Burning temperature for soybean hulls to obtain heat conducting material: 900 [°C] (Sample 1)
Sample 7: Burning temperature for soybean hulls to obtain heat conducting material: 1500 [°C]

All of Samples 5 - 7 were prepared under the following conditions:

Median diameter of the burned material of soybean hulls: 60 $\mu$m
Thickness of heat conducting member: 2.5 [mm]
Content ratio of the burned material of soybean hulls against rubber: 300 [phr]

According to Fig. 11, the electromagnetic wave absorption regarding Sample 7 (plotted with D in the figure) is almost constant regardless of the frequency band, however, it can be said that the electromagnetic wave absorption in the lower frequencies is more than that in the higher frequencies.

In contrast, it is found that Sample 5 (plotted with A in the figure) increases the electromagnetic wave absorption as the frequency increases. In contrast, it is found that Sample 6 (plotted with O in the figure) reduces the electromagnetic wave absorption as the frequency increases.

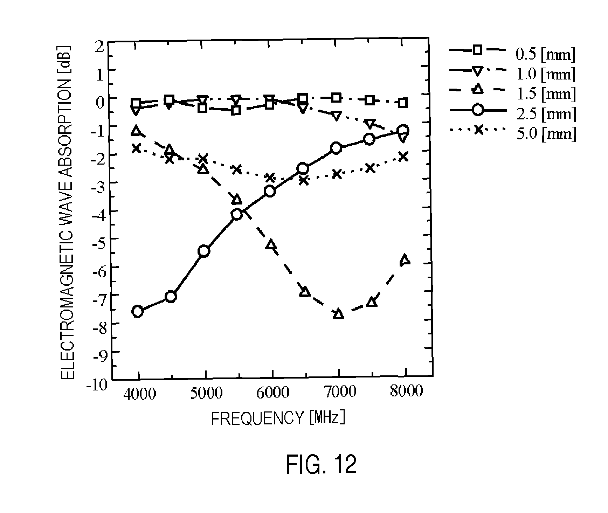

Regarding Fig. 12, the follows Samples 8 - 12 were prepared. The prepared samples were as follows:

Sample 8: Thickness of heat conducting member: 0.5 [mm]
Sample 9: Thickness of heat conducting member: 1.0 [mm]
Sample 10: Thickness of heat conducting member: 1.5 [mm]
Sample 11: Thickness of heat conducting member: 2.0 [mm] (Sample 4)
Sample 12: Thickness of heat conducting member: 5.0 [mm] (Sample 3)

All of Samples 8 - 12 were prepared under the following conditions:

Burning temperature for soybean hulls to obtain heat conducting material: 900 [°C]
Median diameter of the burned material of soybean hulls: 60 $\mu$m
Content ratio of the burned material of soybean hulls against rubber: 300 [phr]

According to Fig. 12, the electromagnetic wave absorption regarding Samples 8, 9, 12 (plotted with □, ∇, ×) is almost constant generally regardless of the frequency band. However, the electromagnetic wave absorption of Sample 12 (plotted with × in the figure) is more than that of Samples 8, 9 (plotted with D, V in the figure). In contrast, Sample 10, 11 (plotted with △, O in the figure) show a change in the electromagnetic wave absorption depending on high or low of the frequency.

Fig. 13 - Fig. 14 show a chart indicting the electromagnetic wave absorption characteristics of the "heat conducting member". The lateral axis and vertical axis of Fig 13 etc. respectively represent frequency [MHz] and electromagnetic wave absorption [dB]. Furthermore, Fig. 13 also shows an enlarged view for the frequency band up to 500 [MHz].

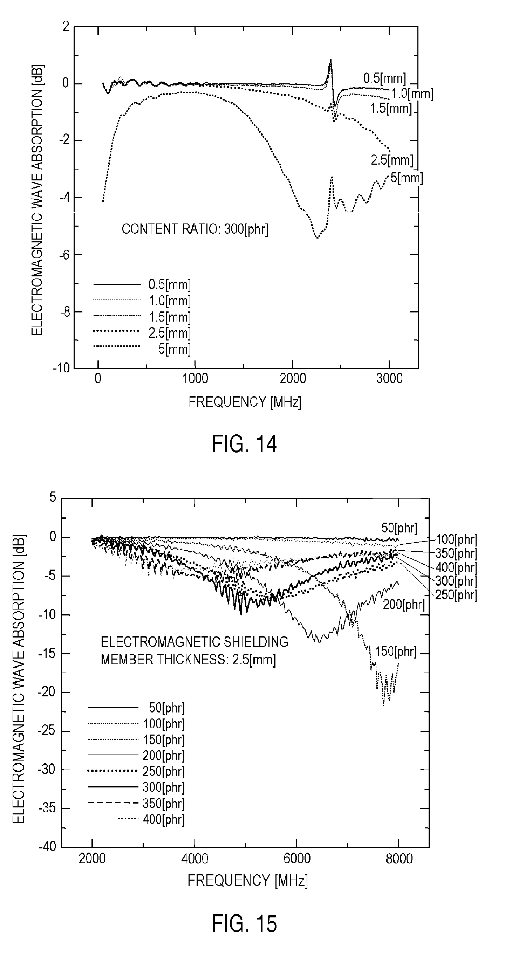

The electromagnetic wave absorption characteristics shown in Fig. 13 and Fig. 14 were measured by so-called S-parameter method. Specifically, a toroidal-shaped heat conducting member with an outer diameter of approx. 20Φ and inner diameter of 8.7Φ was mounted on the bottom of a cylindrical test container with an inner diameter of approx. 20Φ, and said mixture was irradiated from the opening end of the test container with incident waves at frequencies plotted in Fig. 13 and Fig. 14 so as to measure the energy of the reflected waves from said mixture, thus the electromagnetic wave absorption was calculated. For the heat conducting member, the content ratio of the burned material of soybean hulls against rubber has been changed from 0 [phr] to 400 [phr] with an increment of 50 [phr]. In all cases, the burning temperature for soybean hulls was set to 900 [°C], and the median diameter of the burned material of soybean hulls was set to 60 $\mu$m.

According to Fig. 13, the electromagnetic wave absorption is approx. 0 [dB] with little fluctuations around 500 [MHz] - 2300 [MHz] regardless of high or low of the content ratio of the burned material of soybean hulls. The fluctuations seen from 2300 [MHz] to 2400 [MHz] are caused by noises during the measurement. In contrast, in the range of 2400 [MHz] and above, when the content ratio of the burned material of soybean hulls is 150 [phr] or below, the electromagnetic wave absorption is approx. 0 [dB] with little fluctuations, and when the content ratio of the burned material of soybean hulls is 200 [phr] or above, the electromagnetic wave absorption increases to some extent.

According to the enlarged view of Fig. 13, at around 50 [MHz], when the content ratio of the burned material of soybean hulls is 150 [phr] and 400 [phr], the electromagnetic wave absorption is found to be -3 [dB] and -6 [dB] respectively, however, at other content ratios, the electromagnetic wave absorption stays within -1.0 [dB] even though it shows more fluctuations.

Here, paying attention to the burned material of soybean hulls with the content ratio of 400 [phr], the electromagnetic wave absorber of this embodiment has an electromagnetic wave shielding effect of 40 [dB] at the frequency band of around 50 [MHz] as shown in Fig. 2, while having an electromagnetic wave absorption of -6 [dB] as shown in Fig. 13, and thus it is considered to be causing a reflection of 34 [dB]. In addition, based on the chart shown in Fig. 13, it is preferred to be used as an electromagnetic wave reflector in the frequency band of 50 [MHz] - 100 [MHz].

Fig. 14 shows a relationship between frequency and electromagnetic wave absorption, wherein the thickness of the heat conducting member is changed from 0.5 [mm] to 5.0 [mm] with an increment of 0.5 [mm]. Here, the content ratio of the burned material of soybean hulls was set to 300 [phr].

According to Fig. 14, except for the cases that the thickness of the heat conducting member has been set to 2.5 [mm] and 5.0 [mm], it is found that the results of the electromagnetic wave absorptions are approximately similar to each other. That means, when the thickness of the heat conducting member is 0.5 [mm] - 1.5 [mm], the electromagnetic wave absorption is approx. 0 [dB] with little fluctuations around 500 [MHz] - 2300 [MHz]. Although there is some difference based on the different thickness of the heat conducting member, the electromagnetic wave absorption increases to some extent from 2400 [MHz] and above, while the electromagnetic wave absorption stays within -1.0 [dB] from 500 [MHz] and below even though it shows more fluctuations. The fluctuations seen from 2300 [MHz] to 2400 [MHz] are caused by noises.

In contrast, when the thickness of the heat conducting member is 5.0 [mm], the electromagnetic wave absorption is relatively high at any point in the frequency band up to 3000 [MHz]. In addition, when the thickness of the heat conducting member is 2.5 [mm], the electromagnetic wave absorption increases around over 1200 [MHz].

Here, according to this test result, the electromagnetic wave absorption with the thickness of the heat conducting member of 2.5 [mm] is somewhat different from the one with the thickness of the heat conducting member of 5.0 [mm] in the frequency band of 2400 [MHz] and above.

However, it is worth noting that when the thickness of the heat conducting member is 5.0 [mm], the absorption characteristic of about -4 [dB] has been obtained at the frequency of 50 [MHz] and the absorption characteristic of about maximum -5 [dB] has been obtained in the frequency band of 2000 [MHz] - 2500 [MHz].

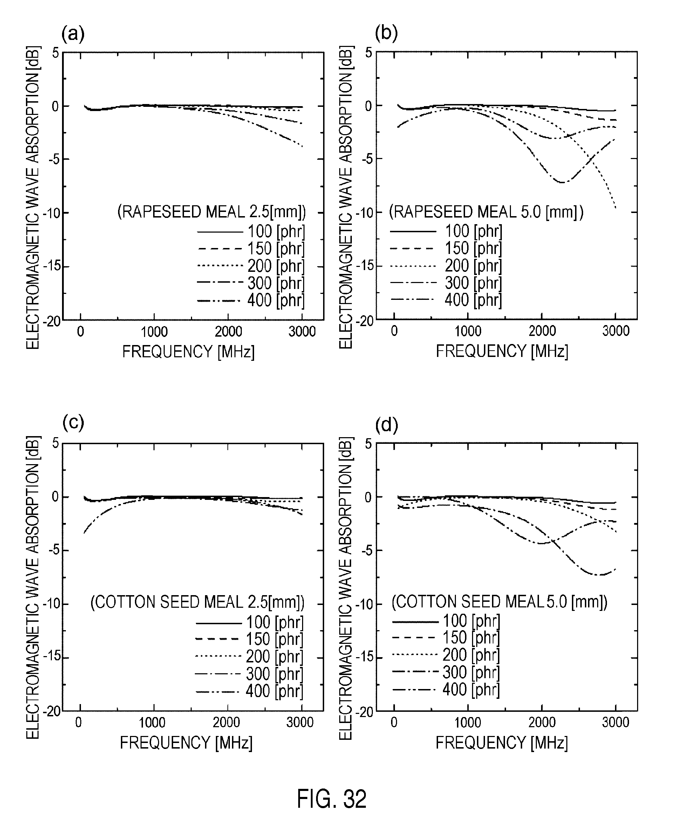

Fig. 32(a) - Fig. 32(h) show a chart indicating the electromagnetic wave absorption characteristics of the heat conducting members formed from the burned material of rapeseed meal, sesame meal, cotton seed meal and cotton hulls respectively. In Fig. 32(a) - Fig. 32(h), the lateral axis and vertical axis indicate frequency [MHz] and electromagnetic wave absorption [dB] respectively. Here, the thickness of the heat conducting member was set to 2.5 [mm] and 5.0 [mm], and the content ratio of the burned material of rapeseed meal etc. against rubber was changed.

Fig. 32(a) shows electromagnetic wave absorption characteristics of the heat conducting member with a thickness of 2.5 [mm], wherein the burned material of rapeseed meal was burned at a burning temperature of 900 [°C], and Fig. 32(b) shows electromagnetic wave absorption characteristics of the heat conducting member with a thickness of 5.0 [mm], wherein the burned material of rapeseed meal was burned at a burning temperature of 900 [°C].

Fig. 32(c) shows electromagnetic wave absorption characteristics of the heat conducting member with a thickness of 2.5 [mm], wherein the burned material of cotton seed meal was burned at a burning temperature of 900 [°C], and Fig. 32(d) shows electromagnetic wave absorption characteristics of the heat conducting member with a thickness of 5.0 [mm], wherein the burned material of cotton seed meal was burned at a burning temperature of 900 [°C].

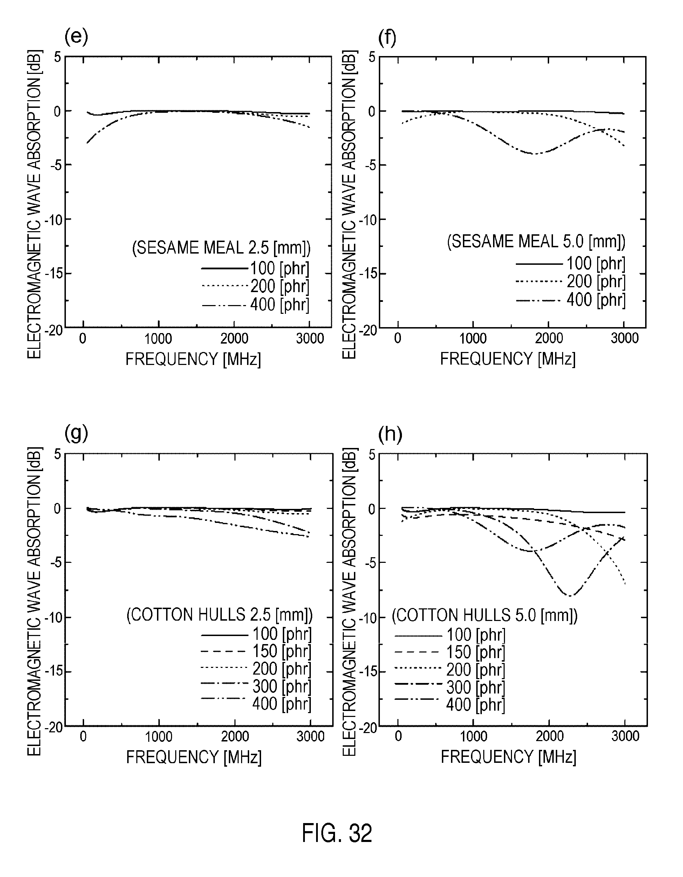

Fig. 32(e) shows electromagnetic wave absorption characteristics of the heat conducting member with a thickness of 2.5 [mm], wherein the burned material of sesame meal was burned at a burning temperature of 900 [°C], and Fig. 32(f) shows electromagnetic wave absorption characteristics of the heat conducting member with a thickness of 5.0 [mm], wherein the burned material of sesame meal was burned at a burning temperature of 900 [°C].

Fig. 32(g) shows electromagnetic wave absorption characteristics of the heat conducting member with a thickness of 2.5 [mm], wherein the burned material of cotton hulls was burned at a burning temperature of 900 [°C], and Fig. 32(h) shows electromagnetic wave absorption characteristics of the heat conducting member with a thickness of 5.0 [mm], wherein the burned material of cotton hulls was burned at a burning temperature of 900 [°C].

Whenever the burned material of any one of plants such as rapeseed meal is used, when the thickness of the heat conducting member is 2.5 [mm], the absorption characteristic of about maximum -5 [dB] has been obtained in the frequency band of 3000 [MHz] and below, and when 5.0 [mm], the absorption characteristic of about maximum -8 [dB] has been obtained.

Although it has not been determined (regarding sesame meal, we could not carry out a measurement for the case containing 300 [phr] of the burned material against rubber) it may be said that the burned material of any one of plants such as rapeseed meal has an effective frequency absorption characteristic in the frequency band of 2000 [MHz] - 3000 [MHz] when containing 300 [phr] against rubber.

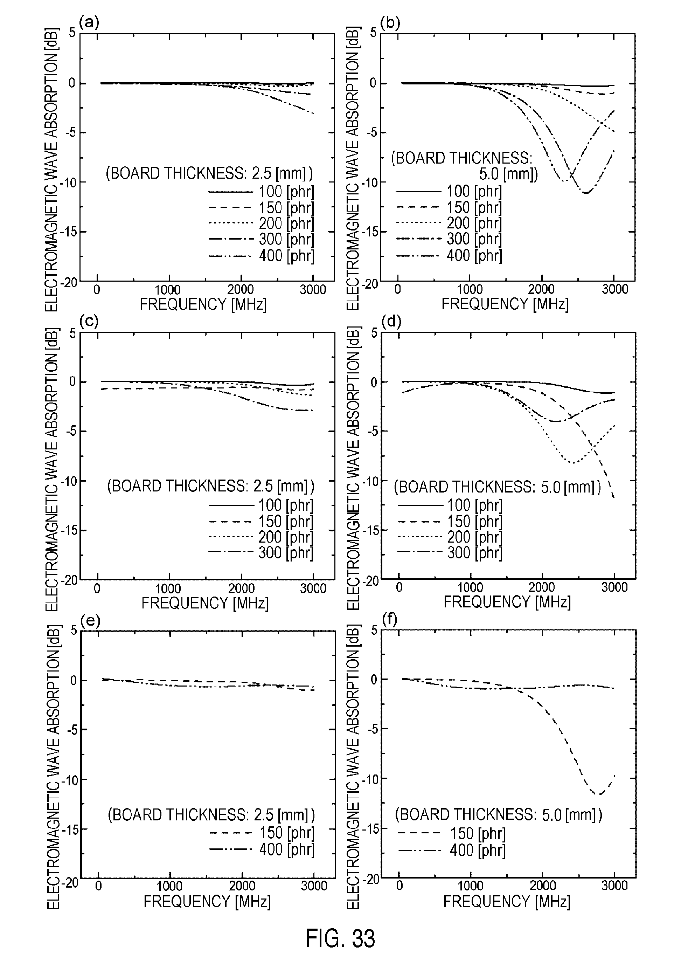

Fig. 33 shows a chart indicating the electromagnetic wave absorption characteristics regarding the burned material of soybean hulls, wherein the burning temperature etc. was changed, and it corresponds to Fig. 13. In Fig. 33 (a) - Fig. 33(f), the lateral axis and vertical axis indicate frequency [MHz] and electromagnetic wave absorption [dB] respectively. Here, the thickness of the heat conducting member was set to 2.5 [mm] and 5.0 [mm], and the measurement was carried out for both cases.

Fig. 33(a) shows electromagnetic wave absorption characteristics of the heat conducting member with a thickness of 2.5 [mm], wherein the burned material was burned at 900 [°C] and was then pulverized, and Fig. 33(b) shows electromagnetic wave absorption characteristics of the heat conducting member with a thickness of 5.0 [mm], wherein the burned material was burned at 900 [°C] and was then pulverized.

Fig. 33(c) shows electromagnetic wave absorption characteristics of the heat conducting member with a thickness of 2.5 [mm], wherein the burning temperature was at 1500 [°C], and Fig. 33(d) shows electromagnetic wave absorption characteristics of the heat conducting member with a thickness of 5.0 [mm], wherein the burning temperature was at 1500 [°C].

Fig. 33(e) shows electromagnetic wave absorption characteristics of the heat conducting member with a thickness of 2.5 [mm] according to soybean hulls, wherein the burning temperature was at 3000 [°C], and Fig. 33(f) shows electromagnetic wave absorption characteristics of the heat conducting member with a thickness of 5.0 [mm] according to soybean hulls, wherein the burning temperature was at 3000 [°C].

First, it was confirmed from all of the measurement results of Fig. 33(a) - Fig. 33(f) that the heat conducting member with a thickness of 5.0 [mm] has an electromagnetic wave absorption of about maximum 10 [dB] in the frequency band of 2000 [MHz] - 3000 [MHz], while such an electromagnetic wave absorption was not confirmed in the case of the heat conducting member with a thickness of 2.5 [mm].

In addition, as comparing Fig. 33(a) - Fig. 33(f) with each other, it was confirmed that the frequency band at which the maximum electromagnetic wave absorption can be obtained varies depending on the burning temperature for the burned material of soybean hulls to obtain the heat conducting material, the thickness of the heat conducting member, the content of the burned material of soybean hulls against rubber, and whether or not the burned material of soybean hulls has been pulverized.

Based on the above, in order to obtain an heat conducting material preferably used at, for example, around 2500 [MHz], it is understood that:

(1) the conditions may be the burning temperature for the burned material of soybean hulls of 1500 [°C], the thickness of the heat conducting member of 5 [mm], the content of the burned material of soybean hulls against rubber of 200 [phr], and not applying pulverization for the burned material of soybean hulls.

(2) the conditions may be the burning temperature for the burned material of soybean hulls of 900 [°C], the thickness of the heat conducting member of 5 [mm], the content of the burned material of soybean hulls against rubber of 300 [phr] - 400 [phr], and applying pulverization for the burned material of soybean hulls.

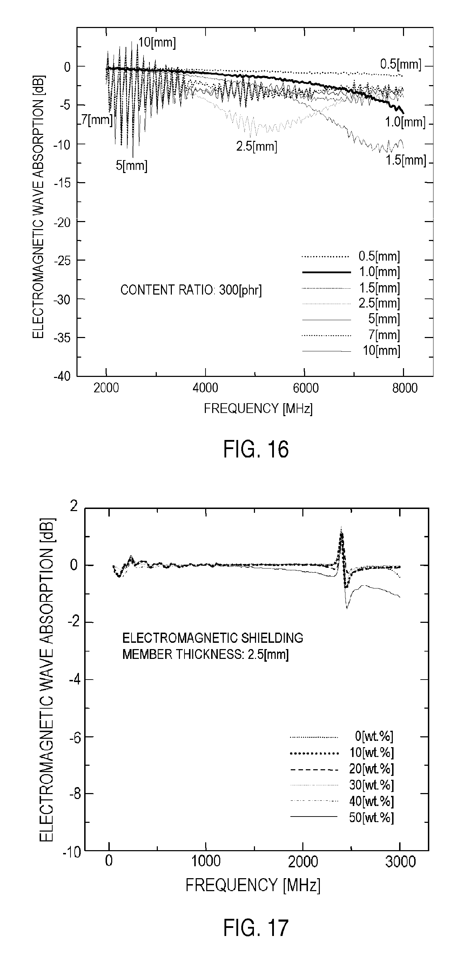

Fig. 15 and Fig. 16 show a chart indicating the relationship between frequency and electromagnetic wave absorption characteristics corresponding to Fig. 13 and Fig. 14. The electromagnetic wave absorption characteristics in the frequency band of 2000 [MHz] - 8000 [MHz] are indicated herein.

As shown in Fig. 15, paying attention to the minimum value of each chart, there seems to be association between the content ratio of the burned material of soybean hulls against ethylene propylene diene monomer rubber and the frequency band. That is, as the content ratio of the burned material of soybean hulls against ethylene propylene diene monomer rubber increases, the electromagnetic wave absorption range shifts to the lower frequency band.

In addition, there also seems to be association between the content ratio of the burned material of soybean hulls against ethylene propylene diene monomer rubber and the absorption itself. That is, as the content ratio of the burned material of soybean hulls against ethylene propylene diene monomer rubber increases, the electromagnetic wave absorption increases except for the cases that the content ratio of the burned material of soybean hulls against ethylene propylene diene monomer rubber is set to 50 [phr] and 100 [phr].

However, when the content ratio of the burned material of soybean hulls is 50 [phr] and 100 [phr] in the sample, the absorption characteristic cannot be obtained. In Fig. 15, it should be noted that when the content ratio of the burned material of soybean hulls was 150 [phr], the absorption characteristic of as much as -20 [dB] was obtained in the frequency band of 7 [GHz] - 8 [GHz].

As shown in Fig. 16, there seems to be association between the thickness of the heat conducting member and the frequency band. That is, as the thickness of the heat conducting member increases, the electromagnetic wave absorption range shifts to the lower frequency band.

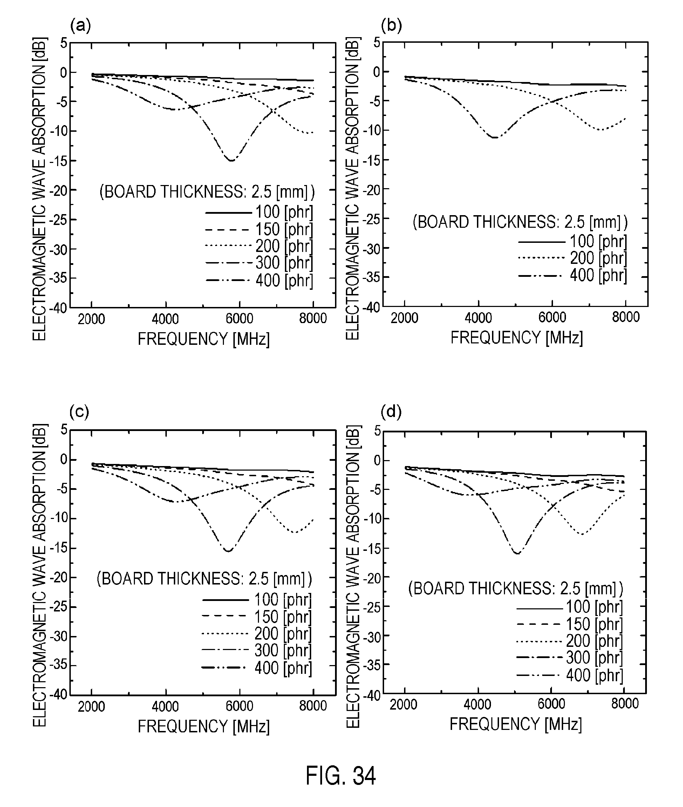

Fig. 34(a) - Fig. 34(d) show a chart indicating the electromagnetic wave absorption characteristics of the heat conducting members formed from the burned material of rapeseed meal, sesame meal, cotton seed meal and cotton hulls respectively, and these correspond to Fig. 15. In Fig. 34(a) - Fig. 34(d), the lateral axis and vertical axis indicate frequency [Hz] and electromagnetic wave absorption [dB] respectively. Here, the burning temperature for rapeseeds etc. was set to 900 °C, the thickness of the heat conducting member was set to 2.5 [mm], and the content ratio of the burned material of rapeseed meal etc. against rubber was changed.

Fig. 34(a) shows electromagnetic wave absorption characteristics of the heat conducting member formed from the burned material of rapeseed meal. Fig. 34(b) shows electromagnetic wave absorption characteristics of the heat conducting member formed from the burned material of sesame meal. Fig. 34(c) shows electromagnetic wave absorption characteristics of the heat conducting member formed from the burned material of cotton seed meal. Fig. 34(d) shows electromagnetic wave absorption characteristics of the heat conducting member formed from the burned material of cotton hulls.

First, looking at Fig. 34(a) - Fig. 34(d), it is found that the maximum value of the electromagnetic wave absorption in each burned material of rapeseed meal etc. is about -15 [dB] in the frequency band of 2000 [MHz] - 6000 [MHz].

Although it has not been determined (regarding the cotton seed meal shown in Fig. 34(c), we could not carry out a measurement for the case containing 300 [phr] of the burned material against rubber) it may be said that the burned material of any one of plants such as rapeseed meal has an effective frequency absorption characteristic in the frequency band of 2000 [MHz] - 8000 [MHz] when containing 300 [phr] against rubber. The result indicated that the frequency with the maximum electromagnetic wave absorption was around 4000 [MHz] - 6000 [MHz].

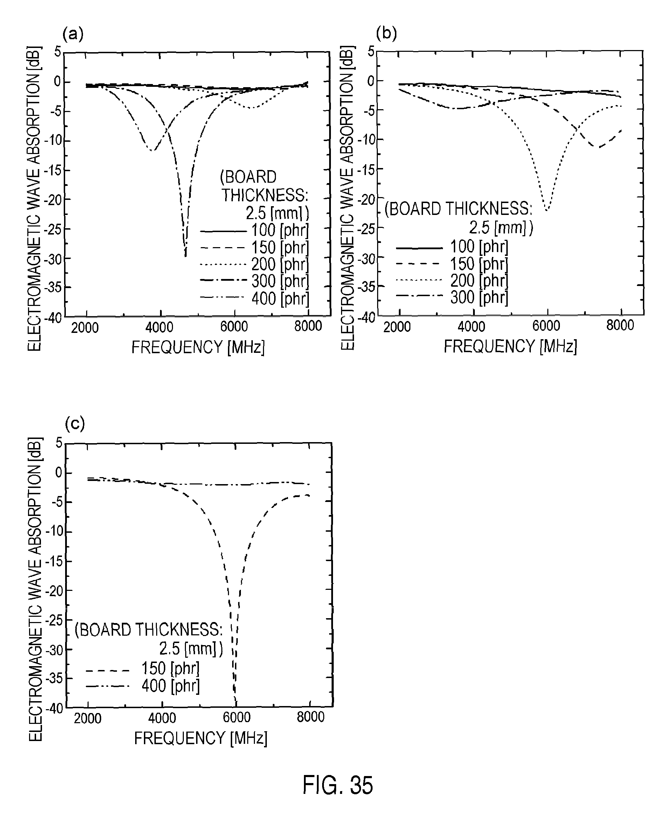

Fig. 35 shows a chart indicating the electromagnetic wave absorption characteristics regarding the burned material of soybean hulls, wherein the burning temperature etc. was changed, and it corresponds to Fig. 15. In Fig. 35 (a) - Fig. 35(c), the lateral axis and vertical axis indicate frequency [MHz] and electromagnetic wave absorption [dB] respectively. Here, the thickness of the heat conducting member was set to 2.5 [mm].

Fig. 35(a) shows electromagnetic wave absorption characteristics of the burned material of soybean hulls that was burned at a burning temperature of 900 [°C] and was then pulverized. Fig. 35(b) shows electromagnetic wave absorption characteristics of the burned material of soybean hulls that was burned at a burning temperature of 1500 [°C] and was not pulverized. Fig. 35(c) shows electromagnetic wave absorption characteristics of the burned material of soybean hulls that was burned at a burning temperature of 3000 [°C] and was not pulverized.

In contrast to the case of rapeseed meal etc. shown in Fig. 34, it is confirmed that the burned material of soybean hulls has a strong electromagnetic absorption characteristic of 20 [dB] and above regardless of the burning temperature. In addition, according to these measurement results, it can be said that there is a poor correlation between the maximum value of the electromagnetic wave absorption, the burning temperature for soybean hulls, and the content of the burned material of soybean hulls against rubber.

For example, large electromagnetic wave absorption was obtained at the content of 300 [phr] in the case of the burning temperature of 900 [°C] as shown in Fig. 35(a), at the content of 200 [phr] in the case of the burning temperature of 1500 [°C] as shown in Fig. 35(b) and at the content of 150 [phr] in the case of the burning temperature of 3000 [°C] as shown in Fig. 35(c).

From Fig. 35(a), an electromagnetic shielding effectiveness of 20 [dB] and above is confirmed in the frequency band of approx. 4200 [MHz] to approx. 4400 [MHz]. Furthermore, from Fig. 35(b) and Fig. 35(c), an electromagnetic shielding effectiveness of 20 [dB] and above is confirmed in the frequency band of approx. 6000 [MHz]. In particular, the maximum of nearly 40 [dB] of electromagnetic shielding effectiveness is confirmed in Fig. 35(c).

Fig. 17 and Fig. 18 show a chart indicating the relationship between frequency and electromagnetic wave absorption in the case that low density polyethylene is used for the base material to be blended with the burned material of soybean hulls, instead of using ethylene propylene diene monomer rubber. Fig. 17 shows a chart, wherein the burning temperature for soybean hulls was 900 [°C], the median diameter was approx. 60 $\mu$m, the thickness of the heat conducting member was 2.5 [mm], and the content ratio of the burned material of soybean hulls against low density polyethylene was changed from 0 to 50 [wt.%] with an increment of 10 [wt.%].

According to Fig. 17, the electromagnetic wave absorption is approx. 0 [dB] with little fluctuations around 500 [MHz] - 2300 [MHz] regardless of the content ratio of the burned material of soybean hulls. The electromagnetic wave absorption can be evaluated as somewhat similar to the one shown in Fig. 13 in the frequency bands of 2300 [MHz] and above, and 500 [MHz] and below regardless of the content ratio of the burned material of soybean hulls.

Fig. 18 shows a chart, wherein the content ratio of the burned material of soybean hulls against low density polyethylene was chosen from 40 [wt.%] and 50 [wt.%], and the thickness of the heat conducting member was changed to 1, 2 and 3 [mm]. Also in the case of Fig. 18, the electromagnetic wave absorption can generally be evaluated as similar to the one shown in Fig. 17.

However, the electromagnetic wave absorption increases as the thickness of the heat conducting member increases, and as the content ratio of the burned material of soybean hulls against low density polyethylene increases. Therefore, when low density polyethylene is used as the base material, it is preferred to increase the content ratio itself of the burned material of soybean hulls in terms of the electromagnetic wave absorption.

What can be said from the charts shown in Fig. 17 and Fig. 18 is that a comparative electromagnetic absorption characteristic cannot be obtained since the content ratio of the burned material of soybean hulls against low density polyethylene cannot exceed the content ratio of the burned material of soybean hulls against ethylene propylene diene monomer rubber due to the structural and characteristic reasons of low density polyethylene. For reference, the content ratio of the burned material of soybean hulls against low density polyethylene is as much as a content ratio of about 50 [wt.%] (= the content ratio of the burned material of soybean hulls: 100 [phr]).

As explained above, it is observed that the heat conducting member of this embodiment not only has the anti-charge function and anti-static function, but also has a shielding function. In addition, these functions can be tailored to various applications by changing the production conditions for the burned plant material of soybean hulls etc.

In other words, the heat conducting member of this embodiment can be tailored to various applications by adjusting the content ratio of the burned material of soybean hulls against a base material, the median diameter of the burned material of soybean hulls, the burning temperature for obtaining the burned material of soybean hulls. Consequently, the heat conducting member of this embodiment can be used as, for example, conductive filler to the plastic and rubber used in electronic appliances.

Regarding the burned material of soybean hulls according to this embodiment, the following tests and measurements have been carried out. Here, regarding the burned material of soybean hulls, although those with the median diameter of approx. 30 $\mu$m and those with the median diameter of approx. 60 $\mu$m were used to carry out several tests and measurements, this range of differences in median diameter did not indicate any differences in the test results and measurement results.

(1) Regarding the burned material of soybean hulls according to this embodiment, the physical properties such as bulk specific gravity, BET specific surface area, and crystallite size were measured.

(2) Regarding the burned material of soybean hulls according to this embodiment, whether or not it can be blended with a base material other than ethylene propylene diene monomer rubber, and if possible to blend, the content ratio of said burned material against the rubber were measured.

First, the following measurement results were obtained regarding the physical properties.

Bulk specific gravity: approx. 0.2 g/ml to approx. 0.6 g/ ml
(maximum range: approx. 0.4 g/ ml)
BET specific surface area: approx. 4.7 m$^2$/g to approx. 390 m$^2$/g
Crystallite size: approx. 1 nm to approx. 20 nm

As comparing those burned at respective burning temperatures of 900 [°C], 1500 [°C] and 3000 [°C] with each other, it is found that the BET specific surface area varies depending on the burning temperature.

For example, JPA2005-336017 discloses a porous carbon material with a bulk specific gravity of 0.6 - 1.2 g/cm$^3$. When comparing the above measurement results with those in this publication, the burned material of soybean hulls according to this embodiment has a lower value in the bulk specific gravity. Here, the bulk specific gravity of the burned material of soybean hulls according to this embodiment has been measured in conformity to JIS K-1474.

JPA2007-191389 discloses carbonaceous or graphitic particles for electrodes of non-aqueous secondary battery that have a median diameter of 5 - 50 μm and a BET specific surface area of 25 m$^2$/g or below.

JPA2005-222933 discloses carbonaceous particles that have a crystallite size of over 100 nm as a negative-electrode material for lithium battery. When comparing the above measurement results with those in this publication, the burned material of soybean hulls according to this embodiment has a smaller crystallite size, and thus it is evaluated as low-crystalline carbon.

If it explains additionally, the bulk specific gravity of rapeseed meal, sesame meal, cotton seed meal, cotton hulls and cacao husk were approx. 0.6 g/ml to 0.9 g/ ml, approx. 0.7 g/ml to 0.9 g/ ml, approx. 0.6 g/ml to 0.9 g/ml, approx. 0.3 g/ml to 0.5 g/ ml, and approx. 0.3 g/ml to 0.5 g/ ml respectively. Therefore, the kinds of hulls (soybean hulls, cotton hulls and cacao husk) are a relatively bulky.

Next, the measurement results of whether or not being able to blend with a base material other than ethylene propylene diene monomer rubber, and if possible to blend, the content ratio of said burned material against the rubber were found as follows.

Here, No.191-TM TEST MIXING ROLL manufactured by Yasuda Seiki Seisakusho Ltd. was used as an open roll (biaxial kneading machine), and TOYO SEIKI mini TEST PRESS 10 was used as a molding process machine (compacting machine).

For comparison, in addition to the burned material of soybean hulls according to this embodiment, (1) coconut shell activated carbon (granular SHIRASAGI WH2C8/32SS Lot No. M957 manufactured by Japan EnviroChemicals. Ltd.), and (2) carbon black (SUNBLACK285, Lot No. 8BFS6 manufactured by ASAHI CARBON CO., LTD.) were used.

For the base material other than ethylene propylene diene monomer rubber, (a) isoprene (IR-2200 manufactured by Kraton JSR Elastomers K.K.), and (b) polyvinyl chloride resin (ZEST1000Z, Lot No. C60211 manufactured by Shin Daiichi Enbi K.K.) were used.

In addition, regarding coconut shell activated carbon and carbon black, whether or not it can be blended with ethylene propylene diene monomer rubber was also checked.

Blending the burned material of soybean hulls according to this embodiment with a base material was the same as explained above with reference to Fig. 2; and generally stated, when isoprene was used as the base material, it was masticated by the open roll preheated to approx. 90 [°C]. When PVC was used as the base material, it was masticated by the open roll preheated to approx. 185 [°C]. Then the burned material of soybean hulls according to this embodiment and others were respectively blended with the base material. This burned material of soybean hulls was the one burned at 900 [°C], and the median diameter was set to 30 μm.

Subsequently, the molding process machine was used to process molding for the base material that had been blended with the burned material of soybean hulls according to this embodiment or others under the pressure of 20 [MPa] for 5 minutes at the temperature of 100 [°C].

Hence, regarding the resultant products, the measurement results of whether or not being able to blend with the base material, and if possible to blend, the content ratio of said burned material against the rubber were found as follows.

1. Regarding the burned material of soybean hulls according to this embodiment,

(1) In the case that isoprene was used as the base material, the content ratio was found to be as much as approx. 600 [phr].

(2) In the case that polyvinyl chloride resin was used as the base material, the content ratio was found to be as much as approx. 350 [phr].

2. Regarding coconut shell activated carbon,

(1) In the case that isoprene was used as the base material, the content ratio was found to be approx. 150 [phr]. However, it was not possible to knead in to 200 [phr] or more.

(2) In the case that ethylene propylene diene monomer rubber was used as the base material, the content ratio was found to be approx. 150 [phr]. However, in this case, when this compressed compact was curved, it caused a crack. Moreover, it was not possible to knead in to 200 [phr] or more.

3. Regarding carbon black,

(1) In the case that isoprene was used as the base material, the content ratio was found to be approx. 100 [phr]. However, in this case, when this compressed compact was curved, it caused a crack. Moreover, it was not possible to knead in to 150 [phr] or more.

(2) In the case that ethylene propylene diene monomer rubber was used as the base material, the content ratio was found to be approx. 100 [phr]. However, in this case, when this compressed compact was curved, it caused a crack. Moreover, it was not possible to knead in to 150 [phr] or more.

As a summary, in contrast to the burned material of soybean hulls according to this embodiment, even though "coconut shell activated carbon" that is in common in terms of being plant-derived carbide and being porous structure was used, a large amount of blending with the base material such as the one obtained by the burned material of soybean hulls according to this embodiment was not recognized. So any one of the burning temperature for the burned material of soybean hulls according to this embodiment, the carbon content attributable thereto, and a lager number of reactive functional residues is possibly contributing to the increased content ratio against the base material.

In the case of petroleum-pitch-derived carbon black, it was found that not only containing the amount of 100 [phr] for ethylene propylene diene monomer rubber causes a reduced flexibility, but also containing the amount of 100 [phr] for isoprene causes a reduced flexibility.

It was confirmed that the burned material of soybean hulls according to this embodiment was able to be blended with a base material even if silicon rubber was used as the base material. When reproducibility tests were selectively carried out for various test results etc. explained in this embodiment, it was confirmed that all of them were reproducible. In addition, the burned material of soybean hulls according to this embodiment may be blended with not only rubber but also paint, cement, etc. as a base material. Therefore, for example, the burned material of soybean hulls may be used as a paint containing a heat conducting member for a roof material etc., or also may be used as cement containing a heat conducting member at the time of construction of collective housing.

Furthermore, each test was selectively carried out by setting the median diameter of the burned material of soybean hulls according to this embodiment to 30 $\mu$m. As explained with reference to Fig. 8, when the median diameter was changed to 60 $\mu$m, 10 $\mu$m and 2 $\mu$m, there seems to be differences in the specific volume resistivity, however, no significant difference was observed between the median diameters of 60 $\mu$m and 30 $\mu$m. Yet another, no significant difference was observed in the "surface resistivity" between the median diameters of 60 $\mu$m and 30 $\mu$m.

Next, the heat conducting members formed from the burned material of cacao husk (heat conducting material) is descrived. In addition, the various following measurements were carried out under similar conditions to those for the burned material of raw soybean hulls and soybean hulls, etc. as stated above.

First, according to the component analysis (organic micro-elemental analysis method) for raw cacao husk, the carbon component, hydrogen component and nitrogen component were approx. 43.60%, approx. 6.02% and approx. 2.78% respectively. In contrast, according to the component analysis (organic micro-elemental analysis method) for burned material of cacao husk, the carbon component, hydrogen component and nitrogen component were approx. 65.57%, approx. 1.12% and approx. 1.93% respectively. In addition, the volume specific resistivity of the burned material of cacao husk was 0.0406 $\Omega \cdot$cm.

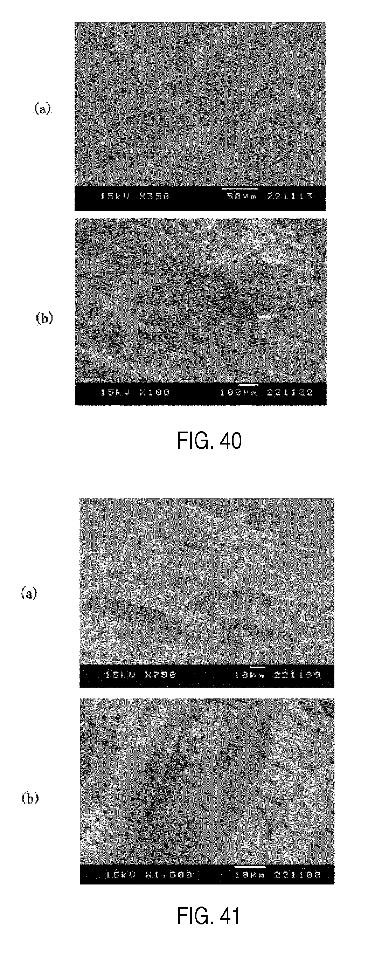

Fig. 40 and Fig. 41 show SEM pictures of raw cacao husk. Fig. 40(a), Fig. 40(b), Fig. 41(a), and Fig. 41(b) respectively show a picture of the outer skin taken at 350-fold magnification, a picture of the inner skin taken at 100-fold magnification, a picture of the inner skin taken at 750-fold magnification, and a picture of the inner skin taken at 1500-fold magnification.

As shown in Fig. 40(a), the outer skin of raw cacao husk is a form like the surface of a limestone. In contrast, as shown in Fig. 40(b), the inner skin of raw cacao husk is a form like the fibrous.

Interestingly, as shown in Fig. 41(a) and Fig. 41(b), the inner skin of raw cacao husk is a form like the spiral when the fibrous part is expanded. In addition, the diameter of spiral portion is visible to 10 $\mu$m - 20 $\mu$m in general.

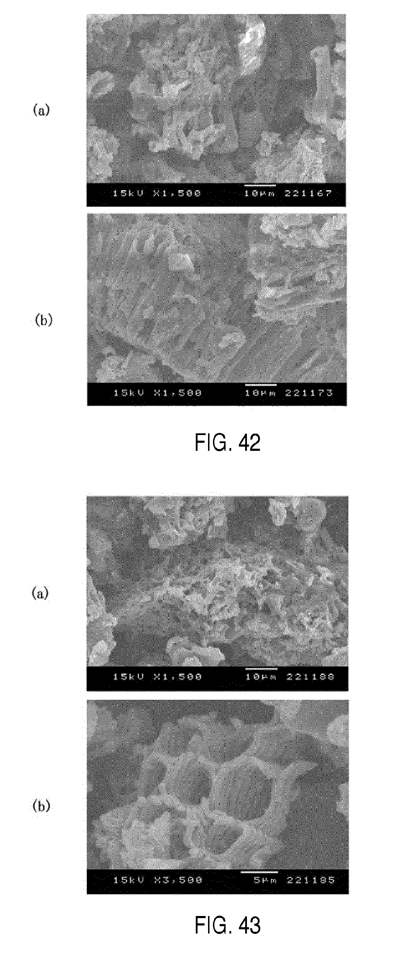

Fig. 42 and Fig. 43 show SEM pictures of cacao husk burned without distinguishing by the inner skin and the outer skin. Fig. 42(a), Fig. 42(b), and Fig. 43(a) respectively show a picture of the burned material taken at 1500-fold magnification, and Fig. 43(b) shows a picture of the burned material taken at 3500-fold magnification.

From Fig. 42(a) and Fig. 43(b), it is confirmed that a form like the fibrous looked at the inner skin of raw cacao husk is remaining also in the burned material of cacao husk. In addition, as for the size of the burned material, the diameter of spiral portion seems to be shrunk to approximately 5 $\mu$m-10 $\mu$m. Moreover, from Fig. 42(b) and Fig. 43(a), it is confirmed that the burned material of cacao husk is a variegated porous structure.

A form like the spiral is not confirmed in soybean hulls, rapeseed meal, sesame meal, cotton seed meal, cotton hulls and soybean chaffs as stated above. Therefore, such a form has a high possibility of being peculiar to a cacao husk.

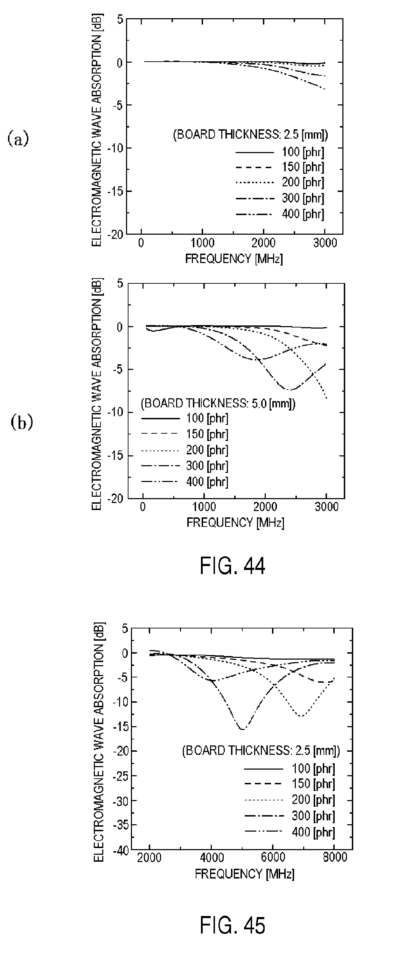

Fig. 44 shows a chart indicating the electromagnetic wave absorption characteristics of the heat conducting members formed from the burned material of cacao husk, and it corresponds to that shown in Fig. 32. Fig. 45 shows a chart indicating the electromagnetic wave absorption characteristics of the heat conducting members formed from the burned material of cacao husk, and it corresponds to that shown in Fig. 34.

In Fig. 44(a), Fig. 44(b) and Fig. 45, the lateral axis and vertical axis indicate frequency [MHz] and electromagnetic wave absorption [dB] respectively. In terms of comparison with Figure 44, Figure 45 and Figure 32, Figure 44, the electromagnetic wave absorption characteristics regarding the cacao husk seems to be similar to the electromagnetic wave absorption characteristics regarding the cotton hulls.

Next, the measurement result of thermal conductivity of the heat conducting member of this embodiment is explained. Thermal conductivity measurement was performed under the temperature of 25 °C to each sample mentioned later. The measuring method of thermal conductivity was made into the hot wire method, and was carried out in accordance with JIS standard R2616.

the measurement of thermal conductivity of a sample was carried out in the state where eight heat conducting members of size with 100mm (length) x 50mm (width) x 2.5mm (thickness) were made to laminate (2.0mm (thickness) x 10 laminations was adopted only for the measurement of sample A and for the measurement of 150phr regarding sample D). Moreover, the quick thermal conductivity meter QTM-500 (manufactured by Kyoto Electronics Manufacturing Co., Ltd.) was used as measuring device. And, the measurement of thermal conductivity was carried out on the accuracy conditions from which the numerical value of less than ±5% of the thermal conductivity standard value of standard sample mentioned later is acquired.

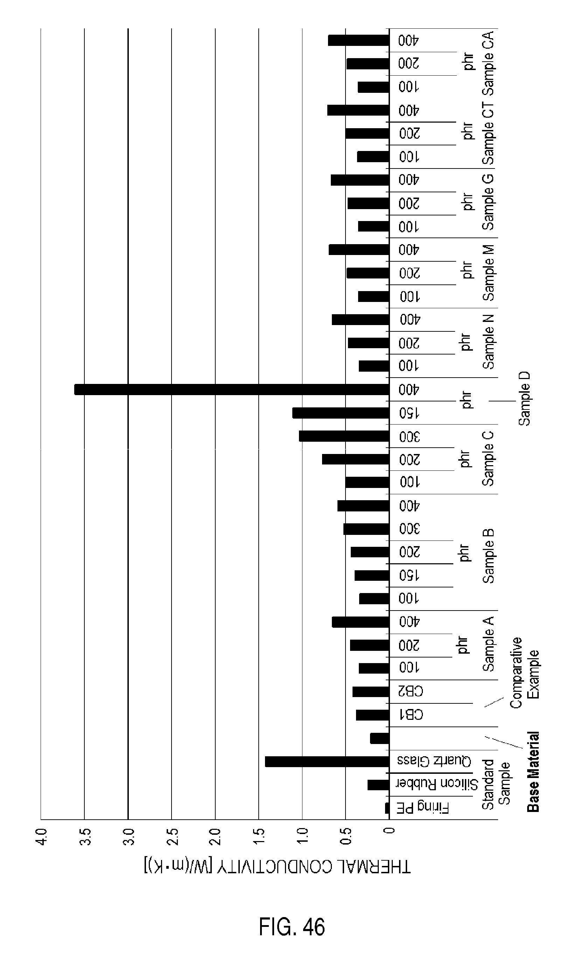

Fig. 46 shows a chart indicating the measurement result of thermal conductivity of the heat conducting member of this embodiment. Fig. 46 shows the thermal conductivities in the case that various samples described below and, as a comparative example, two kinds of arbitrary carbon black (CB1, 2) which is circulating in the market were contained a predetermined amount against the base material (ethylene propylene diene monomer rubber). In addition, Fig. 46, for reference, also shows the thermal conductivities of firing polyethylene (PE), silicon rubber, and quartz glass as a standard samples. 2.0mm (thickness) x 10 laminations was adopted for CB2.

First, the thermal conductivities of standard samples were the firing polyethylene (PE), silicon rubber, and quartz glass of respectively 0.036 [W/(m · K)], 0.238 [W/(m · K)], and 1.42 [W/(m · K)].

The thermal conductivities of carbon black (CB1, 2) were 0.377 [W/(m · K)] and 0.418 [W/(m · K)] respectively. The content ratios of the carbon black (CB1, 2) against the base material were 100 phr respectively. In addition, the thermal conductivity of base material was slightly 0.211 [W/(m · K)].

Sample A is a heat conducting member which burned the soybean hulls at the temperature of approx. 900 °C, and is not pulverized. The heat conducting member uses the heat conducting material which has approx. 30 μm median diameters. The thermal conductivities in the case that the content ratios of Sample A against the base material were 100 phr, 200 phr and 400 phr respectively were 0.342 [W/(m · K)], 0.446 [W/(m · K)] and 0.651 [W/(m · K)] respectively.

Sample B is a heat conducting member which burned the soybean hulls at the temperature of approx. 900 °C, and is pulverized. The heat conducting member uses the heat conducting material which has approx. 5 μm median diameters.. The thermal conductivities in the case that the content ratios of Sample B against the base material were 100 phr, 150 phr, 200 phr, 300 phr and 400 phr respectively were 0.334 [W/(m · K)], 0.391 [W/(m · K)], 0.436 [W/(m · K)], 0.518 [W/(m · K)] and 0.587 [W/(m · K)] respectively.

Sample C is a heat conducting member which burned the soybean hulls at the temperature of approx. 1500 °C, and is not pulverized. The heat conducting member uses the heat conducting material which has approx. 30 μm median diameters. The thermal conductivities in the case that the content ratios of Sample C against the base material were 100 phr, 200 phr and 300 phr respectively were 0.498 [W/(m·K)], 0.769 [W/(m·K)] and 1.030 [W/(m·K)] respectively.

Sample D is a heat conducting member which burned the soybean hulls at the temperature of approx. 3000 °C, and is not pulverized. The heat conducting member uses the heat conducting material which has approx. 30 μm median diameters. The thermal conductivities in the case that the content ratios of Sample D against the base material were 150 phr and 400 phr respectively were 1.100 [W/(m · K)] and 3.610 [W/(m · K)] respectively.

Sample N is a heat conducting member which burned the rapeseed meal at the temperature of approx. 900 °C, and is not pulverized. The heat conducting member uses the heat conducting material which has approx. 48μ m median diameters. The thermal conductivities in the case that the content ratios of Sample N against the base material were 100 phr, 200 phr and 400 phr respectively were 0.344 [W/(m·K)], 0.460 [W/(m·K)] and 0.654 [W/(m·K)] respectively.

Sample M is a heat conducting member which burned the cotton seed meal at the temperature of approx. 900 °C, and is not pulverized. The heat conducting member uses the heat conducting material which has approx. 36 μm median diameters. The thermal conductivities in the case that the content ratios of Sample N against the base material were 100 phr, 200 phr and 400 phr respectively were 0.348 [W/(m·K)], 0.482 [W/(m·K)] and 0.683 [W/(m·K)] respectively.

Sample G is a heat conducting member which burned the sesame meal at the temperature of approx. 900 °C, and is not pulverized. The heat conducting member uses the heat conducting material which has approx. 61 μm median

diameters. The thermal conductivities in the case that the content ratios of Sample N against the base material were 100 phr, 200 phr and 400 phr respectively were 0.345 [W/(m · K)], 0.471 [W/(m · K)] and 0.665 [W/(m · K)] respectively.

Sample CT is a heat conducting member which burned the cotton hulls at the temperature of approx. 900 °C, and is not pulverized. The heat conducting member uses the heat conducting material which has approx. 34 µm median diameters. The thermal conductivities in the case that the content ratios of Sample CT against the base material were 100 phr, 200 phr and 400 phr respectively were 0.361 [W/(m · K)], 0.495 [W/(m · K)] and 0.705 [W/(m · K)] respectively.

Sample CA is a heat conducting member which burned the cacao husk at the temperature of approx. 900 °C, and is not pulverized. The heat conducting member uses the heat conducting material which has approx. 39 µm median diameters. The thermal conductivities in the case that the content ratios of Sample CA against the base material were 100 phr, 200 phr and 400 phr respectively were 0.355 [W/(m · K)], 0.483 [W/(m · K)] and 0.692 [W/(m · K)] respectively.

First, when comparing the thermal conductivity of base material and the thermal conductivity of each sample, it can be found that the thermal conductivity of each sample is high. Therefore, it can be found that containing the heat conducting material of this embodiment against the base material is better in respect of thermal conductivity rather than using only base material as a heat conducting member.

The thermal conductivity in the case that the content ratio of Sample A against the base material is 100 phr has no great difference compared to each of comparative examples. It seems due to the fact that the carbon content against the base material is close. In addition, although the thermal conductivity in the case that the content ratio of Sample A against the base material is 200 phr can be evaluated as slightly better compared to each of comparative examples, the significant increase cannot be confirmed. On the other hand, the thermal conductivity in the case that the content ratio of Sample A against the base material is 400 phr increased to more than 1.5 times compared to each of comparative examples.

Next, when the thermal conductivity of Sample A and the thermal conductivity of Sample N, M, G, CT, and CA are contrasted, it can be found that the same tendency is seen generally. That is, in the case that the content ratio of heat conducting material regarding each of these samples against the base material is same, it can be found that the thermal conductivity shows the same value. And, in the case that the content ratio of heat conducting material regarding each of these samples against the base material is increased, it can be found that the thermal conductivity also increases.

Next, when Sample A and Sample B are contrasted, Sample B using small median diameter has become loose slightly of the increasing trend in thermal conductivity Therefore, it is considered that the step of "pulverizing" is better to delete to increase the thermal conductivity.

Next, when Sample A and Sample C are contrasted, it can be found that the thermal conductivity increases with the increasing the burning temperature at the time of producing heat conducting material. For Sample C, when the content ratio of heat conducting material against the base material is only 100 phr, the thermal conductivity of approx. 0.5 [W/(m · K)] can be confirmed.

Similarly, when Sample A and Sample D are contrasted, it can be found that the thermal conductivity increases with the increasing the burning temperature at the time of producing heat conducting material. For Sample D, when the content ratio of heat conducting material against the base material is only 150 phr, the thermal conductivity of approx. 1.1 [W/(m · K)] can be confirmed. In addition, surprisingly, for Sample D, in the case that the content ratio of heat conducting material against the base material is 400 phr, the thermal conductivity of approx. 17 times to the thermal conductivity of the base material can be obtained.

Here, why such measurement result was obtained is considered. First, carbon itself has a heat transfer property. When substances having heat transfer property are in close to each other, a heat bridge is formed. The carbon content of the heat conducting material of this embodiment is high, so a heat bridge is easy to be formed. It is consider that the heat conducting material of this embodiment is excellent in thermal conductivity, so as to contain the heat conducting member.

Fig. 49 is a graph showing the measurement results which fill up the graph of Fig. 46. Fig. 49 shows the measurement results of the Sample E which is produced and measured under the same condition as Sample D shown in Fig. 46. For reference, the thermal conductivity of each firing polyethylene (PE), silicon rubber, and quartz glass as well as the case of Fig. 46 is shown as a standard sample.

Sample E is produced under the same process as Sample D, after not less than one year has passed since the produce of Sample D. That is, Sample E, as well as Sample D, is a heat conducting member produced by a non pulverizing burned material of soybean hulls burned at the temperature of approx. 3000 °C. The heat conducting material using the heat conducting member has approx. 30 µm median diameters.

The thermal conductivities were measured, when the content ratios of Sample E against the base material were 100 phr, 150 phr, 200 phr, 300 phr and 400 phr respectively.

The thermal conductivity in the case that the content ratio of Sample E against the base material was 100 phr was 0.765 [W/(m · K)]. It can be found that the above figure is lower than the thermal conductivity in the case that the content ratio of Sample E against the base material was 150 phr,

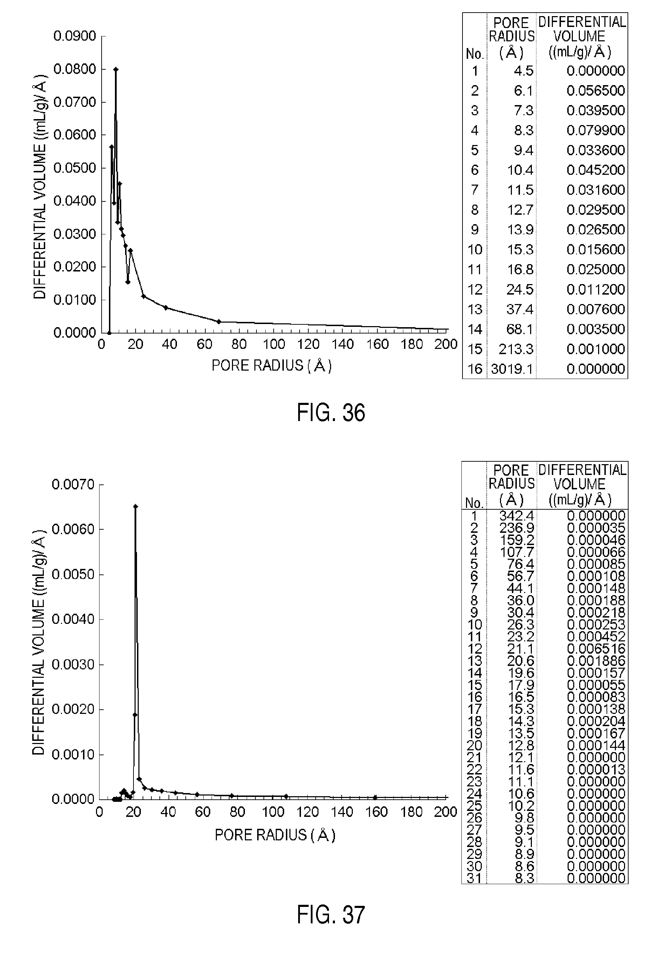

In addition, the thermal conductivity in the case that the content ratio of Sample E against the base material was 150 phr was 1.10 [W/(m · K)] which was same figure as the thermal conductivity in the case that the content ratio of Sample D as shown in Fig. 36 against the base material was 150 phr. Moreover, the thermal conductivity in the case that the content ratio of Sample E against the base material was 400 phr was 3.770 [W/(m · K)], and although it was somewhat different from 3.610 [W/(m · K)] shown in Fig. 36, it can be said that it is almost equivalent.

Therefore, it can be found that the heat conducting member of this embodiment has high reproducibility about thermal conductivity. When added, the burned material of soybean hulls according to sample D and sample E were same results not only thermal conductivity but also physical properties, component analysis, etc.

In addition, the thermal conductivity in the case that the content ratios of Sample E against the base material were 200 phr and 300 phr respectively were 1.680 [W/(m · K)] and 2.860 [W/(m · K)] respectively.

In addition, as apparent from Fig. 49, it can be found that when the thermal conductivity is also increased linearly, the content ratio of Sample E against the base material is increased linearly. Therefore, it became clear that the burned plant material according to this embodiment may control thermal conductivity easily by choosing the content ratio against the base material suitably. In other words, it became clear that there is linearity between the change in the content ratio of the burned plant material against the base material and the height of the thermal conductivity of the heat conducting member.

(EMBODIMENT 2)

Next, an adsorbent of Embodiment 2 according to the present invention is described. The inventors of the present invention found out that the burned plant material produced by the method described in Embodiment 1 had an adsorption action as described below.

First, the performance of the burned plant material is explained. In the burned material of soybean hulls which is a burned plant material, the sample weight is 1.1463 [g], the relative pressure range of BET plot is 0.01 to 0.15, the measurement area is 440.5 [$m^2$], the BET specific surface area is 384.3 [$m^2$/g], the pore volume Vp is 0.1756 [$cm^3$/g], the average pore radius rm is 9.14 [Å], the mode pore radius at the time of adsorption is 4.42 [Å], when the burning temperature is set to 900 [°C],

In addition, in case that the burning temperature is set to 1500 [°C] or 3000 [°C], the sample weight is 0.5637 [g] or 7.7389 [g], the measurement area is 29.4 [$m^2$] or 38.1 [$m^2$], the BET specific surface area is 52.2 [$m^2$/g] or 4.92 [$m^2$/g] respectively.

Fig. 22 shows a chart of the pore size distribution curve in the gas adsorption process for the burned material of soybean hulls burned at a temperature of 900 [°C]. The lateral axis and vertical axis of Fig. 22 respectively represent the pore radius (Å) and the differential volume ((mL/g)/Å). The median diameter of the burned material of soybean hulls was approx. 34 μm.

It should be noted that the burned material of soybean hulls at least shows a sole sharp peak in the differential volume at a specific pore radius that is rarely seen in the burned materials of other plants in consideration of the verification results for the burned material of soybean hulls that was burned at a temperature of 1500 [°C] or 3000 [°C] as described below.

Normally, the burned materials of other plants excluding burned material of soybean hulls, etc. rarely show a single sharp peak at a specific pore radius in the differential volume, and rather the chart of the pore size distribution curve results in broad, or several peaks appear in the chart of the pore size distribution curve.

The pore size of the burned material of soybean hulls burned at a temperature of 900 [°C] as shown Fig. 22 shows a sharp peak in the differential volume at a pore radius of approx. 4.42 Å. See the chart in Fig. 22 for the detailed measurement results about other pore radiuses and differential volumes. In addition, the burned material of soybean hull still has a porous structure with a large specific surface area even after the graphitization process.

Fig. 36 shows a chart of the pore size distribution curve in the gas adsorption process for the burned material of soybean hulls burned at a temperature of 1500 [°C]. The lateral axis and vertical axis of Fig. 36 respectively represent the pore radius (Å) and the differential volume ((mL/g)/Å). The median diameter of the burned material of soybean hulls was approx. 27 μm.

Here, the differential volume also shows a peak at a specific pore radius. The pore size of the burned material of soybean hulls burned at a temperature of 1500 [°C] showed a less sharp peak in the differential volume at a pore radius of approx. 8.29 Å, but the peak was still somewhat sharp. However, the pore distribution has become wider in the range of about 30 Å. See the chart in Fig. 36 for the detailed measurement results.

Fig. 37 shows a chart of the pore size distribution curve in the gas desorption process for the burned material of soybean hulls burned at a temperature of 3000 [°C]. The lateral axis and vertical axis of Fig. 37 respectively represent the pore radius (Å) and the differential volume ((mL/g)/Å). The median diameter of the burned material of soybean hulls was approx. 24 μm. Here, the differential volume also shows a sharp peak at a specific pore radius. In the case of gas adsorption process, it was found that the pore size of the burned material of soybean hulls burned at a temperature of 3000 [°C] showed a sharp peak in the differential volume at a pore radius of approx. 4.41 Å. However, in the case of gas adsorption process, a broad small peak was found at a pore radius of around 14.3 Å. See the chart in Fig. 37 for the detailed measurement results.

Fig. 38 shows a chart of the pore size distribution curve in the gas adsorption process for the burned material of soybean hulls burned at a temperature of 3000 [°C]. Here, the differential volume also shows a sharp peak at a specific pore radius. In the case of gas desorption process, it was found that the pore size of the burned material of soybean hulls burned at a temperature of 3000 [°C] showed a sharp peak in the differential volume at a pore radius of approx. 21.1 Å. See the chart in Fig. 38 for the detailed measurement results.

As described above, it is found that the burned material of soybean hulls has a very rare characteristic of showing a peak in the differential volume at a specific pore radius regardless of the burning temperature.

Next, an adsorbent using each burned material of cotton seed meal, cacao husk, rapeseed meal, sesame meal and cotton hulls is as follows.

Table 1 is a showing the weight (g), the relative pressure range of BET-plot, the measurement area (m²), the specific surface area (m²/g), the pore volume $V_p$ (cm³/g), the average pore radius rm [Å], the mode pore radius at the time of adsorption [Å] of each of these burned materials. In addition, each burned material is made into the burning temperatures of about 900 °C.

Table 1

| Plant-derived carbon | Sample weight (g) | Relative press. range of BET-plot | Measurement area (m²) | Specific surface area (m²/g) | Pore volume $V_p$ (cm³/g) | Average pore radius $r_m$ (Å) | Mode pore radius (Å) |
|---|---|---|---|---|---|---|---|
| Cotton seed meal | 2.8473 | 0.05~0.35 | 4.27 | 1.5 | 0.0042 | 56.0 | 23.1 |
| Cotton hulls | 3.9112 | 0.01~0.15 | 3.52 | 0.9 | 0.0002 | 4.4 | 8.8 |
| Cacao husk | 1.7732 | 0.05~0.35 | 8.16 | 4.6 | 0.0097 | 42.2 | 23.0 |
| Rapeseed meal | 3.6666 | 0.05~0.35 | 3.67 | 1.0 | 0.0032 | 64.0 | 22.9 |
| Sesame meal | 4.1875 | 0.05~0.35 | 20.52 | 4.9 | 0.0032 | 64.0 | 22.9 |

The measurement techniques such as a pore radius explained in Specification are performed under the following conditions.

As measurement apparatus, Sorptmatic 1990 manufactured by Thermo Finnigan, Inc. is adopted.

As a pretreating method, the measuring object was dried under reduced pressure for about 6 hours at approx. 200 °C and cooled down, then, the measuring sample was weighed and degassed under reduced pressure for about 6 hours on condition of approx. $1 \times 10^{-3}$ (Pa) and below at approx. 200 °C in predetermined burette.

As a measuring method of surface area, the nitrogen gas adsorption method (a constant volume method, an adsorption process, a helium gas blank method) was adopted.

As the analysis method, BET multipoint method was adopted.

The relative pressure range was set to 0.05 - 0.35 (burned material of cotton seed meal, burned material of cacao husk, burned material of rapeseed meal, and burned material of sesame meal) and 0.01 - 0.15 (burned material of cotton hulls).

As a measuring method of pore size distribution, the nitrogen gas adsorption method (a constant volume method, an adsorption process, a helium gas blank method) was adopted.

As the analysis method, Dollimore/Heal method was adopted.

The pore volume was the value that the relative pressure corresponded to P/Po= 0.97 in the adsorption process.

As shown in Table 1, although the average pore radius is various by each burned material, an important aspect of the present invention is that a burned plant material has a peak in the differential volume at a specific pore radius.

Fig. 50-54 show the pore size distribution curve of burned material of cotton seed meal, burned material of cacao husk, burned material of rapeseed meal, burned material of sesame meal, and burned material of cotton hulls respectively.

As shown in Fig. 50, the burned material of cotton seed meal has a peak in the differential volume at 23.1 (Å). Similarly, as shown in Fig. 51, the burned material of cacao husk has a peak in the differential volume at 23.0 (Å). As shown in Fig. 52, the burned material of rapeseed meal has a peak in the differential volume at 22.9 (Å). As shown in Fig. 53, the burned material of sesame meal has a peak in the differential volume at 23.4 (Å). Uniquely, as shown in Fig. 53, the burned material of cotton hulls has a peak in the differential volume in the range of 19.9 (Å) - 23.9(Å) although it is not pinpoint. Thus, since any of these burned materials can be called as burned plant material which has a peak in the differential volume at a specific pore radius, it becomes possible to adsorb a gas corresponding to said specific pore radius.

Next, concerning the adsorbent of burned material of soybean hulls of this embodiment, the gas adsorbent examination was actually done using FT-IR Fourier transform infrared spectrophotometer (MIDAC Inc. I-4001). The burning temperature of soybean hulls was set to 900 °C and the median diameter was also approx. 30 $\mu$m. In addition, the examination was done in the following ways at Tomoeshokai Inc. Technology Division Yokohama Institute.

First, three test vessels, three petri dishes on which adsorbent placed in each enclosed vessel is put, and three tripods on which each petri dish is placed were prepared. These were the total volume of 0.11248 (L). The first test vessel was enclosed with approx. 5 (g) of adsorbent of soybean hulls of this embodiment and was sealed. The second test vessel was enclosed with approx. 5 (g) of commercially available activated carbon for comparison and was sealed. The third test vessel was not enclosed with adsorbent, etc. Activated carbon manufactured by Kanto Chemical (model version No. 01085-02) was used as activated carbon for comparison.

This activated carbon for comparison was selected for the following reasons;
In contrast to adsorbent of soybean hulls of this embodiment,

· There is a common feature of being a plant-derived burned material which is a burned material of sawdust.
· There is a approximation point that the particle size of activated carbon for comparison is about 20 $\mu$m, whereas the particle size of adsorbent of soybean hulls of this embodiment is about 30 $\mu$m.
· On the other hand, there are differences from adsorbent of soybean hulls of this embodiment since the pore radius is in broad with approx. 5 Å - approx. 2500 Å and the average pore radius is approx. 100 Å.

Next, the adsorbent, etc. were dried by heating at 120 °C for about 8 hours flowing nitrogen gas at a flow rate of 1 (L/min) in the 1st and 2nd test vessels. Then, heating was stopped and the temperature was lowered to room temperature (approx. 22 °C), where nitrogen gas is flowed. After the adsorbent of soybean hulls of this embodiment and commercially available activated carbon have returned to room temperature, the pressure of each test vessel was reduced to approx. 40 (cmHgG) or less and a test gas which was collected by a gas syringe was introduced to a concentration of 49950 ppm under the pressure of approx. 0.01 MPaG, then, each test vessel was left for one day under room temperature.

Then, during nitrogen gas was fed in each test vessel at approx. 0.5 (L/min), the test gas concentration discharged from each test vessel was measured using FT-IR Fourier transform infrared spectrophotometer connected to each test vessel.

In this embodiment, carbon dioxide (CO2) gas, carbon monoxide (CO) gas, ethylene (C2H4) gas, and ammonia (NH3) gas were selected as test gas, and the test using each of these gases was carried out. Of course, Each time test gas was changed, the heating and drying process described above were performed. In addition, among these test gases, 4m gas cell for low concentration measurement was used on the occasion of measurement of ammonia gas and 1 cm gas cell for high concentration measurement was used on the occasion of measurement of other gas.

Table 2 is a table showing the test result of gas adsorption test.

Table 2

| Test vessel / Test gas Enclosed concentration | 3rd Test vessel | 1st Test vessel | 2nd Test vessel |
|---|---|---|---|
| Carbon dioxide:$CO_2$ 49950ppm | 43600ppm [−] | 1400ppm [97% decrease] | 7400ppm [83% decrease] |
| Carbon monoxide:CO 50380ppm | 45400ppm [−] | 34300ppm [24% decrease] | 35400ppm [22% decrease] |
| Ethylene:$C_2H_4$ 49300ppm | 39600ppm [−] | 940ppm [98% decrease] | 1270ppm [97% decrease] |
| Ammonia:$NH_3$ 51600ppm | 6040ppm [*1] [−] | 12ppm [99% or more decrease] | 160ppm [97% decrease] |

As shown in Table 2, when carbon dioxide gas was selected as test gas, the maximum concentration of carbon dioxide gas concerning the 3rd test vessel was the detection result of 43600 (ppm). On the other hand, the maximum concentration of carbon dioxide gas concerning the 1st test vessel was the detection result of 1400 (ppm). This shows that approx. 97% of test gas has been absorbed by the adsorbent of soybean hulls of this embodiment during one day leave after introducing test gas in the 1st test vessel.

On the other hand, the maximum concentration of the carbon dioxide gas concerning the 2nd test vessel was the detection result of 7400 (ppm). This shows that about 83% of test gas has been absorbed by commercially available activated carbon during one day leave after introducing test gas in the 2nd test vessel.

In contrast to the measurement result concerning the 1st test vessel and the 2nd test vessel, there is a adsorption difference of approx. 5.3 times because of a measurement result of 1400 (ppm) and 7400 (ppm) from a concentration standpoint. In addition, the absorption of the carbon dioxide gas by adsorbent of soybean hulls of this embodiment has been phenomenally improved approx. 15%.

Similarly, when the adsorbent of soybean hulls of this embodiment is targeted, ammonia gas is the noteworthy test gas. When ammonia gas was selected as test gas, the maximum concentration of ammonia gas concerning the 1st test vessel was the detection result of 12 (ppm). This shows that approx. 99.8 % of test gas has been absorbed by the adsorbent of soybean hulls of this embodiment during one day leave after introducing test gas in the 1st test vessel.

On the other hand, the maximum concentration of ammonia gas concerning the 2nd test vessel was the detection result of 160 (ppm). This shows that approx. 97% of test gas has been absorbed by the adsorbent of commercially available activated carbon during one day neglecting after introducing test gas in the 2nd test vessel.

Therefore, in contrast to the measurement result concerning the 1st test vessel and the measurement result concerning the 2nd test vessel, first of all, it can be found that there is a adsorption difference of approx. 13 times because of a measurement result of 12 (ppm) and 160 (ppm) from a concentration standpoint.

In addition, as shown in Table 2, it can be found that the adsorbent using the soybean hulls of this embodiment has a superior gas absorption characteristic as compared with the commercially available activated carbon. For reference, the adsorption difference is approx. 1.03 times from a concentration standpoint and it is negligible in the case of carbon monoxide gas, and the adsorption difference is approx. 1.3 times from a concentration standpoint in the case of ethylene gas.

Incidentally, the adsorption amount per unit weight and contact area are easily computable using the following formula. That is, as an example in the case that test gas is ammonia gas, since the introduced concentration of test gas to the test vessel was 51600 (ppm), the packing amount of test object was 5.0 (g), the enclosed gas amount was 0.113605 (L) and the area of two petri dishes was 26.3917 (cm$^2$), the adsorption amount per unit weight is as follows;

$$[\text{adsorption amount per unit weight}] = [\text{enclosed concentration x } (1 - \text{maximum gas concentration concerning the 1st test vessel} / \text{maximum gas concentration concerning the 3rd test vessel}) \text{ x enclosed gas amount} \div \text{packing amount of test object}]$$

The calculation result of the adsorption amount per unit weight using the above formula was as follows;

$$[\text{adsorption amount per unit weight}] = [51600 / 1000000 \text{ x } (1 - 12 / 6040) \text{ x } 0.113605 / 5.0] = 1.1700 \text{ (mL/g)}$$

In addition, the adsorption amount per unit contact area is computable using the following formula;

$$[\text{adsorption amount per unit contact area}] = [\text{enclosed concentration x } (1 - \text{maximum gas concentration concerning the 1st test vessel} / \text{maximum gas concentration concerning the 3rd test vessel}) \text{ x enclosed gas amount} / \text{area of two petri dishes}]$$

The calculation result of the adsorption amount per unit contact area using the above formula was as follows;

$$[\text{adsorption amount per unit contact area}] = 51600 \diagup 1000000 \text{ x } (1 - 12 \diagup 6040) \text{ x } 0.113605 \diagup 26.3917 = 0.2217 \text{ (mL/ cm}^2)$$

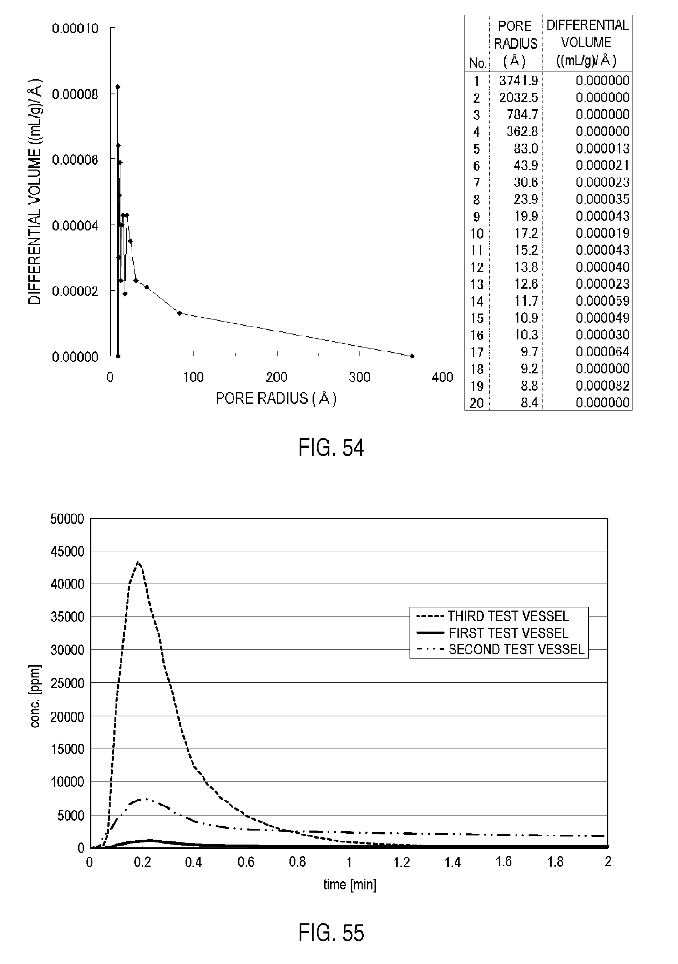

Fig. 55 shows the relation of test gas concentration and measuring time concerning 1st - 3rd test vessel in the case of selecting carbon dioxide gas as test gas. As shown in Fig. 55, immediately after a measurement start, since there is a distance gap in each test vessel and FT-IR Fourier transform infrared spectrophotometer, the gas in test vessel hardly reaches the FT-IR Fourier transform infrared spectrophotometer. Therefore, the test gas concentration measured in this timing is close to 0 (ppm).

Then, since the test gas came out from each test vessel begins to reach the FT-IR Fourier transform infrared spectrophotometer, gradually, the test gas concentration continued to increase, and the test gas concentration became maximum at about 0.2 (min) as the measurement time in any of the test vessels.

In the case of 3rd test vessel, when measuring time becomes about 1.2 (min), it is observed that almost all of the test gas enclosed in 3rd test vessel was discharged from 3rd test vessel by fed nitrogen gas.

In the case of 2nd test vessel, even if measuring time becomes 2 (min), the test gas concentration is not reduced to 0 (ppm). This means that the adsorption power of carbon dioxide gas by commercially available activated carbon is relatively weak, therefore, a lot of carbon dioxide gas is released from commercially available activated carbon during nitrogen gas is fed to the 2nd test vessel.

In the case of 1st test vessel, when measuring time becomes about 0.8 (min), the test gas concentration is reduced to about 0 (ppm). This means that the adsorption power of carbon dioxide gas by adsorbent of soybean hulls of this embodiment is relatively strong, therefore, carbon dioxide gas is hardly released from adsorbent of soybean hulls of this embodiment during nitrogen gas is fed to the 1st test vessel.

In addition, although it is considerable to be read from Fig. 55 by those skilled in the art, the greater the difference between the maximum concentration of test gas in the 3rd test vessel and the 1st test vessel, the adsorbent of soybean hulls of this embodiment is more easily to adsorb said test gas. In addition, after the expiration of measuring time corresponding to the maximum concentration of test gas in the 1st test vessel, the greater the decline and the faster the decline of the maximum concentration of test gas, the test gas is more difficult to be released from the adsorbent of the soybean hulls of this embodiment.

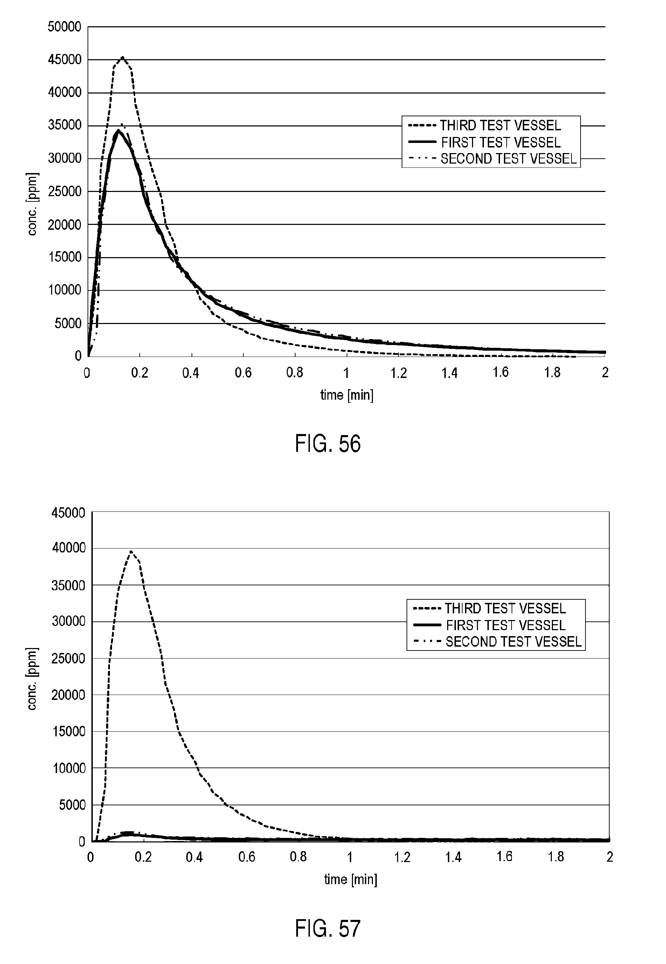

Fig. 56 shows the relation of test gas concentration and measuring time concerning 1st - 3rd test vessel in the case of selecting carbon monoxide gas as test gas. In contrast to Fig. 56 and Fig. 55, these curves are shown roughly similar, but the difference between the maximum concentration of test gas in the 3rd test vessel and the 1st test vessel is relatively small. This shows that the adsorbent of the soybean hulls of this embodiment cannot perform adsorption like carbon dioxide gas to carbon monoxide gas.

In addition, since the concentration of the test gas concerning the 1st test vessel is not reduced to 0 (ppm) even if measuring time reaches 2.0 (min), the adsorbent of the soybean hulls of this embodiment is understood that adsorption power is strong to carbon dioxide gas rather than carbon monoxide gas.

Fig. 57 shows the relation of test gas concentration and measuring time concerning 1st - 3rd test vessel in the case of selecting ethylene gas as test gas. In contrast to Fig. 57 and Fig. 55, the shape of the curve concerning the 1st and 2nd test vessel is different. According to Fig. 57, the adsorbent of this embodiment and the commercially available activated carbon are excellent in adsorption of ethylene gas, and it can be found that the adsorption power is relatively strong.

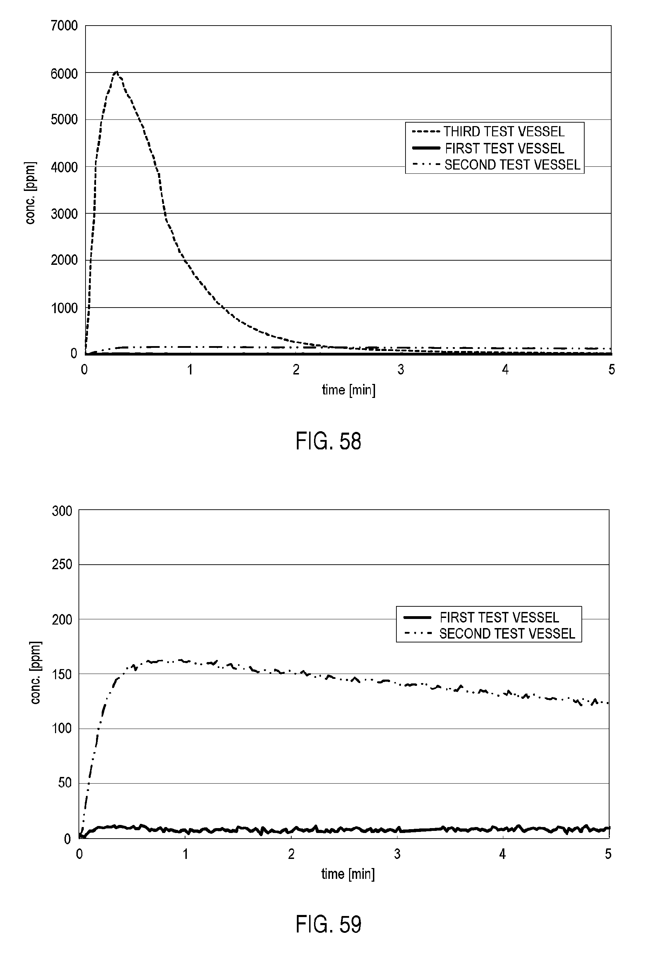

Fig. 58 shows the relation of test gas concentration and measuring time concerning 1st - 3rd test vessel in the case of selecting ammonia gas as test gas. Fig. 59 is a figure which changed the measure of the test gas concentration shown in Fig. 58. According to Fig. 58 and Fig. 59, the adsorbent of this embodiment is extremely excellent in adsorption of ethylene gas, and it is understood that the adsorption power is absolutely strong.

Furthermore, the confirmation test of oxygen adsorption amount of the adsorbent of this embodiment was done. Specifically, an adsorbent (about 250g) and an oxygen analyser (OX-01: diaphragm galvanic cell type manufactured by Riken Keiki) were placed in a desiccator and were sealed. In this case, the contact area between the adsorbent and air in the desiccator was approx. 615 cm$^2$, the air volume in the desiccator was approx. 2.5 L.

Although the above adsorbent had been in contact with the atmosphere and had already adsorbed considerable amount of oxygen, the oxygen concentration was decreased by 0.4% after one hour from sealing. The oxygen adsorption amount was 10mL, the oxygen adsorption amount per unit contact area was 0.016mL/cm$^2$, and the oxygen adsorption amount per unit weight was 0.04 mL/g after three hours from sealing.

In this embodiment, although gas adsorption was explained as an example, the removal of a toxic substance from liquids such as water containing a toxic substance, like sewage treatment is also possible.

INDUSTRIAL APPLICABILITY

The present invention has applicability in the field of heat conducting sheet, heat conducting board and heat conducting paint, in addition, in the field which adsorbs specific gas from various gases including toxic gases, or removes a toxic substance from a liquid containing a toxic substance.

BRIEF DESCRIPTION OF THE DRAWINGS

Fig. 1 shows charts indicating the measurement results of the electromagnetic shielding characteristics of the heat conducting member of this embodiment.

Fig. 2 shows a schematic production process diagram of the heat conducting material and heat conducting member of this embodiment.

Fig. 3 shows charts indicating the results of component analysis based on the ZAF quantitative analysis method for soybean hulls etc. before and after burning.

Fig. 4 shows SEM pictures indicating the result of the tissue observation of "raw soybean hull".

Fig. 5 shows SEM pictures indicating the result of the tissue observation of the "burned material of soybean hull".

Fig. 6 shows charts indicating the test results of the conductivity test regarding the "burned material of soybean hulls".

Fig. 7 shows a chart indicating the relationship between the burning temperature for soybean hulls and the specific volume resistivity.

Fig. 8 shows a chart indicating the relationship between the content ratio of the burned material of soybean hulls and the specific volume resistivity.

Fig. 9 shows charts indicating the measurement results of the "surface resistivity" of the heat conducting member of the test object.

Fig. 10 shows a chart indicting the electromagnetic wave absorption characteristics of the "heat conducting member".

Fig. 11 shows a chart indicting the electromagnetic wave absorption characteristics of the "heat conducting member".

Fig. 12 shows a chart indicting the electromagnetic wave absorption characteristics of the "heat conducting member".

Fig. 13 shows a chart indicting the electromagnetic wave absorption characteristics of the "heat conducting member".

Fig. 14 shows a chart indicting the electromagnetic wave absorption characteristics of the "heat conducting member".

Fig. 15 shows a chart indicating the relationship between frequency and electromagnetic wave absorption characteristics corresponding to Fig. 13.

Fig. 16 shows a chart indicating the relationship between frequency and electromagnetic wave absorption characteristics corresponding to Fig. 14.

Fig. 17 shows a chart indicating the relationship between frequency and electromagnetic wave absorption in the case that low density polyethylene is used for the base material to be blended with the burned material of soybean hulls.

Fig. 18 shows a chart indicating the relationship between frequency and electromagnetic wave absorption in the case that low density polyethylene is used for the base material to be blended with the burned material of soybean hulls.

Fig. 19 shows a chart indicating the measurement results of the electromagnetic shielding characteristics shown in Fig. 1 with an expanded measurement range.

Fig. 20 shows charts indicating the measurement results of the electromagnetic shielding characteristics of the burned materials of rapeseed meal, sesame meal, cotton seed meal and cotton hulls.

Fig. 21 show charts indicating the measurement results of the electromagnetic shielding characteristics when the production conditions etc. for the burned material of soybean hulls have been changed.

Fig. 22 shows a chart of the pore size distribution curve in the gas adsorption process for the burned material of soybean hulls burned at a temperature of 900 [°C].

Fig. 23 shows charts indicating the result of the component analysis based on the organic micro-elemental analysis method corresponding to Fig. 3.

Fig. 24 shows SEM pictures of the "burned material of soybean hull".

Fig. 25 shows SEM pictures of the "burned material of soybean hulls" according to Fig 24 at a magnification of 20,000 and 50,000 respectively.

Fig. 26 shows a chart indicating the test results of the conductivity test regarding the burned materials of cotton hulls, sesame meal, rapeseed meal, cotton seed meal and cacao husk.

Fig. 27 shows a chart indicating the test results of the conductivity test regarding the burned material of soybean hulls, wherein the burning furnace and burning temperature were changed.

Fig. 28 shows a chart indicating the test results of the conductivity test regarding the burned material of soybean hulls, wherein the burning temperature etc. was changed.

Fig. 29 shows a chart indicating the relationship between the content ratio of the burned material of cotton hulls, sesame meal, rapeseed meal or cotton seed meal, and the specific volume resistivity.

Fig. 30 shows charts indicating the measurement results of the specific volume resistivity and surface resistivity of the heat conducting material formed by the burned materials of rapeseed meal, sesame meal, cotton seed meal and cotton hulls.

Fig. 31 shows charts indicating the measurement results of the specific volume resistivity and surface resistivity of the heat conducting member of this embodiment.

Fig. 32 shows charts indicating the electromagnetic wave absorption characteristics of the heat conducting member formed by the burned materials of rapeseed meal, sesame meal, cotton seed meal and cotton hulls.

Fig. 33 shows charts indicating the electromagnetic wave absorption characteristics regarding the burned material of soybean hulls, wherein the burning temperature etc. was changed.

Fig. 34 shows charts indicating the electromagnetic wave absorption characteristics of the heat conducting member formed by the burned materials of rapeseed meal, sesame meal, cotton seed meal and cotton hulls.

Fig. 35 shows charts indicating the electromagnetic wave absorption characteristics regarding the burned material of soybean hulls, wherein the burning temperature etc. was changed.

Fig. 36 shows a chart of the pore size distribution curve in the gas adsorption process for the burned material of soybean hulls burned at a temperature of 1500 [°C].

Fig. 37 shows a chart of the pore size distribution curve in the gas desorption process for the burned material of soybean hulls burned at a temperature of 3000 [°C].

Fig. 38 shows a chart of the pore size distribution curve in the gas adsorption process for the burned material of soybean hulls burned at a temperature of 3000 [°C].

Fig. 39 shows a chart indicating the specific volume resistivity regarding the burned material of soybean hulls, wherein the burning temperature etc. was changed.

Fig. 40 shows a SEM picture of raw cacao husk.

Fig. 41 shows a SEM picture of raw cacao husk.

Fig. 42 shows a SEM picture of cacao husk burned without distinguishing by the inner skin and the outer skin.

Fig. 43 shows a SEM picture of cacao husk burned without distinguishing by the inner skin and the outer skin.

Fig. 44 shows a chart indicating the electromagnetic wave absorption characteristics of the heat conducting members formed from the burned material of cacao husk.

Fig. 45 shows a chart indicating the electromagnetic wave absorption characteristics of the heat conducting members formed from the burned material of cacao husk.

Fig. 46 shows a chart indicating the measurement result of thermal conductivity of the heat conducting member of this embodiment.

Fig. 47 shows a chart indicating the measurement results of the specific volume resistivity and surface resistivity of the heat conducting member of the burned materials of cacao husk.

Fig. 48 shows a chart indicating the measurement results of the electromagnetic shielding characteristics of the burned materials of cacao husk.

Fig. 49 is a graph showing the measurement result which fills up the graph of Fig. 46.

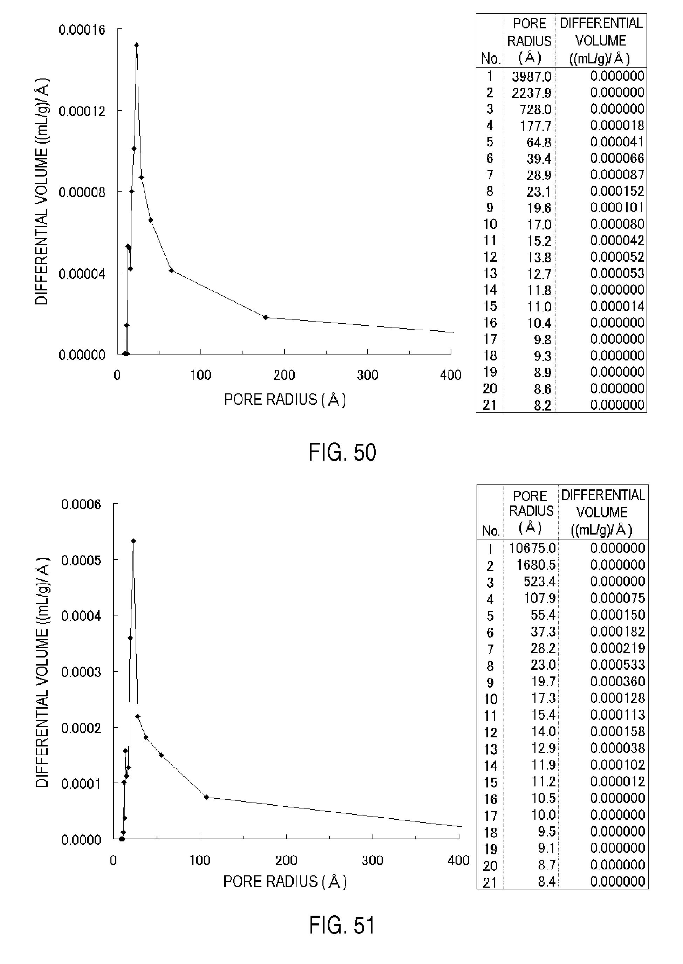

Fig. 50 shows the pore size distribution curve of burned material of cotton seed meal.

Fig. 51 shows the pore size distribution curve of burned material of cacao husk.

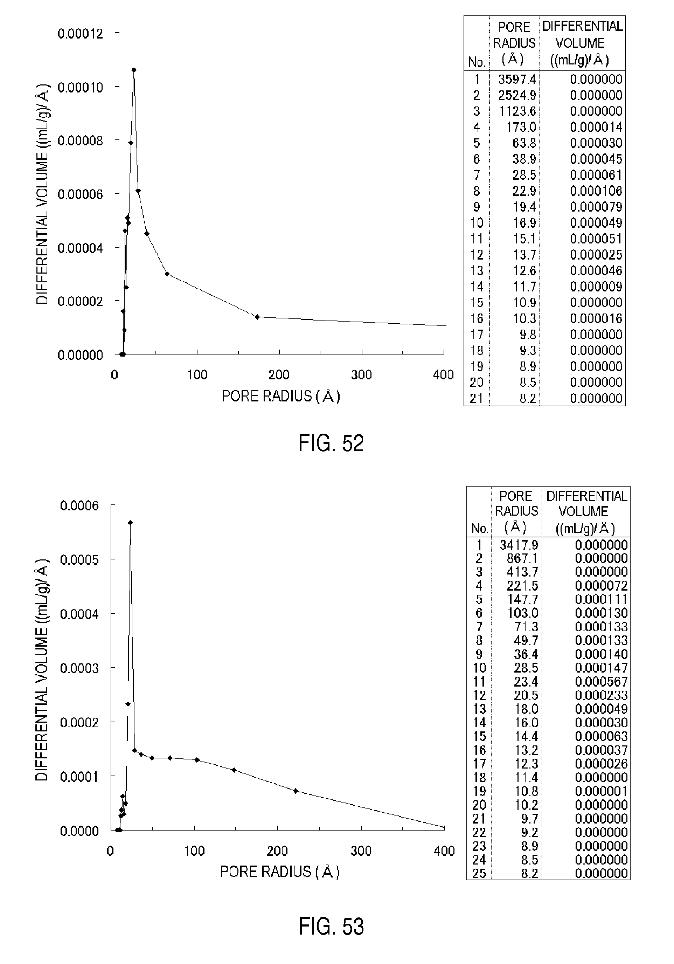

Fig. 52 shows the pore size distribution curve of burned material of rapeseed meal.

Fig. 53 shows the pore size distribution curve of burned material of sesame meal.

Fig. 54 shows the pore size distribution curve of burned material of cotton hulls.

Fig. 55 shows the relation of test gas concentration and measuring time concerning 1st test vessel - 3rd test vessel in the case of selecting carbon dioxide gas as test gas.

Fig. 56 shows the relation of test gas concentration and measuring time concerning 1st test vessel - 3rd test vessel in the case of selecting carbon monoxide gas as test gas.

Fig. 57 shows the relation of test gas concentration and measuring time concerning 1st test vessel - 3rd test vessel in the case of selecting ethylene gas as test gas.

Fig. 58 shows the relation of test gas concentration and measuring time concerning 1st test vessel - 3rd test vessel in the case of selecting ammonia gas as test gas.

Fig. 59 is a figure which changed the measure of the test gas concentration shown in Fig. 58.

**Claims**

1. A heat conducting member comprising a burned plant material which has a peak of differential volume at a specific pore radius.

2. The heat conducting member as claimed in Claim 1 being manufactured by controlling at least one of a burning temperature of the burned plant material and a content ratio of the burned plant material against a base material.

3. The heat conducting member as claimed in Claim 1, wherein the burned plant material is one of the burned materials of soybean hulls, rapeseed meal, sesame meal, cotton seed meal, cotton hulls, soybean chaffs and cacao husk.

4. The heat conducting member as claimed in Claim 1, wherein the base material is one of rubber, resin, paint and cement.

5. The heat conducting member as claimed in Claim 1, wherein there is linearity between the change in the content ratio of the burned plant material against the base material and the height of the thermal conductivity of the heat conducting member.

6. A heat conducting material being the burned plant material which is used as the heat conducting member as claimed in Claim 1.

7. An adsorbent comprising a burned plant material which has a peak of differential volume at a specific pore radius.

8. The adsorbent as claimed in Claim 7, wherein the burned plant material has been adjusted a burning temperature and a median diameter.

9. The adsorbent as claimed in Claim 7, wherein the burned plant material is one of the burned materials of soybean hulls, rapeseed meal, sesame meal, cotton seed meal, cotton hulls, soybean chaffs and cacao husk.

FIG. 1

FIG. 2

FIG. 3

(a)

(b)

(c)

FIG. 4

(a)

(b)

(c)

FIG. 5

FIG. 6

FIG. 7

(a)

(b)

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

FIG. 21

| No. | PORE RADIUS (Å) | DIFFERENTIAL VOLUME ((mL/g)/Å) |
|---|---|---|
| 1 | 3.4 | 0.000000 |
| 2 | 3.6 | 0.191600 |
| 3 | 3.7 | 0.308400 |
| 4 | 3.8 | 0.339500 |
| 5 | 3.9 | 0.428100 |
| 6 | 4.0 | 0.377500 |
| 7 | 4.1 | 0.402000 |
| 8 | 4.1 | 0.663200 |
| 9 | 4.2 | 0.528300 |
| 10 | 4.2 | 0.632500 |
| 11 | 4.3 | 0.672900 |
| 12 | 4.3 | 0.813300 |
| 13 | 4.3 | 0.925300 |
| 14 | 4.4 | 1.023900 |
| 15 | 4.4 | 1.190500 |
| 16 | 4.4 | 1.190500 |
| 17 | 4.4 | 7.169600 |
| 18 | 4.4 | 1.931900 |
| 19 | 4.5 | 1.737900 |
| 20 | 4.5 | 0.921900 |
| 21 | 4.6 | 0.412200 |
| 22 | 4.7 | 0.211500 |
| 23 | 5.0 | 0.117200 |
| 24 | 5.3 | 0.082900 |
| 25 | 5.8 | 0.060400 |
| 26 | 6.3 | 0.039400 |
| 27 | 6.9 | 0.031000 |
| 28 | 7.4 | 0.043500 |
| 29 | 8.1 | 0.025300 |
| 30 | 8.8 | 0.017400 |
| 31 | 9.6 | 0.015200 |
| 32 | 10.4 | 0.013500 |
| 33 | 11.3 | 0.010500 |
| 34 | 12.3 | 0.008200 |
| 35 | 13.3 | 0.007900 |
| 36 | 14.4 | 0.006600 |
| 37 | 15.6 | 0.005200 |
| 38 | 17.0 | 0.004200 |
| 39 | 24.1 | 0.001900 |
| 40 | 36.7 | 0.000800 |
| 41 | 64.4 | 0.000400 |
| 42 | 177.3 | 0.000100 |
| 43 | 2251.8 | 0.000000 |

FIG. 22

FIG. 23

(a)　　　　　　　　　　　　　　　　　　(b)

(c)　　　　　　　　　　　　　　　　　　(d)

FIG. 24

( a )

( b )

( c )

( d )

( e )

( f )

FIG. 25

FIG. 26

FIG. 27

FIG. 28

FIG. 29

FIG. 30

FIG. 30

FIG. 31

FIG. 32

FIG. 32

FIG. 33

FIG. 34

FIG. 35

| No. | PORE RADIUS (Å) | DIFFERENTIAL VOLUME ((mL/g)/Å) |
|-----|-----------------|-------------------------------|
| 1 | 4.5 | 0.000000 |
| 2 | 6.1 | 0.056500 |
| 3 | 7.3 | 0.039500 |
| 4 | 8.3 | 0.079900 |
| 5 | 9.4 | 0.033600 |
| 6 | 10.4 | 0.045200 |
| 7 | 11.5 | 0.031600 |
| 8 | 12.7 | 0.029500 |
| 9 | 13.9 | 0.026500 |
| 10 | 15.3 | 0.015600 |
| 11 | 16.8 | 0.025000 |
| 12 | 24.5 | 0.011200 |
| 13 | 37.4 | 0.007600 |
| 14 | 68.1 | 0.003500 |
| 15 | 213.3 | 0.001000 |
| 16 | 3019.1 | 0.000000 |

FIG. 36

| No. | PORE RADIUS (Å) | DIFFERENTIAL VOLUME ((mL/g)/Å) |
|-----|-----------------|-------------------------------|
| 1 | 342.4 | 0.000000 |
| 2 | 236.9 | 0.000035 |
| 3 | 159.2 | 0.000046 |
| 4 | 107.7 | 0.000066 |
| 5 | 76.4 | 0.000085 |
| 6 | 56.7 | 0.000108 |
| 7 | 44.1 | 0.000148 |
| 8 | 36.0 | 0.000188 |
| 9 | 30.4 | 0.000218 |
| 10 | 26.3 | 0.000253 |
| 11 | 23.2 | 0.000452 |
| 12 | 21.1 | 0.006516 |
| 13 | 20.6 | 0.001886 |
| 14 | 19.6 | 0.000157 |
| 15 | 17.9 | 0.000055 |
| 16 | 16.5 | 0.000083 |
| 17 | 15.3 | 0.000138 |
| 18 | 14.3 | 0.000204 |
| 19 | 13.5 | 0.000167 |
| 20 | 12.8 | 0.000144 |
| 21 | 12.1 | 0.000000 |
| 22 | 11.6 | 0.000013 |
| 23 | 11.1 | 0.000000 |
| 24 | 10.6 | 0.000000 |
| 25 | 10.2 | 0.000000 |
| 26 | 9.8 | 0.000000 |
| 27 | 9.5 | 0.000000 |
| 28 | 9.1 | 0.000000 |
| 29 | 8.9 | 0.000000 |
| 30 | 8.6 | 0.000000 |
| 31 | 8.3 | 0.000000 |

FIG. 37

| No. | PORE RADIUS ( Å ) | DIFFERENTIAL VOLUME ((mL/g)/ Å ) |
|---|---|---|
| 1 | 3.5 | 0.000000 |
| 2 | 4.4 | 0.112300 |
| 3 | 5.9 | 0.021100 |
| 4 | 7.0 | 0.008500 |
| 5 | 8.0 | 0.009000 |
| 6 | 8.9 | 0.010700 |
| 7 | 9.8 | 0.011700 |
| 8 | 10.7 | 0.014700 |
| 9 | 11.6 | 0.018000 |
| 10 | 12.5 | 0.020000 |
| 11 | 13.4 | 0.021500 |
| 12 | 14.3 | 0.023400 |
| 13 | 15.3 | 0.022000 |
| 14 | 16.4 | 0.020200 |
| 15 | 17.5 | 0.018000 |
| 16 | 23.1 | 0.012800 |
| 17 | 31.2 | 0.009500 |
| 18 | 43.6 | 0.008100 |
| 19 | 64.6 | 0.006400 |
| 20 | 103.3 | 0.004600 |
| 21 | 171.1 | 0.003700 |
| 22 | 289.0 | 0.002700 |
| 23 | 455.3 | 0.002200 |
| 24 | 707.2 | 0.000000 |

FIG. 38

FIG. 39

(a)

(b)

15kU X350    50µm 221113

15kU X100    100µm 221102

FIG. 40

(a)

(b)

15kU X750    10µm 221199

15kU X1,500    10µm 221108

FIG. 41

FIG. 42

FIG. 43

(a)

(b)

FIG. 44

FIG. 45

FIG. 46

FIG. 47

FIG. 48

FIG. 49

| No. | PORE RADIUS (Å) | DIFFERENTIAL VOLUME ((mL/g)/Å) |
|-----|------|----------|
| 1 | 3987.0 | 0.000000 |
| 2 | 2237.9 | 0.000000 |
| 3 | 728.0 | 0.000000 |
| 4 | 177.7 | 0.000018 |
| 5 | 64.8 | 0.000041 |
| 6 | 39.4 | 0.000066 |
| 7 | 28.9 | 0.000087 |
| 8 | 23.1 | 0.000152 |
| 9 | 19.6 | 0.000101 |
| 10 | 17.0 | 0.000080 |
| 11 | 15.2 | 0.000042 |
| 12 | 13.8 | 0.000052 |
| 13 | 12.7 | 0.000053 |
| 14 | 11.8 | 0.000000 |
| 15 | 11.0 | 0.000014 |
| 16 | 10.4 | 0.000000 |
| 17 | 9.8 | 0.000000 |
| 18 | 9.3 | 0.000000 |
| 19 | 8.9 | 0.000000 |
| 20 | 8.6 | 0.000000 |
| 21 | 8.2 | 0.000000 |

FIG. 50

| No. | PORE RADIUS (Å) | DIFFERENTIAL VOLUME ((mL/g)/Å) |
|-----|------|----------|
| 1 | 10675.0 | 0.000000 |
| 2 | 1680.5 | 0.000000 |
| 3 | 523.4 | 0.000000 |
| 4 | 107.9 | 0.000075 |
| 5 | 55.4 | 0.000150 |
| 6 | 37.3 | 0.000182 |
| 7 | 28.2 | 0.000219 |
| 8 | 23.0 | 0.000533 |
| 9 | 19.7 | 0.000360 |
| 10 | 17.3 | 0.000128 |
| 11 | 15.4 | 0.000113 |
| 12 | 14.0 | 0.000158 |
| 13 | 12.9 | 0.000038 |
| 14 | 11.9 | 0.000102 |
| 15 | 11.2 | 0.000012 |
| 16 | 10.5 | 0.000000 |
| 17 | 10.0 | 0.000000 |
| 18 | 9.5 | 0.000000 |
| 19 | 9.1 | 0.000000 |
| 20 | 8.7 | 0.000000 |
| 21 | 8.4 | 0.000000 |

FIG. 51

| No. | PORE RADIUS (Å) | DIFFERENTIAL VOLUME ((mL/g)/Å) |
|---|---|---|
| 1 | 3597.4 | 0.000000 |
| 2 | 2524.9 | 0.000000 |
| 3 | 1123.6 | 0.000000 |
| 4 | 173.0 | 0.000014 |
| 5 | 63.8 | 0.000030 |
| 6 | 38.9 | 0.000045 |
| 7 | 28.5 | 0.000061 |
| 8 | 22.9 | 0.000106 |
| 9 | 19.4 | 0.000079 |
| 10 | 16.9 | 0.000049 |
| 11 | 15.1 | 0.000051 |
| 12 | 13.7 | 0.000025 |
| 13 | 12.6 | 0.000046 |
| 14 | 11.7 | 0.000009 |
| 15 | 10.9 | 0.000000 |
| 16 | 10.3 | 0.000016 |
| 17 | 9.8 | 0.000000 |
| 18 | 9.3 | 0.000000 |
| 19 | 8.9 | 0.000000 |
| 20 | 8.5 | 0.000000 |
| 21 | 8.2 | 0.000000 |

FIG. 52

| No. | PORE RADIUS (Å) | DIFFERENTIAL VOLUME ((mL/g)/Å) |
|---|---|---|
| 1 | 3417.9 | 0.000000 |
| 2 | 867.1 | 0.000000 |
| 3 | 413.7 | 0.000000 |
| 4 | 221.5 | 0.000072 |
| 5 | 147.7 | 0.000111 |
| 6 | 103.0 | 0.000130 |
| 7 | 71.3 | 0.000133 |
| 8 | 49.7 | 0.000133 |
| 9 | 36.4 | 0.000140 |
| 10 | 28.5 | 0.000147 |
| 11 | 23.4 | 0.000567 |
| 12 | 20.5 | 0.000233 |
| 13 | 18.0 | 0.000049 |
| 14 | 16.0 | 0.000030 |
| 15 | 14.4 | 0.000063 |
| 16 | 13.2 | 0.000037 |
| 17 | 12.3 | 0.000026 |
| 18 | 11.4 | 0.000000 |
| 19 | 10.8 | 0.000001 |
| 20 | 10.2 | 0.000000 |
| 21 | 9.7 | 0.000000 |
| 22 | 9.2 | 0.000000 |
| 23 | 8.9 | 0.000000 |
| 24 | 8.5 | 0.000000 |
| 25 | 8.2 | 0.000000 |

FIG. 53

| No. | PORE RADIUS (Å) | DIFFERENTIAL VOLUME ((mL/g)/Å) |
|-----|-----------------|--------------------------------|
| 1 | 3741.9 | 0.000000 |
| 2 | 2032.5 | 0.000000 |
| 3 | 784.7 | 0.000000 |
| 4 | 362.8 | 0.000000 |
| 5 | 83.0 | 0.000013 |
| 6 | 43.9 | 0.000021 |
| 7 | 30.6 | 0.000023 |
| 8 | 23.9 | 0.000035 |
| 9 | 19.9 | 0.000043 |
| 10 | 17.2 | 0.000019 |
| 11 | 15.2 | 0.000043 |
| 12 | 13.8 | 0.000040 |
| 13 | 12.6 | 0.000023 |
| 14 | 11.7 | 0.000059 |
| 15 | 10.9 | 0.000049 |
| 16 | 10.3 | 0.000030 |
| 17 | 9.7 | 0.000064 |
| 18 | 9.2 | 0.000000 |
| 19 | 8.8 | 0.000082 |
| 20 | 8.4 | 0.000000 |

FIG. 54

FIG. 55

FIG. 56

FIG. 57

FIG. 58

FIG. 59

### INTERNATIONAL SEARCH REPORT

| | International application No. |
|---|---|
| | PCT/JP2011/051268 |

**A. CLASSIFICATION OF SUBJECT MATTER**
*C09K5/08*(2006.01)i, *B01J20/20*(2006.01)i, *B01J20/28*(2006.01)i, *C01B31/02*
(2006.01)i, *H05K9/00*(2006.01)n

According to International Patent Classification (IPC) or to both national classification and IPC

**B. FIELDS SEARCHED**

Minimum documentation searched (classification system followed by classification symbols)
C09K5/08, B01J20/20, B01J20/28, C01B31/02, H05K9/00

Documentation searched other than minimum documentation to the extent that such documents are included in the fields searched
Jitsuyo Shinan Koho          1922-1996    Jitsuyo Shinan Toroku Koho    1996-2011
Kokai Jitsuyo Shinan Koho    1971-2011    Toroku Jitsuyo Shinan Koho    1994-2011

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2006-315875 A  (Kikkoman Corp.),<br>24 November 2006 (24.11.2006),<br>claims; paragraphs [0018] to [0050]; fig. 3<br>(Family: none) | 7,9<br>1-6,8 |
| X<br>Y | JP 5-309269 A  (Kyodo Kumiai Ratesuto),<br>22 November 1993 (22.11.1993),<br>claims; examples<br>(Family: none) | 7,9<br>1-6,8 |
| X<br>Y | JP 2000-264734 A  (Nihon University),<br>26 September 2000 (26.09.2000),<br>claims; examples<br>(Family: none) | 7,9<br>1-6,8 |

[X] Further documents are listed in the continuation of Box C.          [ ] See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 07 March, 2011 (07.03.11) | 15 March, 2011 (15.03.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.

PCT/JP2011/051268

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP 63-123803 A (Mitsutoyo Corp.),<br>27 May 1988 (27.05.1988),<br>claims; pages 4 to 6<br>(Family: none) | 7,9<br>1-6,8 |
| X<br>Y | JP 2000-095512 A (Hitachi Techno Engineering<br>Co., Ltd.),<br>04 April 2000 (04.04.2000),<br>claims; carrying-out mode; paragraph [0001]<br>(Family: none) | 7,9<br>1-6,8 |
| X<br>Y | JP 10-101453 A (Sanwa Yushi Co., Ltd.),<br>21 April 1998 (21.04.1998),<br>claims; examples; paragraphs [0008], [0032]<br>& AU 9739308 A & US 5916499 A | 7,9<br>1-6,8 |
| Y | JP 2001-269570 A (Osaka Gas Co., Ltd.),<br>02 October 2001 (02.10.2001),<br>claims<br>(Family: none) | 8 |
| Y | JP 2008-182132 A (Mitsubishi Paper Mills Ltd.),<br>07 August 2008 (07.08.2008),<br>paragraph [0009]<br>(Family: none) | 1-6 |
| Y | JP 11-222803 A (Yugen Kaisha Nozawa Service<br>Center),<br>17 August 1999 (17.08.1999),<br>paragraph [0009]<br>(Family: none) | 1-6 |

Form PCT/ISA/210 (continuation of second sheet) (July 2009)

**REFERENCES CITED IN THE DESCRIPTION**

**Patent documents cited in the description**

- JP 2000053864 A